# EUROPEAN PATENT APPLICATION

(11) **EP 4 708 687 A1**
(43) Date of publication of application: **11.03.2026**
(21) Application number: 24844241.0
(22) Date of filing: 14.03.2024
(51) Int. Cl.: H03H 7/01

(54) **RESONANT STRUCTURE, RADIO-FREQUENCY SYSTEM AND ELECTRONIC DEVICE**

(30) Priority: 21.07.2023 CN 202310898020
(71) Applicant: Honor Device Co., Ltd., Shenzhen, Guangdong 518040 (CN)
(72) Inventor: ZHANG, Ziyan, Shenzhen, Guangdong 518040 (CN)
(74) Representative: Gill Jennings & Every LLP
(86) International application number: PCT/CN2024/081778
(87) International publication number: WO 2025/020544

(57) **Abstract**

This application provides a resonance structure, a radio frequency system, and an electronic device, and relates to the field of communication technologies. The resonance structure includes at least a first resonance structure. The first resonance structure includes at least three levels of resonance networks. The respective levels of resonance networks among the at least three levels of resonance networks are electrically connected in series and/or parallel. The respective levels of resonance networks influence each other, so that a frequency point and frequency point depth of the first resonance structure are different from a frequency point and frequency point depth of at least one level of resonance network among the respective levels of resonance networks. In the resonance structure, a resonance superposition mode with a non-serial structure is created by mutually nesting a plurality of levels of resonance networks. Therefore, by means of mutual influence among the plurality of levels of resonance networks, an insertion loss in a passband of the resonance structure may not be increased as resonance frequency points are increased, and the resonance structure can form multi-frequency point resonance at a particular frequency point.

## Description

This application claims priority to Chinese Patent Application No. 202310898020.4, filed with the China National Intellectual Property Administration on July 21, 2023 and entitled "RESONANCE STRUCTURE, RADIO FREQUENCY SYSTEM, AND ELECTRONIC DEVICE", which is incorporated herein by reference in its entirety.

### TECHNICAL FIELD

This application relates to the field of communication technologies, and in particular, to a resonance structure, a radio frequency system, and an electronic device.

### BACKGROUND

With the continuous development of technology, various mobile communication technologies, for example, a 5th generation mobile communication technology (5G), have been widely applied. Currently, to satisfy the use of different mobile communication technologies, an electronic device generates a multi-band multiple input multiple output (MIMO) specification, an evolved nodeb dual connectivity (ENDC) demand, and the like, so that more electronic devices generate requirements such as multi-band multi-mode. The multi-band refers to a plurality of bands, and the multi-mode refers to a plurality of network modes.

A resonance network can implement the multi-band multi-mode of the electronic device. In an actual application, functions such as filtering, combining, and frequency selection of a radio frequency signal may be generally implemented by using features such as a passband and a stop band of the resonance network, to construct a device such as a filter (filter) and a combiner (combiner). Generally, a band allowed to pass through by the resonance network is referred to as the passband, and a band prevented from passing through by the resonance network is referred to as the stop band.

However, the device such as the filter or the combiner needs to implement frequency broadening, multi-frequency point suppression, and the like by using a plurality of resonance points in a manner of connecting a plurality of resonance networks in series and/or parallel currently. This may cause problems such as increase of an insertion loss and degradation of consistency of an overall resonance network. Therefore, how to avoid increase of the insertion loss and degradation of consistency of the overall resonance network becomes a problem to be urgently resolved.

### SUMMARY

This application provides a resonance structure, a radio frequency system, and an electronic device. In the resonance structure, a resonance superposition mode with a non-serial structure is created by mutually nesting a plurality of levels of resonance networks. Therefore, by means of mutual influence among the plurality of levels of resonance networks, an insertion loss in a passband of the resonance structure may not be increased as resonance frequency points are increased, and the resonance structure can form multi-frequency point resonance at a particular frequency point.

To achieve the foregoing objective, the following technical solutions are used in this application:
According to a first aspect, a resonance structure is provided, including at least a first resonance structure. The first resonance structure includes at least three levels of resonance networks. The respective levels of resonance networks among the at least three levels of resonance networks are electrically connected in series and/or parallel. The respective levels of resonance networks influence each other, so that a frequency point and frequency point depth of the first resonance structure are different from a frequency point and frequency point depth of at least one level of resonance network among the respective levels of resonance networks.

In this implementation, a resonance superposition mode with a non-serial structure is created by mutually nesting a plurality of levels of resonance networks in the first resonance structure of the resonance structure, so that an insertion loss obtained after superposing the plurality of resonance networks is not simply serial addition. Instead, by means of mutual influence among the plurality of levels of resonance networks, an insertion loss in a passband of the resonance structure may not be increased as resonance frequency points are increased. In addition, because of mutual influence among the plurality of levels of resonance networks in the first resonance structure, multi-frequency point resonance can be formed at a particular required frequency point, thereby broadening a suppression band of the resonance structure.

In a possible implementation of the first aspect, the first resonance structure includes a first-level resonance network, a second-level resonance network, and a third-level resonance network. The first-level resonance network includes at least a first inductor and a first capacitor connected in parallel. The second-level resonance network is connected in series to the first inductor or the first capacitor.

The third-level resonance network is connected in parallel to two ends of the second-level resonance network, the first inductor, or the first capacitor, or is connected in parallel to two ends of the second-level resonance network and the first capacitor connected in series or is connected in parallel to two ends of the second-level resonance network and the first inductor connected in series.

In this implementation, by mutually nesting three levels of resonance networks, the three levels of resonance networks influence each other, and the insertion loss in the passband of the resonance structure may not be increased as resonance frequency points are increased. In addition, multi-frequency point resonance can be formed at a particular required frequency point, thereby broadening a suppression band of the resonance structure.

In a possible implementation of the first aspect, the first resonance structure includes four levels of resonance networks. The respective levels of resonance networks are electrically connected in series and parallel. The respective levels of resonance networks include at least one capacitor and/or inductor.

In this implementation, by mutually nesting four levels of resonance networks, the four levels of resonance networks influence each other, and the insertion loss in the passband of the resonance structure may not be increased as resonance frequency points are increased. In addition, multi-frequency point resonance can be formed at a particular required frequency point, thereby broadening a suppression band of the resonance structure.

In a possible implementation of the first aspect, the first resonance structure includes a first-level resonance network and a first secondary resonance network.

The first-level resonance network includes at least a first inductor and a first capacitor connected in parallel.

The first secondary resonance network includes a second-level resonance network, a third-level resonance network, and a fourth-level resonance network. The first secondary resonance network is connected in series to the first inductor or the first capacitor.

In this implementation, by mutually nesting respective levels of resonance networks, the respective levels of resonance networks influence each other, and the insertion loss in the passband of the resonance structure may not be increased as resonance frequency points are increased. In addition, multi-frequency point resonance can be formed at a particular required frequency point, thereby broadening a suppression band of the resonance structure.

In a possible implementation of the first aspect, the second-level resonance network, the third-level resonance network, and the fourth-level resonance network in the first secondary resonance network are connected in parallel.

The first secondary resonance network is connected in parallel to the first inductor after being connected in series to the first capacitor.

In this implementation, by mutually nesting respective levels of resonance networks, the respective levels of resonance networks influence each other, and the insertion loss in the passband of the resonance structure may not be increased as resonance frequency points are increased. In addition, multi-frequency point resonance can be formed at a particular required frequency point, thereby broadening a suppression band of the resonance structure.

In a possible implementation of the first aspect, the second-level resonance network includes a second inductor and a second capacitor connected in series. The third-level resonance network includes a third inductor and a third capacitor connected in series. The fourth-level resonance network includes a fourth inductor and a fourth capacitor connected in series.

The first resonance structure further includes a first port and a second port.

A first end of the first capacitor is separately electrically connected to a first end of the first inductor and the first port. A second end of the first capacitor is separately electrically connected to a first end of the second inductor, a first end of the third inductor, and a first end of the fourth inductor. A second end of the second inductor is electrically connected to a first end of the second capacitor. A second end of the third inductor is electrically connected to a first end of the third capacitor. A second end of the fourth inductor is electrically connected to a first end of the fourth capacitor. A second end of the first inductor is separately electrically connected to a second end of the second capacitor, a second end of the third capacitor, a second end of the fourth capacitor, and the second port.

In this implementation, by mutually nesting respective levels of resonance networks, the respective levels of resonance networks influence each other, and the insertion loss in the passband of the resonance structure may not be increased as resonance frequency points are increased. In addition, multi-frequency point resonance can be formed at a particular required frequency point, thereby broadening a suppression band of the resonance structure.

In a possible implementation of the first aspect, the second-level resonance network includes a second inductor and a second capacitor connected in series. The third-level resonance network includes a third inductor and a third capacitor connected in series. The fourth-level resonance network includes a fourth inductor and a fourth capacitor connected in series.

The first resonance structure further includes a first port and a second port.

A first end of the first inductor is separately electrically connected to a first end of the first capacitor and the first port. A second end of the first inductor is separately electrically connected to a first end of the second capacitor, a first end of the third inductor, and a first end of the fourth inductor. A second end of the second capacitor is electrically connected to a first end of the second inductor. A second end of the third inductor is electrically connected to a first end of the third capacitor. A second end of the fourth inductor is electrically connected to a first end of the fourth capacitor. A second end of the first capacitor is separately electrically connected to a second end of the second inductor, a second end of the third capacitor, a second end of the fourth capacitor, and the second port.

In this implementation, by mutually nesting respective levels of resonance networks, the respective levels of resonance networks influence each other, and the insertion loss in the passband of the resonance structure may not be increased as resonance frequency points are increased. In addition, multi-frequency point resonance can be formed at a particular required frequency point, thereby broadening a suppression band of the resonance structure.

In a possible implementation of the first aspect, the first resonance structure includes a fifth-level resonance network and a second secondary resonance network.

The fifth-level resonance network includes at least a fifth inductor.

The second secondary resonance network includes a sixth-level resonance network, a seventh-level resonance network, and an eighth-level resonance network. The second secondary resonance network is connected in parallel to the fifth inductor.

In this implementation, by mutually nesting respective levels of resonance networks, the respective levels of resonance networks influence each other, and the insertion loss in the passband of the resonance structure may not be increased as resonance frequency points are increased. In addition, multi-frequency point resonance can be formed at a particular required frequency point, thereby broadening a suppression band of the resonance structure.

In a possible implementation of the first aspect, the fifth-level resonance network includes a fifth inductor. The sixth-level resonance network includes a sixth inductor and a sixth capacitor connected in series. The seventh-level resonance network includes a seventh capacitor and a seventh inductor connected in series. The eighth-level resonance network includes an eighth capacitor and an eighth inductor connected in series.

The first resonance structure further includes a third port and a fourth port.

A first end of the fifth inductor is separately electrically connected to a first end of the sixth capacitor, a first end of the seventh capacitor, and the third port. A second end of the fifth inductor is separately electrically connected to a second end of the sixth inductor, a second end of the eighth inductor, and the fourth port. A second end of the sixth capacitor is separately electrically connected to a first end of the sixth inductor, a second end of the seventh inductor, and a first end of the eighth capacitor. A second end of the seventh capacitor is electrically connected to a first end of the seventh inductor. A second end of the eighth capacitor is electrically connected to a first end of the eighth inductor.

In this implementation, by mutually nesting respective levels of resonance networks, the respective levels of resonance networks influence each other, and the insertion loss in the passband of the resonance structure may not be increased as resonance frequency points are increased. In addition, multi-frequency point resonance can be formed at a particular required frequency point, thereby broadening a suppression band of the resonance structure.

In a possible implementation of the first aspect, the first resonance structure includes a twelfth-level resonance network and a third secondary resonance network.

The twelfth-level resonance network includes at least a thirteenth inductor and a fourteenth inductor connected in parallel, or a fifteenth capacitor and a sixteenth capacitor connected in parallel.

The third secondary resonance network includes a thirteenth-level resonance network, a fourteenth-level resonance network, and a fifteenth-level resonance network. The third secondary resonance network is connected in series to the thirteenth inductor or the fourteenth inductor. Alternatively, the third secondary resonance network is connected in series to the fifteenth capacitor or the sixteenth capacitor.

In this implementation, by means of mutual influence among a plurality of levels of resonance networks, the insertion loss in the passband of the resonance structure may not be increased as resonance frequency points are increased, and multi-frequency point resonance can be formed at a particular required frequency point.

In a possible implementation of the first aspect, the twelfth-level resonance network includes a thirteenth inductor and a fourteenth inductor connected in parallel. The thirteenth-level resonance network includes a fifteenth inductor. The fourteenth-level resonance network includes a sixteenth inductor and a seventeenth inductor connected in series. The fifteenth-level resonance network includes a thirteenth capacitor and a fourteenth capacitor connected in series.

The first resonance structure further includes a fifth port and a sixth port.

A first end of the fourteenth inductor is separately electrically connected to a first end of the thirteenth inductor and the fifth port. A second end of the fourteenth inductor is separately electrically connected to a first end of the fifteenth inductor and a first end of the sixteenth inductor. A second end of the sixteenth inductor is separately electrically connected to a first end of the seventeenth inductor and a first end of the thirteenth capacitor. A second end of the thirteenth capacitor is electrically connected to a first end of the fourteenth capacitor. A second end of the fourteenth capacitor is connected to a ground. A second end of the seventeenth inductor is separately electrically connected to a second end of the fifteenth inductor, a second end of the thirteenth inductor, and the sixth port.

In this implementation, by means of mutual influence among a plurality of levels of resonance networks, the insertion loss in the passband of the resonance structure may not be increased as resonance frequency points are increased, and multi-frequency point resonance can be formed at a particular required frequency point.

In a possible implementation of the first aspect, the twelfth-level resonance network includes a fifteenth capacitor and a sixteenth capacitor connected in parallel. The thirteenth-level resonance network includes an eighteenth inductor. The fourteenth-level resonance network includes a nineteenth inductor and a twentieth inductor connected in series. The fifteenth-level resonance network includes a seventeenth capacitor.

The first resonance structure further includes a fifth port and a sixth port.

A first end of the sixteenth capacitor is separately electrically connected to a first end of the fifteenth capacitor and the fifth port. A second end of the sixteenth capacitor is separately electrically connected to a first end of the eighteenth inductor and a first end of the nineteenth inductor. A second end of the nineteenth inductor is separately electrically connected to a first end of the twentieth inductor and a first end of the seventeenth capacitor. A second end of the seventeenth capacitor is connected to a ground. A second end of the twentieth inductor is separately electrically connected to a second end of the eighteenth inductor, a second end of the fifteenth capacitor, and the sixth port.

In this implementation, by means of mutual influence among a plurality of levels of resonance networks, the insertion loss in the passband of the resonance structure may not be increased as resonance frequency points are increased, and multi-frequency point resonance can be formed at a particular required frequency point.

In a possible implementation of the first aspect, the resonance structure further includes a second resonance structure. The second resonance structure is electrically connected to the first resonance structure in series and/or parallel. The second resonance structure and the first resonance structure do not influence each other.

In this implementation, by means of the first resonance structure, the insertion loss in the passband of the resonance structure may not be increased as resonance frequency points are increased, and multi-frequency point resonance can be formed at a particular required frequency point. In addition, the second resonance structure has a further frequency point and frequency point depth suppression effect.

In a possible implementation of the first aspect, the second resonance structure includes a ninth-level resonance network. The ninth-level resonance network is connected in parallel to the first resonance structure.

The ninth-level resonance network includes a ninth capacitor and a ninth inductor connected in series.

The first resonance structure includes a fifth-level resonance network, a sixth-level resonance network, a seventh-level resonance network, and an eighth-level resonance network. The fifth-level resonance network includes a fifth inductor. The sixth-level resonance network includes a sixth inductor and a sixth capacitor connected in series. The seventh-level resonance network includes a seventh capacitor and a seventh inductor connected in series. The eighth-level resonance network includes an eighth capacitor and an eighth inductor connected in series. The first resonance structure further includes a third port and a fourth port.

A first end of the fifth inductor is separately electrically connected to a first end of the sixth capacitor, a first end of the seventh capacitor, a first end of the ninth capacitor, and the third port. A second end of the fifth inductor is separately electrically connected to a second end of the sixth inductor, a second end of the eighth inductor, and the fourth port. A second end of the sixth capacitor is separately electrically connected to a first end of the sixth inductor, a second end of the seventh inductor, and a first end of the eighth capacitor. A second end of the seventh capacitor is electrically connected to a first end of the seventh inductor. A second end of the eighth capacitor is electrically connected to a first end of the eighth inductor. A second end of the ninth capacitor is electrically connected to a first end of the ninth inductor. A second end of the ninth inductor is connected to a ground.

In this implementation, by means of the first resonance structure, the insertion loss in the passband of the resonance structure may not be increased as resonance frequency points are increased, and multi-frequency point resonance can be formed at a particular required frequency point. In addition, the ninth-level resonance network has a further frequency point and frequency point depth suppression effect.

In a possible implementation of the first aspect, the second resonance structure includes a tenth-level resonance network. The tenth-level resonance network is connected in parallel to the first resonance structure.

The tenth-level resonance network includes a tenth capacitor, an eleventh capacitor, and a tenth inductor. The eleventh capacitor is connected in parallel to the tenth inductor and is connected in series to the tenth capacitor.

The first resonance structure includes a fifth-level resonance network, a sixth-level resonance network, a seventh-level resonance network, and an eighth-level resonance network. The fifth-level resonance network includes a fifth inductor. The sixth-level resonance network includes a sixth inductor and a sixth capacitor connected in series. The seventh-level resonance network includes a seventh capacitor and a seventh inductor connected in series. The eighth-level resonance network includes an eighth capacitor and an eighth inductor connected in series. The first resonance structure further includes a third port and a fourth port.

A first end of the fifth inductor is separately electrically connected to a first end of the sixth capacitor, a first end of the seventh capacitor, a first end of the tenth capacitor, and the third port. A second end of the fifth inductor is separately electrically connected to a second end of the sixth inductor, a second end of the eighth inductor, and the fourth port. A second end of the sixth capacitor is separately electrically connected to a first end of the sixth inductor, a second end of the seventh inductor, and a first end of the eighth capacitor. A second end of the seventh capacitor is electrically connected to a first end of the seventh inductor. A second end of the eighth capacitor is electrically connected to a first end of the eighth inductor. A second end of the tenth capacitor is separately electrically connected to a first end of the eleventh capacitor and a first end of the tenth inductor. A second end of the eleventh capacitor is electrically connected to a second end of the tenth inductor and is connected to a ground.

In this implementation, by means of the first resonance structure, the insertion loss in the passband of the resonance structure may not be increased as resonance frequency points are increased, and multi-frequency point resonance can be formed at a particular required frequency point. In addition, the tenth-level resonance network has a further frequency point and frequency point depth suppression effect.

In a possible implementation of the first aspect, the second resonance structure includes an eleventh-level resonance network. The eleventh-level resonance network is connected in parallel to the first resonance structure.

The eleventh-level resonance network includes a twelfth capacitor, an eleventh inductor, and a twelfth inductor. The eleventh inductor is connected in parallel to the twelfth inductor and is connected in series to the twelfth capacitor.

The first resonance structure includes a fifth-level resonance network, a sixth-level resonance network, a seventh-level resonance network, and an eighth-level resonance network. The fifth-level resonance network includes a fifth inductor. The sixth-level resonance network includes a sixth inductor and a sixth capacitor connected in series. The seventh-level resonance network includes a seventh capacitor and a seventh inductor connected in series. The eighth-level resonance network includes an eighth capacitor and an eighth inductor connected in series. The first resonance structure further includes a third port and a fourth port.

A first end of the fifth inductor is separately electrically connected to a first end of the sixth capacitor, a first end of the seventh inductor, a first end of the twelfth capacitor, and the third port. A second end of the fifth inductor is separately electrically connected to a second end of the sixth inductor, a second end of the eighth inductor, and the fourth port. A second end of the sixth capacitor is separately electrically connected to a first end of the sixth inductor, a second end of the seventh capacitor, and a first end of the eighth capacitor. A second end of the seventh inductor is electrically connected to a first end of the seventh capacitor. A second end of the eighth capacitor is electrically connected to a first end of the eighth inductor. A second end of the twelfth capacitor is separately electrically connected to a first end of the eleventh inductor and a first end of the twelfth inductor. A second end of the eleventh inductor is electrically connected to a second end of the twelfth inductor and is connected to a ground.

In this implementation, by means of the first resonance structure, the insertion loss in the passband of the resonance structure may not be increased as resonance frequency points are increased, and multi-frequency point resonance can be formed at a particular required frequency point. In addition, the eleventh-level resonance network has a further frequency point and frequency point depth suppression effect.

According to a second aspect, a radio frequency system is provided, including at least one of a filter, a combiner, a notch filter, a duplexer, and a multiplexer. The filter, the combiner, the notch filter, the duplexer, or the multiplexer includes the resonance structure according to the first aspect or in any possible implementation of the first aspect.

In a possible implementation of the first aspect, the radio frequency system includes a combiner. The combiner includes at least two resonance structures. The at least two resonance structures are configured to combine at least two signals.

In this implementation, the combiner has good effects such as frequency suppression and band broadening.

In a possible implementation of the first aspect, the combiner includes a twentieth-level resonance network and a first resonance structure connected in parallel.

The twentieth-level resonance network includes a twenty-first inductor, an eighteenth capacitor, a twenty-second inductor, and a twelfth port. The eighteenth capacitor is connected in series to the twenty-second inductor and is connected in parallel to the twenty-first inductor.

The first resonance structure includes a first-level resonance network, a second-level resonance network, a third-level resonance network, and a fourth-level resonance network. The first-level resonance network includes a first inductor and a first capacitor connected in parallel. The second-level resonance network includes a second inductor and a second capacitor connected in series. The third-level resonance network includes a third inductor and a third capacitor connected in series. The fourth-level resonance network includes a fourth inductor and a fourth capacitor connected in series. The first resonance structure further includes a first port and a second port.

A first end of the first capacitor is separately electrically connected to a first end of the first inductor, a first end of the twenty-first inductor, a first end of the eighteenth capacitor, and the first port. A second end of the first capacitor is separately electrically connected to a first end of the second inductor, a first end of the third inductor, and a first end of the fourth inductor. A second end of the second inductor is electrically connected to a first end of the second capacitor. A second end of the third inductor is electrically connected to a first end of the third capacitor. A second end of the fourth inductor is electrically connected to a first end of the fourth capacitor. A second end of the first inductor is separately electrically connected to a second end of the second capacitor, a second end of the third capacitor, a second end of the fourth capacitor, and the second port. A second end of the eighteenth capacitor is electrically connected to a first end of the twenty-second inductor. A second end of the twenty-first inductor is separately electrically connected to a second end of the twenty-second inductor and the twelfth port.

In this implementation, the combiner has good effects such as frequency suppression and band broadening.

In a possible implementation of the first aspect, the combiner includes a thirty-third port, a fifty-first inductor, a thirty-sixth capacitor, a fifty-second inductor, a fifty-third inductor, a thirty-seventh capacitor, a thirty-fourth port, a thirty-eighth capacitor, a fifty-fourth inductor, a thirty-ninth capacitor, a fifty-fifth inductor, a fifty-sixth inductor, a fortieth capacitor, a forty-first capacitor, and a thirty-fifth port.

A first end of the fifty-first inductor is separately electrically connected to a first end of the thirty-sixth capacitor, a first end of the thirty-eighth capacitor, a first end of the fifty-fourth inductor, and the thirty-fifth port. A second end of the thirty-sixth capacitor is separately electrically connected to a first end of the fifty-second inductor and a first end of the fifty-third inductor. A second end of the fifty-first inductor is separately electrically connected to a second end of the fifty-second inductor and the thirty-third port. A second end of the fifty-third inductor is separately electrically connected to a first end of the thirty-seventh capacitor. A second end of the thirty-seventh capacitor is connected to a ground. A second end of the fifty-fourth inductor is separately electrically connected to a first end of the thirty-ninth capacitor and a first end of the fifty-fifth inductor. A second end of the thirty-eighth capacitor is separately electrically connected to a second end of the thirty-ninth capacitor and a first end of the fortieth capacitor. A second end of the fifty-fifth inductor is electrically connected to a first end of the fifty-sixth inductor. A second end of the fifty-sixth inductor is connected to a ground. A second end of the fortieth capacitor is separately electrically connected to a first end of the forty-first capacitor and the thirty-fourth port. A second end of the forty-first capacitor is connected to a ground.

In this implementation, the combiner has good effects such as frequency suppression and band broadening.

In a possible implementation of the first aspect, the combiner includes a thirty-eighth port, a fifty-seventh inductor, a forty-second capacitor, a fifty-eighth inductor, a fifty-ninth inductor, a forty-third capacitor, a thirty-sixth port, a forty-fourth capacitor, a sixtieth inductor, a sixty-first inductor, a forty-fifth capacitor, a sixty-second inductor, and a thirty-seventh port.

A first end of the forty-fourth capacitor is separately electrically connected to a first end of the sixtieth inductor, a first end of the fifty-seventh inductor, a first end of the forty-second capacitor, and the thirty-eighth port. A second end of the forty-second capacitor is separately electrically connected to a first end of the fifty-eighth inductor and a first end of the fifty-ninth inductor. A second end of the fifty-seventh inductor is separately electrically connected to a second end of the fifty-eighth inductor and the thirty-sixth port. A second end of the fifty-ninth inductor is electrically connected to a first end of the forty-third capacitor. A second end of the forty-third capacitor is connected to a ground. A second end of the sixtieth inductor is separately electrically connected to a first end of the forty-fifth capacitor and a first end of the sixty-first inductor. A second end of the forty-fourth capacitor is separately electrically connected to a second end of the sixty-first inductor and the thirty-seventh port. A second end of the forty-fifth capacitor is electrically connected to a first end of the sixty-second inductor. A second end of the sixty-second inductor is connected to a ground.

In this implementation, the combiner has good effects such as frequency suppression and band broadening.

In a possible implementation of the first aspect, the combiner includes a forty-first port, a sixty-third inductor, a forty-sixth capacitor, a sixty-fourth inductor, a sixty-fifth inductor, a sixty-sixth inductor, a thirty-ninth port, a forty-seventh capacitor, a forty-eighth capacitor, a forty-ninth capacitor, a sixty-seventh inductor, a sixty-eighth inductor, and a fortieth port.

A first end of the sixty-third inductor is separately electrically connected to a first end of the forty-seventh capacitor, a first end of the forty-ninth capacitor, a first end of the forty-sixth capacitor, and the forty-first port. A second end of the forty-sixth capacitor is separately electrically connected to a first end of the sixty-fourth inductor and a first end of the sixty-fifth inductor. A second end of the sixty-third inductor is separately electrically connected to a second end of the sixty-fourth inductor, a second end of the sixty-fifth inductor, a first end of the sixty-sixth inductor, and the thirty-ninth port. A second end of the sixty-sixth inductor is connected to a ground. A second end of the forty-ninth capacitor is separately electrically connected to a first end of the sixty-seventh inductor and a first end of the sixty-eighth inductor. A second end of the forty-seventh capacitor is separately electrically connected to a second end of the sixty-seventh inductor and a first end of the forty-eighth capacitor. A second end of the forty-eighth capacitor is electrically connected to the fortieth port. A second end of the sixty-eighth inductor is connected to a ground.

In this implementation, the combiner has good effects such as frequency suppression and band broadening.

In a possible implementation of the first aspect, the combiner includes a forty-fourth port, a sixty-ninth inductor, a fiftieth capacitor, a fifty-first capacitor, a forty-second port, a fifty-second capacitor, a seventieth inductor, a fifty-third capacitor, a seventy-first inductor, a seventy-second inductor, a seventy-third inductor, and a forty-third port.

A first end of the fifty-second capacitor is separately electrically connected to a first end of the sixty-ninth inductor, a first end of the fifty-first capacitor, a first end of the seventieth inductor, and the forty-fourth port. A second end of the fifty-second capacitor is separately electrically connected to a first end of the seventy-second inductor and a first end of the fifty-third capacitor. A second end of the seventy-second inductor is electrically connected to a first end of the seventy-third inductor. A second end of the fifty-third capacitor is electrically connected to a first end of the seventy-first inductor. A second end of the seventy-first inductor is separately electrically connected to a second end of the seventy-third inductor, a second end of the seventieth inductor, and the forty-third port. A second end of the sixty-ninth inductor is electrically connected to a first end of the fiftieth capacitor. A second end of the fiftieth capacitor is separately electrically connected to a second end of the fifty-first capacitor and the forty-second port. Two ports are configured to input a signal, and a port is configured to output a signal.

In this implementation, the combiner has good effects such as frequency suppression and band broadening.

According to a third aspect, an electronic device is provided, including the radio frequency system according to the second aspect or in any possible implementation of the second aspect.

### BRIEF DESCRIPTION OF DRAWINGS

FIG. 1 is a schematic structural diagram of a first electronic device according to an embodiment of this application;
FIG. 2 is a schematic structural diagram of a second electronic device according to an embodiment of this application;
FIG. 3 is a schematic diagram of a wireless communication principle of an electronic device according to an embodiment of this application;
FIG. 4 is a schematic diagram of an electric connection of a resonance network 02 and a resonance network 03 according to an embodiment of this application;
FIG. 5 is a schematic diagram of a first single resonance network in the related technology according to an embodiment of this application;
FIG. 6 is a schematic diagram of a relationship between an insertion loss and frequency of the single resonance network of FIG. 5;
FIG. 7 is a schematic diagram of a second single resonance network in the related technology according to an embodiment of this application;
FIG. 8 is a schematic diagram of a relationship between an insertion loss and frequency of the single resonance network of FIG. 7;
FIG. 9 is a schematic diagram of a third single resonance network in the related technology according to an embodiment of this application;
FIG. 10 is a schematic diagram of a relationship between an insertion loss and frequency of the single resonance network of FIG. 9;
FIG. 11 is a schematic diagram of a resonance network in the related technology formed after the single resonance network of FIG. 5, the single resonance network of FIG. 7, and the single resonance network of FIG. 9 are connected in series;
FIG. 12 is a schematic diagram of a relationship between an insertion loss and frequency of the resonance network of FIG. 11;
FIG. 13 is a schematic diagram of a fourth single resonance network in the related technology according to an embodiment of this application;
FIG. 14 is a schematic diagram of a relationship between an insertion loss and frequency of the single resonance network of FIG. 13;
FIG. 15 is a schematic diagram of a resonance network in the related technology formed after the single resonance network of FIG. 5, the single resonance network of FIG. 13, and the single resonance network of FIG. 9 are connected in series and parallel;
FIG. 16 is a schematic diagram of a relationship between an insertion loss and frequency of the resonance network of FIG. 15;
FIG. 17 is a schematic diagram of a first type of first resonance structure according to an embodiment of this application;
FIG. 18 is a schematic diagram of a relationship between an insertion loss and frequency of the first resonance structure of FIG. 17;
FIG. 19 is a schematic diagram of a resonance network formed by combining a first-level resonance network and a second-level resonance network in FIG. 17;
FIG. 20 is a schematic diagram of a relationship between an insertion loss and frequency of the resonance network of FIG. 19;
FIG. 21 is a schematic diagram of a resonance network formed by combining a first-level resonance network and a third-level resonance network in FIG. 17;
FIG. 22 is a schematic diagram of a relationship between an insertion loss and frequency of the resonance network of FIG. 21;
FIG. 23 is a schematic diagram of a resonance network formed by combining a first-level resonance network and a fourth-level resonance network in FIG. 17;
FIG. 24 is a schematic diagram of a relationship between an insertion loss and frequency of the resonance network of FIG. 23;
FIG. 25 is a schematic diagram of a resonance network formed by combining a first-level resonance network, a second-level resonance network, and a third-level resonance network in FIG. 17;
FIG. 26 is a schematic diagram of a relationship between an insertion loss and frequency of the resonance network of FIG. 25;
FIG. 27 is a schematic diagram of a second type of first resonance structure according to an embodiment of this application;
FIG. 28 is a schematic diagram of a relationship between an insertion loss and frequency of the first resonance structure of FIG. 27;
FIG. 29 is a schematic diagram of a resonance structure formed by combining the first resonance structure of FIG. 27 and a ninth-level resonance network;
FIG. 30 is a schematic diagram of a relationship between an insertion loss and frequency of the resonance structure of FIG. 29;
FIG. 31 is a schematic diagram of a resonance structure formed by combining the first resonance structure of FIG. 27 and a tenth-level resonance network;
FIG. 32 is a schematic diagram of a relationship between an insertion loss and frequency of the tenth-level resonance network of FIG. 31;
FIG. 33 is a schematic diagram of a relationship between an insertion loss and frequency of the first resonance structure of FIG. 27 in FIG. 31;
FIG. 34 is a schematic diagram of a relationship between an insertion loss and frequency of the resonance structure of FIG. 31;
FIG. 35 is a schematic diagram of a simplified Smith chart according to an embodiment of this application;
FIG. 36 is a schematic diagram of a resonance structure formed by combining a first resonance structure and an eleventh-level resonance network;
FIG. 37 is a schematic diagram of a relationship between an insertion loss and frequency of the first resonance structure of FIG. 36;
FIG. 38 is a schematic diagram of a relationship between an insertion loss and frequency of the eleventh-level resonance network of FIG. 36;
FIG. 39 is a schematic diagram of a relationship between an insertion loss and frequency of the resonance structure of FIG. 36;
FIG. 40 is a schematic diagram of a third type of first resonance structure according to an embodiment of this application;
FIG. 41 is a schematic diagram of a relationship between an insertion loss and frequency of the resonance structure of FIG. 40;
FIG. 42 is a schematic diagram of a fourth type of first resonance structure according to an embodiment of this application;
FIG. 43 is a schematic diagram of a relationship between an insertion loss and frequency of the resonance structure of FIG. 42;
FIG. 44 is a diagram of an application scenario of a filter according to an embodiment of this application;
FIG. 45 is a diagram of an application scenario of a combiner according to an embodiment of this application;
FIG. 46 is a diagram of an application scenario of a filter and a combiner according to an embodiment of this application;
FIG. 47 is a schematic diagram of a fifth type of first resonance structure according to an embodiment of this application;
FIG. 48 is a schematic diagram of a relationship between an insertion loss and frequency of the resonance structure of FIG. 47;
FIG. 49 is a schematic diagram of a resonance structure formed by combining a first resonance structure and a twentieth-level resonance network;
FIG. 50 is a schematic diagram of a relationship between an insertion loss and frequency of the resonance structure of FIG. 49;
FIG. 51 is a schematic structural diagram of a combiner formed by the resonance network of FIG. 11 in the related technology and the twentieth-level resonance network;
FIG. 52 is a schematic diagram of a relationship between an insertion loss and frequency of the combiner of FIG. 51;
FIG. 53 is a schematic structural diagram of a combiner formed by the resonance network of FIG. 15 in the related technology and the twentieth-level resonance network;
FIG. 54 is a schematic diagram of a relationship between an insertion loss and frequency of the combiner of FIG. 53;
FIG. 55 is a schematic diagram of a sixth type of first resonance structure according to an embodiment of this application;
FIG. 56 is a schematic diagram of a seventh type of first resonance structure according to an embodiment of this application;
FIG. 57 is a schematic diagram of a relationship between an insertion loss and frequency of a combiner formed by FIG. 55 and FIG. 56;
FIG. 58 is a diagram of an application scenario of another combiner according to an embodiment of this application;
FIG. 59 is a schematic diagram of an eighth type of first resonance structure according to an embodiment of this application;
FIG. 60 is a schematic diagram of a ninth type of first resonance structure according to an embodiment of this application;
FIG. 61 is a schematic diagram of a tenth type of first resonance structure according to an embodiment of this application;
FIG. 62 is a schematic diagram of a relationship between an insertion loss and frequency of a combiner formed by FIG. 59, FIG. 60, and FIG. 61;
FIG. 63 is a schematic diagram of an eleventh type of first resonance structure according to an embodiment of this application;
FIG. 64 is a schematic diagram of a twelfth type of first resonance structure according to an embodiment of this application;
FIG. 65 is a schematic diagram of a thirteenth type of first resonance structure according to an embodiment of this application;
FIG. 66 is a schematic diagram of a relationship between an insertion loss and frequency of a combiner formed by FIG. 63, FIG. 64, and FIG. 65;
FIG. 67 is a schematic diagram of a combiner according to an embodiment of this application;
FIG. 68 is a schematic diagram of a relationship between an insertion loss and frequency of the combiner of FIG. 67;
FIG. 69 is a schematic diagram of another combiner according to an embodiment of this application;
FIG. 70 is a schematic diagram of a relationship between an insertion loss and frequency of the combiner of FIG. 69;
FIG. 71 is a schematic diagram of still another combiner according to an embodiment of this application;
FIG. 72 is a schematic diagram of a relationship between an insertion loss and frequency of the combiner of FIG. 71;
FIG. 73 is a schematic diagram of an electronic device according to an embodiment of this application;
FIG. 74 is a schematic diagram of the combiner in FIG. 73;
FIG. 75 is a schematic diagram of a relationship between an insertion loss and frequency of the combiner of FIG. 74;
FIG. 76 is a schematic diagram of a relationship between an insertion loss and frequency of a combiner in the related technology according to an embodiment of this application; and
FIG. 77 is a schematic diagram of a relationship between an insertion loss and frequency of another combiner in the related technology according to an embodiment of this application.

### DESCRIPTION OF EMBODIMENTS

The following clearly describes technical solutions in embodiments of this application in detail with reference to the accompanying drawings.

In the descriptions of the embodiments of this application, "/" means "or" unless otherwise specified. For example, A/B may represent A or B. In this specification, "and/or" describes only an association relationship for describing associated objects and indicates that three relationships may exist. For example, A and/or B may represent the following three cases: A exists alone, A and B exist at the same time, and B exists alone.

In the following, the terms "first" to "seventy-third" are only used for descriptive purposes, and cannot be understood as indicating or implying relative importance or implicitly indicating a quantity of indicated technical features. Therefore, a feature defined by "first" to "seventy-third" may explicitly or implicitly include one or more features.

In the description of the embodiments of this application, unless otherwise specified, "a plurality of" means two or more. "At least one" means one or more.

Some terms in the embodiments of this application are first described for ease of better understanding by a person skilled in the art.

### 1. Filter

The filter is a filter circuit, which can effectively filter a frequency point of a particular frequency or a frequency other than the frequency point, to obtain a signal of a particular frequency or eliminate another signal of a particular frequency.

### 2. Combiner

The combiner is a circuit that can combine inputted multi-band signals for output.

### 3. Notch filter

The notch filter is a circuit that can filter unnecessary frequency signals.

### 4. Duplexer

The duplexer is generally formed by combining two filters at different frequencies, where one filter is used as a transmitting filter, the other filter is used as a receiving filter, and the two filters share one common node (antenna) for isolating a transmitted signal from a received signal and allowing both transmitting and receiving to operate normally at the same time.

### 5. Multiplexer

The multiplexer is a combined circuit, and is a general term for such devices as a duplexer, a triplexer, and a quadruplexer. The multiplexer has a single input port and a plurality of output ports, and is a group of non-superposed filters. In a combined manner, these filters ensure that they are not loaded with each other, and are highly isolated between outputs.

### 6. Insertion loss

The insertion loss is also an insert loss, and refers to a loss of energy or gain when a circuit device or a branch circuit is added to a circuit. A low loss can maximize signal efficiency, to reduce signal power.

### 7. Stop band

The stop band is a band covered by a radio frequency signal that cannot pass a device such as a filter or a combiner.

### 8. Passband

The passband is a band covered by a radio frequency signal that can pass a device such as a filter or a combiner.

### 9. Channel

The channel refers to a number of channels through which a device such as a filter and a combiner can independently receive signal data. A higher number of channels indicates a stronger capability of collecting data in parallel and a better performance.

### 10. pF

The Chinese name of pF is picofarad, which is a unit of capacitance.

### 11. nH

The Chinese name of nH is nanohenry, which is a unit of inductance.

### 12. dB

The Chinese name of dB is decibel, which is a unit of an insertion loss.

The foregoing is a brief introduction to the terms involved in the embodiments of this application, and details are not described below.

**For ease of understanding embodiments of this application, the following first describes an application background of this application.**

An embodiment of this application provides an electronic device. A specific type of the electronic device is not limited herein. In some embodiments, the electronic device of this application may include a mobile phone, a wearable device (such as a smart bracelet, a smart watch, or a headset), a tablet computer, a laptop (laptop), a handheld computer, a notebook computer, an ultra-mobile personal computer (ultra-mobile personal computer, UMPC), a cellular phone, a personal digital assistant (personal digital assistant, PDA), an augmented reality (augmented reality, AR)/virtual reality (virtual reality, VR) device, another Internet of things (internet of things, IOT) device, an in-vehicle electronic device, and the like, and may alternatively be a device such as a television, a large screen, a printer, or a projector.

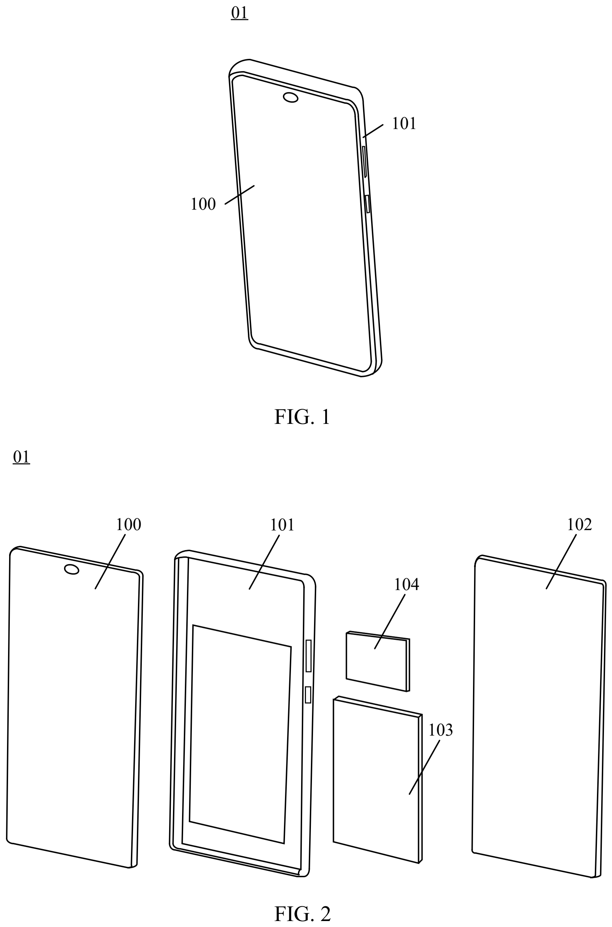

For ease of description, FIG. 1 shows a schematic overall diagram of an electronic device (such as a mobile phone). FIG. 2 shows a schematic split view of the electronic device (such as the mobile phone) in FIG. 1.

The following describes a structure of the electronic device in this embodiment of this application.

As shown in FIG. 1 and with reference to FIG. 2, an example in which the electronic device is a mobile phone 01 is used. The mobile phone 01 may include a display screen 100 and a middle frame 101. The display screen 100 is located on a side of the middle frame 101.

As shown in FIG. 2, the mobile phone 01 may further include structures such as a battery cover 102, a circuit board assembly 103, and a battery 104. The battery cover 102 is disposed on a side of the middle frame 101 away from the display screen 100. In addition, an accommodating space (not shown in the figure) for accommodating the circuit board assembly 103 and the battery 104 is formed between the battery cover 102 and the middle frame 101, and the circuit board assembly 103 and the battery 104 are located in the accommodating space. The circuit board assembly 103 usually carries electronic devices such as a processor system, a controller system, a storage system, a communication system, a radio frequency system, and a power management system. The circuit board assembly 103 herein may be understood as a main circuit board of the electronic device. The circuit board assembly 103 may include, for example, a printed circuit board (printed circuit boards, PCB), a flexible printed circuit (flexible printed circuit, FPC), and the like.

It should be noted that the display screen 100 may be any one of a liquid crystal display (liquid crystal display, LCD), an organic light emitting diode (organic light emitting diode, OLED) display screen, a mini light emitting diode (mini light emitting diode, Mini LED) display screen, or a micro light emitting diode (micro light emitting diode, Micro LED) display screen.

In addition, the mobile phone 01 may further include another structure such as a microphone, a speaker, and a camera.

Therefore, the structure shown in FIG. 2 does not limit the structure of the electronic device.

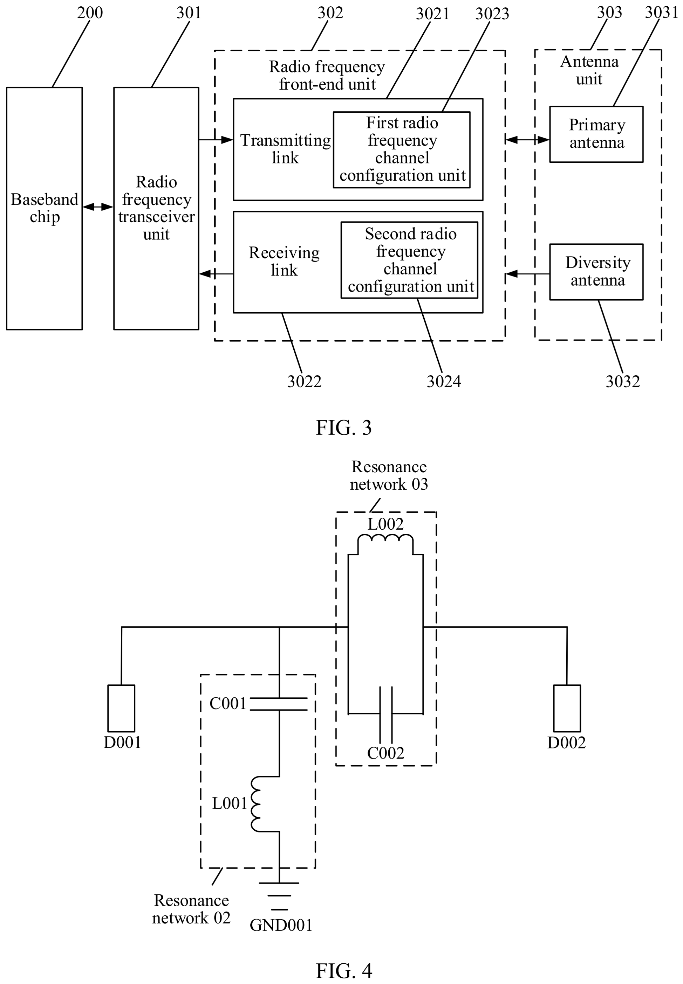

For ease of description, FIG. 3 shows a schematic diagram of a wireless communication principle of the mobile phone in FIG. 1.

Referring to FIG. 3, the electronic device provided in this embodiment of this application may include a baseband chip 200 and a radio frequency system electrically connected to the baseband chip 200. The radio frequency system may include a radio frequency transceiver unit 301, a radio frequency front-end unit 302, and an antenna unit 303.

As shown in FIG. 3, the radio frequency transceiver unit 301 is separately electrically connected to the baseband chip 200 and a side of the radio frequency front-end unit 302 facing away from the antenna unit 303. The radio frequency front-end unit 302 is further electrically connected to the antenna unit 303 by using an external interface. The radio frequency front-end unit 302 has a radio frequency channel. The radio frequency channel may include a transmitting link 3021 and a receiving link 3022. There may be one or more transmitting links 3021 and receiving links 3022. The transmitting link 3021 has a first radio frequency channel configuration unit 3023, and may be configured to transmit radio frequency signals in a plurality of different bands. The receiving link 3022 has a second radio frequency channel configuration unit 3024, and may be configured to receive radio frequency signals in a plurality of different bands.

In application, the baseband chip 200, the radio frequency transceiver unit 301, and the radio frequency front-end unit 302 may all be disposed on a main circuit board of the mobile phone. The baseband chip 200 may be configured to process a digital baseband signal. For example, the baseband chip 200 may be configured to encode and decode the digital baseband signal. The radio frequency transceiver unit 301 may be configured to perform conversion between a digital baseband signal and an analog radio frequency signal. For example, the radio frequency transceiver unit 301 may process a digital baseband signal transmitted by the baseband chip 200 into an analog radio frequency signal and transmit the analog radio frequency signal to the transmitting link 3021 of the radio frequency front-end unit 302. Alternatively, the radio frequency transceiver unit 301 may obtain an analog radio frequency signal transmitted by the receiving link 3022 of the radio frequency front-end unit 302, convert the analog radio frequency signal into a digital baseband signal, and transmit the digital baseband signal to the baseband chip 200.

The antenna unit may include a plurality of antennas, for transmitting radio frequency signals in different bands. As shown in FIG. 3, the plurality of antennas in the antenna unit 303 may be divided into a primary antenna 3031 and a diversity antenna 3032. The radio frequency front-end unit 302 may be configured to send an analog radio frequency signal to the primary antenna 3031. Alternatively, the radio frequency front-end unit 302 may receive an analog radio frequency signal from the primary antenna 3031 and the diversity antenna 3032, to implement processing such as amplification and filtering on the analog radio frequency signal.

It should be understood that the baseband chip 200, the radio frequency transceiver unit 301, the radio frequency front-end unit 302, and the antenna unit 303 may form a conduction end of a wireless communication system. When receiving a radio frequency signal (i.e. a transmitted signal) outputted by the baseband chip 200, the radio frequency transceiver unit 301 mixes, amplifies, filters, and outputs the transmitted signal to the corresponding transmitting link 3021 in the radio frequency front-end unit 302 by using a band in which the transmitted signal is located, and then switches, by using the radio frequency front-end unit 302, the transmitted signal to the corresponding primary antenna 3031 for radiation. Correspondingly, when the antenna unit 303 receives a radio frequency signal and the radio frequency signal enters the radio frequency front-end unit 302, the radio frequency front-end unit 302 may switch the received radio frequency signal (i.e. a received signal) to the corresponding receiving link 3022. The received signal is amplified, filtered, mixed, and then inputted into the baseband chip 200 for demodulation by using a radio frequency device in the receiving link 3022.

It should be noted that the radio frequency transceiver unit 301 may further be configured to control handovers between different transmitting links 3021 and receiving links 3022 in the radio frequency front-end unit 302.

Therefore, the electronic device may perform wireless communication with a network device or another electronic device through the conduction end of the wireless communication system and via a wireless network, to transmit and receive information with the network device or the other electronic device. It may be understood that the network device herein may include a server, a base station, and the like.

For example, the transmitting link 3021 may include, but is not limited to, a link formed by electrically connecting a power amplifier, a filter, a switch, and the like. The receiving link 3022 may include, but is not limited to, a link formed by electrically connecting a low noise amplifier, a filter, a switch, and the like. Certainly, the transmitting link 3021 and the receiving link 3022 may alternatively be formed by using other different structures. This is not specifically limited herein.

It should be understood that the radio frequency device in the radio frequency system may include, but is not limited to, a filter, a combiner, a notch filter (notch filter), a duplexer (duplexer), and a multiplexer (multiplexer), depending on an actual application. The filter, the combiner, the notch filter, the duplexer, and the multiplexer herein are usually formed by a resonance structure.

**The following describes a resonance structure of a radio frequency device in a radio frequency system provided in the related technology in detail.**

For example, a frequency of a passband B41 is 2.496 to 2.690 GHz. If a frequency of 1.710 to 2.170 GHz needs to be suppressed, because a frequency range to be suppressed is 0.460 GHz and a band in which the frequency needs to be suppressed is relatively wide, it is very difficult to achieve, by using a single-level resonance network, a suitable suppression depth in an entire band of frequency to be suppressed. Therefore, currently, a plurality of single-level resonance networks are usually stacked and combined in series and/or parallel, to implement a suitable suppression band, a suitable suppression depth, and the like.

The following provides three different resonance structures connected in series and/or parallel in the related technology.

### Example 1

FIG. 4 shows a resonance network formed by stacking and combining in series and parallel in the related technology.

As shown in FIG. 4, a resonance structure includes a port D001, a resonance network 02, a resonance network 03, a port D002, and a ground GND001. A first end of the resonance network 02 is separately electrically connected to a first end of the resonance network 03 and the port D001. A second end of the resonance network 02 is connected to the ground GND001. A second end of the resonance network 03 is electrically connected to the port D002.

Specifically, as shown in FIG. 4, the resonance network 02 includes a capacitor C001 and an inductor L001, and the capacitor C001 is connected in series to the inductor L001. The resonance network 03 includes a capacitor C002 and an inductor L002, and the capacitor C001 is connected in parallel to the inductor L001. A first end of the capacitor C001 is separately electrically connected to a first end of the capacitor C002, a first end of the inductor L002, and the port D001. A second end of the capacitor C001 is electrically connected to a first end of the inductor L001. A second end of the inductor L001 is connected to the ground GND001. A second end of the capacitor C002 is separately electrically connected to a second end of the inductor L002 and the port D002.

In an actual application, in FIG. 4, a capacitance value of the capacitor C001 may be 0.5 pF. An inductance value of the inductor L001 may be 9.1 nH. A capacitance value of the capacitor C002 may be 1.2 pF. An inductance value of the inductor L002 may be 4.7 nH. Certainly, the capacitance value of each capacitor and the inductance value of each inductor are not limited thereto. This is not specifically limited herein.

Therefore, FIG. 4 provides a resonance network formed by stacking and combining the resonance network 02 and the resonance network 03 in series and parallel. An overall insertion loss of the resonance network is increased level by level as resonance frequency points are increased. In addition, the resonance network 02 and the resonance network 03 have frequency responses to a same frequency point, leading to degradation of overall consistency of the resonance network.

### Example 2

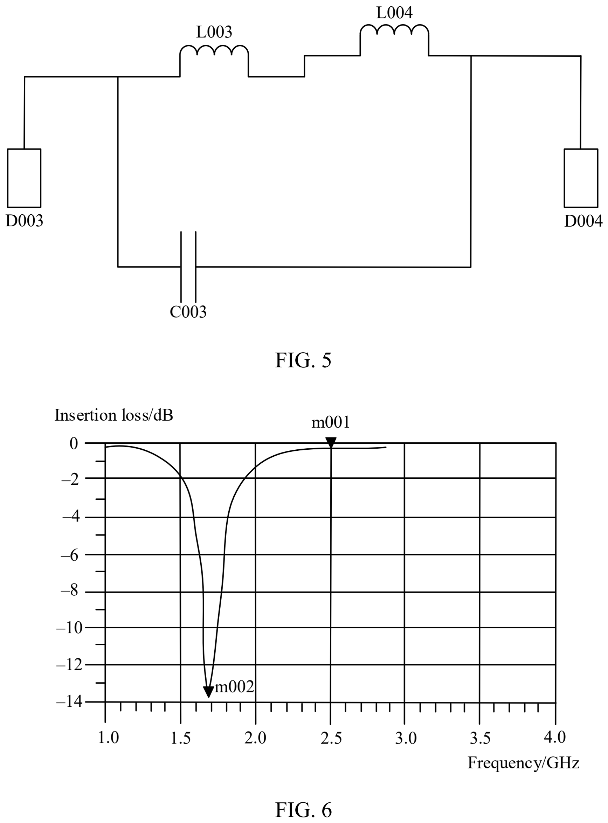

FIG. 5 shows a single resonance network in the related technology. FIG. 6 correspondingly shows a schematic diagram of a relationship between an insertion loss and frequency of the single resonance network in FIG. 5.

As shown in FIG. 5, the single resonance network includes a port D003, a capacitor C003, an inductor L003, an inductor L004, and a port D004. A first end of the capacitor C003 is separately electrically connected to a first end of the inductor L003 and the port D003. A second end of the capacitor C003 is separately electrically connected to a second end of the inductor L004 and the port D004. A second end of the inductor L003 is electrically connected to a first end of the inductor L004.

For a schematic diagram of a relationship between an insertion loss and frequency of the single resonance network in FIG. 5, refer to FIG. 6. As shown in FIG. 6, an insertion loss of the single resonance network of FIG. 5 at an m001 point, namely at 2.490 GHz is -0.282 dB. Therefore, an absolute value of the insertion loss at 2.490 GHz is 0.282 dB.

As further shown in FIG. 6, an insertion loss of the single resonance network of FIG. 5 at an m002 point, namely at 1.720 GHz is -11.572 dB. Therefore, an absolute value of the insertion loss at 1.720 GHz is 11.572 dB.

The foregoing results indicate that the single resonance network of FIG. 5 can suppress a frequency point of a frequency of approximately 1.720 GHz, but cannot suppress a bandwidth frequency of 1.710 to 2.170 GHz.

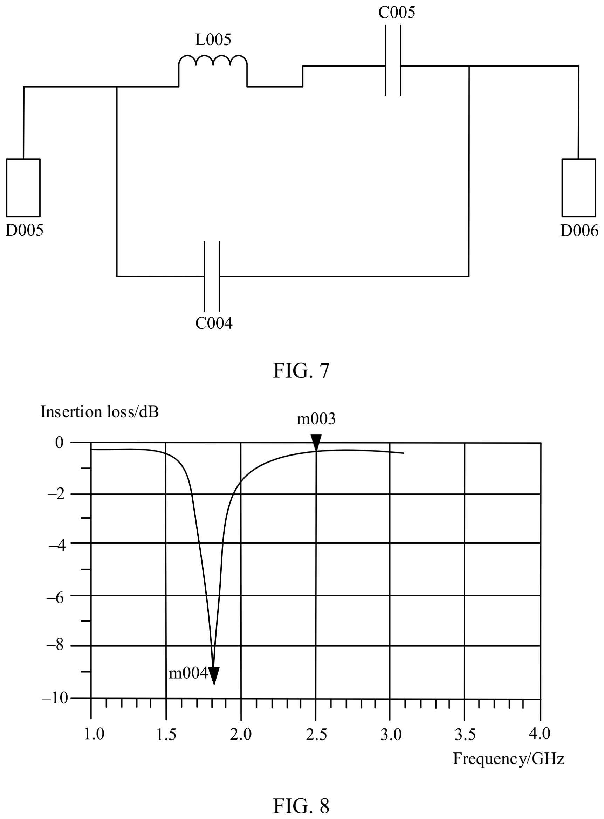

FIG. 7 shows a single resonance network in the related technology. FIG. 8 correspondingly shows a schematic diagram of a relationship between an insertion loss and frequency of the single resonance network in FIG. 7.

As shown in FIG. 7, the resonance structure includes a port D005, a capacitor C004, an inductor L005, a capacitor C005, and a port D006. A first end of the capacitor C004 is separately electrically connected to a first end of the inductor L005 and the port D005. A second end of the capacitor C004 is separately electrically connected to a second end of the capacitor C005 and the port D006. A second end of the inductor L005 is electrically connected to a first end of the capacitor C005.

For a schematic diagram of a relationship between an insertion loss and frequency of the single resonance network in FIG. 7, refer to FIG. 8. As shown in FIG. 8, an insertion loss of the single resonance network of FIG. 7 at an m003 point, namely at 2.490 GHz is -0.284 dB. Therefore, an absolute value of the insertion loss at 2.490 GHz is 0.284 dB.

As further shown in FIG. 8, an insertion loss of the single resonance network of FIG. 7 at an m004 point, namely at 1.820 GHz is -9.494 dB. Therefore, an absolute value of the insertion loss at 1.820 GHz is 9.494 dB.

The foregoing results indicate that the single resonance network of FIG. 7 can suppress a frequency point of a frequency of approximately 1.820 GHz, but cannot suppress a bandwidth frequency of 1.710 to 2.170 GHz.

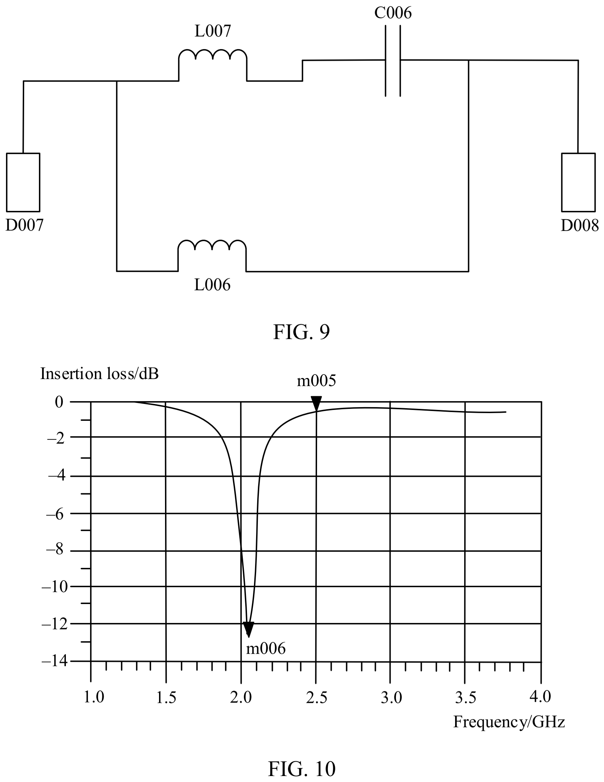

FIG. 9 shows a single resonance network in the related technology. FIG. 10 correspondingly shows a schematic diagram of a relationship between an insertion loss and frequency of the single resonance network in FIG. 9.

As shown in FIG. 9, the resonance structure includes a port D007, an inductor L006, an inductor L007, a capacitor C006, and a port D008. A first end of the inductor L006 is separately electrically connected to a first end of the inductor L007 and the port D007. A second end of the inductor L006 is separately electrically connected to a second end of the capacitor C006 and the port D008. A second end of the inductor L007 is electrically connected to a first end of the capacitor C006.

For a schematic diagram of a relationship between an insertion loss and frequency of the single resonance network in FIG. 9, refer to FIG. 10. As shown in FIG. 10, an insertion loss of the single resonance network of FIG. 9 at an m005 point, namely at 2.490 GHz is -0.177 dB. Therefore, an absolute value of the insertion loss at 2.490 GHz is 0.177 dB.

As further shown in FIG. 10, an insertion loss of the single resonance network of FIG. 9 at an m006 point, namely at 2.040 GHz is -6.254 dB.

The foregoing results indicate that the single resonance network of FIG. 9 may suppress a frequency point of a frequency of approximately 2.040 GHz, but cannot suppress a bandwidth frequency of 1.710 to 2.170 GHz.

Through calculation, a sum of the absolute value (0.282 dB) of the insertion loss of the resonance network of FIG. 5 at 2.490 GHz, the absolute value (0.284 dB) of the insertion loss of the resonance network of FIG. 7 at 2.490 GHz, and the absolute value (0.177 dB) of the insertion loss of the resonance network of FIG. 9 at 2.490 GHz is 0.743 dB (0.282 dB+0.284 dB+0.177 dB=0.743 dB).

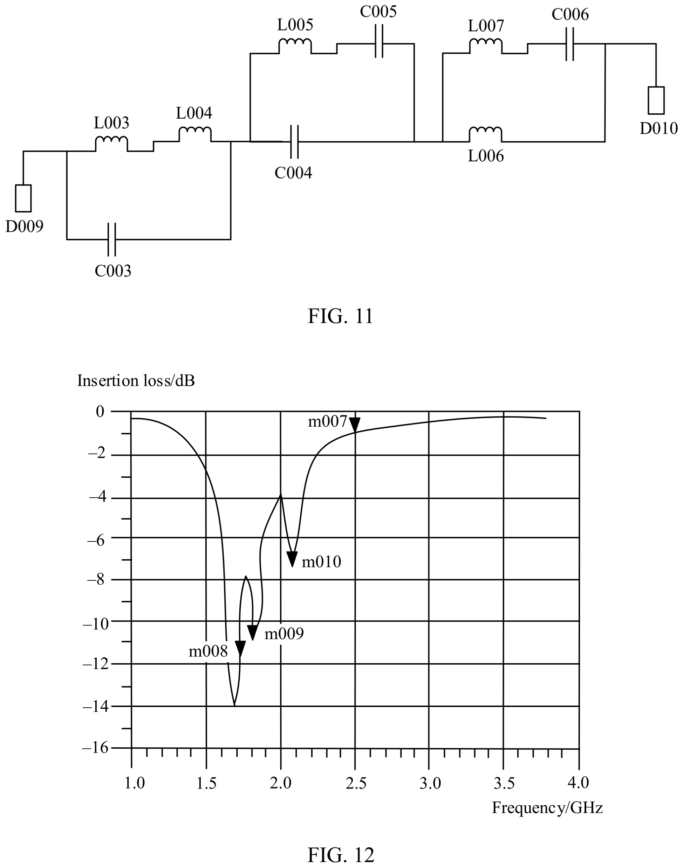

The resonance network of FIG. 5, the resonance network of FIG. 7, and the resonance network of FIG. 9 are connected in series, to obtain a resonance structure shown in FIG. 11. FIG. 12 correspondingly shows a schematic diagram of a relationship between an insertion loss and frequency of the resonance structure in FIG. 11.

As shown in FIG. 11, the resonance structure includes a port D009, a capacitor C003, an inductor L003, an inductor L004, a capacitor C004, an inductor L005, a capacitor C005, an inductor L006, an inductor L007, a capacitor C006, and a port D010. A first end of the capacitor C003 is separately electrically connected to a first end of the inductor L003 and the port D009. A second end of the capacitor C003 is separately electrically connected to a second end of the inductor L004, a first end of the capacitor C004, and a first end of the inductor L005. A second end of the inductor L003 is electrically connected to a first end of the inductor L004. A second end of the capacitor C004 is separately electrically connected to a first end of the inductor L006, a second end of the capacitor C005, and a first end of the inductor L007. A second end of the inductor L005 is electrically connected to a first end of the capacitor C005. A second end of the inductor L006 is separately electrically connected to a second end of the capacitor C006 and the port D010. A second end of the inductor L007 is electrically connected to a first end of C006.

For a schematic diagram of a relationship between an insertion loss and frequency of the resonance structure of FIG. 11, refer to FIG. 12. As shown in FIG. 12, an insertion loss of the resonance structure at an m007 point, namely at 2.490 GHz is - 0.930 dB. Therefore, an absolute value of the insertion loss at 2.490 GHz is 0.930 dB.

As further shown in FIG. 12, an insertion loss of the resonance structure of FIG. 11 at an m008 point, namely at 1.720 GHz is -11.515 dB. Therefore, an absolute value of the insertion loss at 1.720 GHz is 11.515 dB. An insertion loss at an m009 point, namely at 1.820 GHz is -10.732 dB. Therefore, an absolute value of the insertion loss at 1.820 GHz is 10.732 dB. An insertion loss at an m010 point, namely at 2.050 GHz is -7.110 dB. Therefore, an absolute value of the insertion loss at 2.050 GHz is 7.110 dB.

The foregoing results indicate that the resonance structure of FIG. 11 may suppress a bandwidth frequency of 1.710 to 2.170 GHz.

However, the absolute value of the insertion loss of the resonance structure of FIG. 11 at 2.490 GHz is 0.930 dB, while the sum of the absolute values of the insertion losses of the resonance network of FIG. 5, the resonance network of FIG. 7, and the resonance network of FIG. 9 at 2.490 GHz is 0.743 dB, where 0.930 dB is greater than 0.743 dB. To be specific, the absolute value of the insertion loss of the resonance structure of FIG. 11 obtained after the single resonance network of FIG. 5, the single resonance network of FIG. 7, and the single resonance network of FIG. 9 are connected in series is greater than the sum of the absolute values of the insertion losses of the single resonance networks.

In addition, the absolute value (11.515 dB) of the insertion loss of the resonance structure of FIG. 11 at 1.720 GHz is close to the absolute value (11.572 dB) of the insertion loss of the single resonance network of FIG. 5 at 1.720 GHz. The absolute value (10.732 dB) of the insertion loss of the resonance structure of FIG. 11 at 1.820 GHz is close to the absolute value (9.494 dB) of the insertion loss of the single resonance network of FIG. 7 at 1.820 GHz. The absolute value (7.110 dB) of the insertion loss of the resonance structure of FIG. 11 at 2.050 GHz is close to the absolute value (6.254 dB) of the insertion loss of the single resonance network of FIG. 9 at 2.040 GHz. It can be seen that a suppression frequency point of the resonance structure of FIG. 11 is almost the same as a suppression frequency point of the single resonance network of FIG. 5, a suppression frequency point of the single resonance network of FIG. 7, and a suppression frequency point of the single resonance network of FIG. 9.

Therefore, a resonance structure formed after a plurality of single resonance networks are simply connected in series cannot significantly change or increase suppression frequency points, and can only broaden a suppressed bandwidth frequency. In addition, an absolute value of an insertion loss of the resonance structure is greater than a sum of absolute values of insertion losses of the single resonance networks.

### Example 3

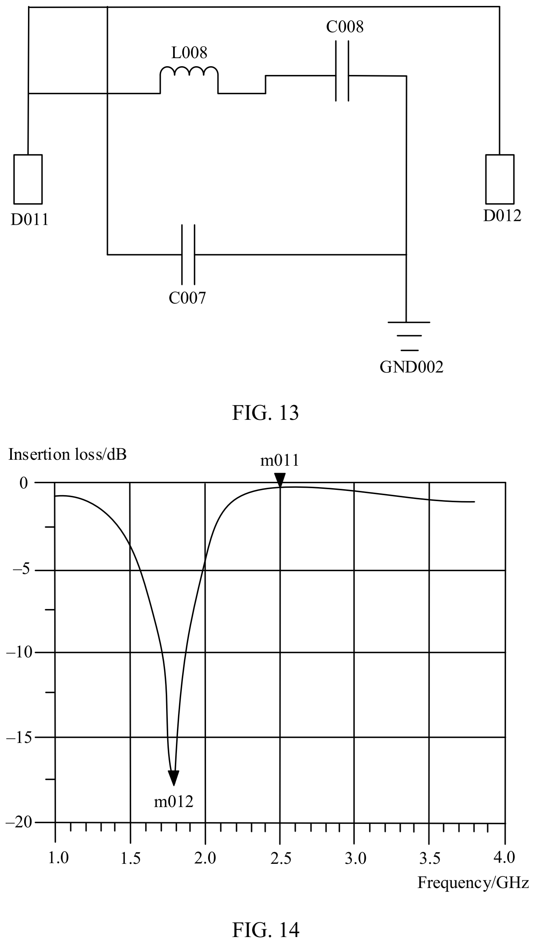

FIG. 13 shows a single resonance network in the related technology. FIG. 14 correspondingly shows a schematic diagram of a relationship between an insertion loss and frequency of the single resonance network in FIG. 13.

As shown in FIG. 13, the resonance structure includes a port D011, a capacitor C007, an inductor L008, a capacitor C008, a port D012, and a ground GND002. A first end of the capacitor C007 is separately electrically connected to a first end of the inductor L008, the port D011, and the port D012. A second end of the capacitor C007 is separately electrically connected to a second end of the capacitor C008, and is connected to the ground GND002. A second end of the inductor L008 is electrically connected to a first end of the capacitor C008.

For a schematic diagram of a relationship between an insertion loss and frequency of the single resonance network in FIG. 13, refer to FIG. 14. As shown in FIG. 14, an insertion loss of the single resonance network of FIG. 13 at an m011 point, namely at 2.490 GHz is -0.278 dB. Therefore, an absolute value of the insertion loss at 2.490 GHz is 0.278 dB.

As further shown in FIG. 14, an insertion loss of the single resonance network of FIG. 13 at an m012 point, namely at 1.800 GHz is -17.399 dB. Therefore, an absolute value of the insertion loss at 1.800 GHz is 17.399 dB.

The foregoing results indicate that the single resonance network of FIG. 13 can suppress a suppression frequency point of a frequency of approximately 1.800 GHz, but cannot suppress a bandwidth frequency of 1.710 to 2.170 GHz.

Through calculation, a sum of the absolute value (0.282 dB) of the insertion loss of the resonance network of FIG. 5 at 2.490 GHz, the absolute value (0.177 dB) of the insertion loss of the resonance network of FIG. 9 at 2.490 GHz, and the absolute value (0.278 dB) of the insertion loss of the resonance network of FIG. 13 at 2.490 GHz is 0.737 dB (0.282 dB+0.177 dB+0.278 dB=0.737 dB).

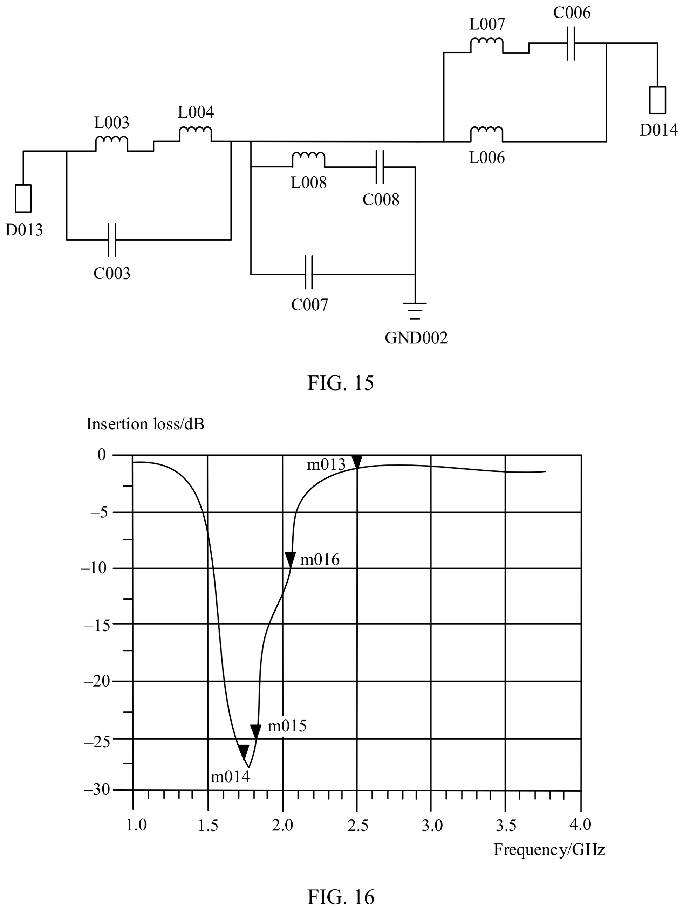

The resonance network of FIG. 5, the resonance network of FIG. 9, and the resonance network of FIG. 13 are stacked and combined in parallel and series, to obtain a resonance structure shown in FIG. 15. FIG. 16 correspondingly shows a schematic diagram of a relationship between an insertion loss and frequency of the resonance structure in FIG. 15.

As shown in FIG. 15, the resonance structure includes a port D013, a capacitor C003, an inductor L003, an inductor L004, a capacitor C007, an inductor L008, a capacitor C008, an inductor L006, an inductor L007, a capacitor C006, a port D014, and a ground GND002. A first end of the capacitor C003 is separately electrically connected to a first end of the inductor L003 and the port D013. A second end of the capacitor C003 is separately electrically connected to a first end of the inductor L004, a first end of the inductor L006, a first end of the inductor L007, a first end of the inductor L008, and a first end of the capacitor C007. A second end of the inductor L003 is electrically connected to a first end of the inductor L004. A second end of the inductor L008 is electrically connected to a first end of the capacitor C008. A second end of the capacitor C007 is electrically connected to a second end of the capacitor C008, and is connected to the ground GND002. A second end of the inductor L006 is electrically connected to a second end of the capacitor C006 and the port D014. A second end of the inductor L007 is electrically connected to a first end of the capacitor C006.

For a schematic diagram of a relationship between an insertion loss and frequency of the resonance structure of FIG. 15, refer to FIG. 16. As shown in FIG. 16, an insertion loss of the resonance structure at an m013 point, namely at 2.490 GHz is - 0.758 dB. Therefore, an absolute value of the insertion loss at 2.490 GHz is 0.758 dB.

As further shown in FIG. 16, an insertion loss of the resonance structure of FIG. 15 at an m014 point, namely at 1.720 GHz is -27.463 dB. Therefore, an absolute value of the insertion loss at 1.720 GHz is 27.463 dB. An insertion loss at an m015 point, namely at 1.820 GHz is -25.428 dB. Therefore, an absolute value of the insertion loss at 1.820 GHz is 25.428 dB. An insertion loss at an m016 point, namely at 2.050 GHz is -10.296 dB. Therefore, an absolute value of the insertion loss at 2.050 GHz is 10.296 dB.

The foregoing results indicate that the resonance structure of FIG. 15 may suppress a bandwidth frequency of 1.710 to 2.170 GHz.

However, the absolute value of the insertion loss of the resonance structure of FIG. 15 at 2.490 GHz is 0.758 dB, while the sum of the absolute value (0.282 dB) of the insertion loss of the resonance network of FIG. 5 at 2.490 GHz, the absolute value (0.177 dB) of the insertion loss of the resonance network of FIG. 9 at 2.490 GHz, and the absolute value (0.278 dB) of the insertion loss of the resonance network of FIG. 13 at 2.490 GHz is 0.737 dB, where 0.758 dB is greater than 0.737 dB. To be specific, the absolute value of the insertion loss of the resonance structure of FIG. 15 obtained after the resonance network of FIG. 5, the resonance network of FIG. 9, and the resonance network of FIG. 13 are simply connected in parallel or connected in series and parallel is greater than the sum of the absolute values of the insertion losses of a plurality of single resonance networks.

In addition, the absolute value (27.463 dB) of the insertion loss of the resonance structure of FIG. 15 at 1.720 GHz is close to the absolute value (11.572 dB) of the insertion loss of the single resonance network of FIG. 5 at 1.720 GHz. The absolute value (25.428 dB) of the insertion loss of the resonance structure ofFIG. 15 at 1.820 GHz is close to the absolute value (17.399 dB) of the insertion loss of the single resonance network of FIG. 13 at 1.800 GHz. The absolute value (10.296 dB) of the insertion loss of the resonance structure of FIG. 155 at 2.050 GHz is close to the absolute value (6.254 dB) of the insertion loss of the single resonance network of FIG. 9 at 2.040 GHz. Therefore, a suppression frequency point of the resonance structure of FIG. 15 is almost the same as a suppression frequency point of the single resonance network of FIG. 5, a suppression frequency point of the single resonance network of FIG. 13, and a suppression frequency point of the single resonance network of FIG. 9.

Therefore, a resonance structure formed after a plurality of single resonance networks are simply connected in series and parallel cannot significantly change or increase suppression points, and can only broaden a bandwidth frequency to be suppressed. In addition, an absolute value of an insertion loss of the resonance structure is greater than a sum of absolute values of insertion losses of the single resonance networks, and an effect of the resonance structure is influenced.

Therefore, it can be seen based on the foregoing three examples that in the related technology, it is very difficult to achieve suppression frequency broadening, proper suppression frequency point depth, and the like of an entire resonance structure by using a single resonance network. A plurality of resonance networks are connected in series and/or parallel in a channel by using an element with a particular Q value (quality factor), a plurality of resonance points are obtained by stacking and combining the plurality of resonance networks, and frequency broadening, frequency point suppression, and the like of the entire resonance structure are implemented by using the plurality of resonance points. However, in a solution that a plurality of resonance networks are simply connected in series and/or parallel to implement an entire resonance structure in the related technology, an insertion loss of the entire resonance structure is far greater than a sum of insertion losses of all single resonance networks. To be specific, an overall channel insertion loss of the resonance structure is greatly increased as a quantity of the resonance networks is increased (resonance frequency points are increased). In addition, the plurality of resonance networks may have a frequency response to a same frequency, resulting in degradation of consistency of the entire resonance structure.

In view of this, this application provides a resonance structure. The resonance structure includes at least a first resonance structure. A resonance superposition mode with a non-serial structure is created by mutually nesting a plurality of levels of resonance networks in the first resonance structure, so that an insertion loss obtained after superposing the plurality of resonance networks is not simply serial addition. Instead, by means of mutual influence among the plurality of levels of resonance networks, an insertion loss in a passband of the resonance structure may not be increased as resonance frequency points are increased. In addition, because of mutual influence among the plurality of levels of resonance networks in the first resonance structure, multi-frequency point resonance can be formed at a particular required frequency point, thereby broadening a suppression band of the first resonance structure.

Further, when any one of a filter, a combiner, a notch filter, a duplexer, and a multiplexer in a radio frequency system has the resonance structure, the device such as the combiner, the notch filter, the duplexer, and the multiplexer has a relatively wide suppression band, and an insertion loss may not be increased as resonance frequency points are increased.

Furthermore, an electronic device having the foregoing radio frequency system has a good performance.

Only content related to the present disclosure is described herein, and reference may be made to the following for other content.

**The following describes a resonance structure provided in an embodiment of this application in detail.**

This embodiment of this application provides a resonance structure, including at least a first resonance structure. The first resonance structure includes at least three levels of resonance networks. The respective levels of resonance networks among the at least three levels of resonance networks are electrically connected in series and/or parallel. The respective levels of resonance networks influence each other, so that a frequency point and frequency point depth of the first resonance structure are different from a frequency point and frequency point depth of at least one level of resonance network among the respective levels of resonance networks.

That the resonance structure includes at least a first resonance structure means that: The resonance structure may include only the first resonance structure. Alternatively, in addition to the first resonance structure, the resonance structure may further include another resonance structure. This is not specifically limited herein.

That the first resonance structure includes at least three levels of resonance networks means that: The first resonance structure may include only three levels of resonance networks. Alternatively, in addition to the three levels of resonance networks, the first resonance structure may further include another resonance network. This is not specifically limited herein.

In the resonance structure provided in this embodiment of this application, a resonance superposition mode with a non-serial structure is created at least by mutually nesting a plurality of levels of resonance networks in the first resonance structure, so that an insertion loss obtained after superposing the plurality of resonance networks is not simply serial addition. Instead, by means of mutual influence among the plurality of levels of resonance networks, an insertion loss in a passband of the resonance structure may not be increased as resonance frequency points are increased. In addition, because of mutual influence among the plurality of levels of resonance networks in the first resonance structure, multi-frequency point resonance can be formed at a particular required frequency point, thereby broadening a suppression band of the first resonance structure.

### Embodiment 1

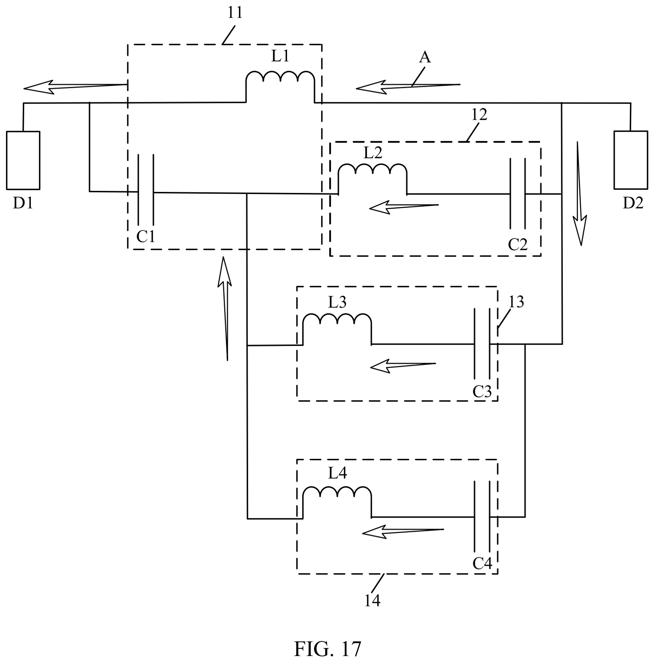

Optionally, as an implementable manner, referring to FIG. 17, a case of a first resonance structure according to an embodiment of this application is specifically described.

As shown in FIG. 17, the resonance structure includes: a first port D1, a first-level resonance network 11, a second-level resonance network 12, a third-level resonance network 13, a fourth-level resonance network 14, and a second port D2.

The first-level resonance network 11 includes a first inductor L1 and a first capacitor C1, and the first inductor L1 is connected in parallel to the first capacitor C1. The second-level resonance network 12 includes a second inductor L2 and a second capacitor C2, and the second inductor L2 is connected in series to the second capacitor C2. The third-level resonance network 13 includes a third inductor L3 and a third capacitor C3, and the third inductor L3 is connected in series to the third capacitor C3. The fourth-level resonance network 14 includes a fourth inductor L4 and a fourth capacitor C4, and the fourth inductor L4 is connected in series to the fourth capacitor C4. In addition, after being connected in parallel to the third-level resonance network 13 and the second-level resonance network 12, the fourth-level resonance network 14 is connected in series to the first capacitor C1 in the first-level resonance network 11, and then is connected in parallel to the first inductor L1 in the first-level resonance network 11.

Specifically, as shown in FIG. 17, a first end of the first capacitor C1 is separately electrically connected to a first end of the first inductor L1 and the first port D1. A second end of the first capacitor C1 is separately electrically connected to a first end of the second inductor L2, a first end of the third inductor L3, and a first end of the fourth inductor L4. A second end of the second inductor L2 is electrically connected to a first end of the second capacitor C2. A second end of the third inductor L3 is electrically connected to a first end of the third capacitor C3. A second end of the fourth inductor L4 is electrically connected to a first end of the fourth capacitor C4. A second end of the first inductor L1 is separately electrically connected to a second end of the second capacitor C2, a second end of the third capacitor C3, a second end of the fourth capacitor C4, and the second port D2.

In an application, capacitance values of the foregoing capacitors may be determined according to a frequency of a radio frequency signal in a radio frequency system, provided that the capacitance values can satisfy normal passage of the radio frequency signal. The capacitors may implement the normal passage of the radio frequency signal, to block passage of a direct current voltage.

Inductance values of the foregoing inductors should be set as large as possible. The magnitude of the inductance values may alternatively be determined according to the frequency of the radio frequency signal in the radio frequency system. It is proper to form a good resistance to the radio frequency signal. Therefore, the inductors can implement the normal passage of the direct current voltage and block the passage of the radio frequency signal.

It should be understood that structures and the like of the foregoing inductors are not specifically limited. For example, the inductors may include a sheet coil, a hollow coil, and the like.

In an actual application, a capacitance value of the first capacitor C1 in FIG. 17 may be 3.0 pF. An inductance value of the first inductor L1 may be 3.0 nH. A capacitance value of the second capacitor C2 may be 3.0 pF. An inductance value of the second inductor L2 may be 2.0 nH. A capacitance value of the third capacitor C3 may be 2.7 pF. An inductance value of the third inductor L3 may be 2.4 nH. A capacitance value of the fourth capacitor C4 may be 3.0 pF. An inductance value of the fourth inductor L4 may be 3.0 nH. Certainly, the capacitance value of each capacitor and the inductance value of each inductor are not limited thereto. This is not specifically limited herein.

It should be understood that FIG. 17 further shows an electrical signal direction A of the resonance structure.

As shown in FIG. 17, an electrical signal transmitted by the second port D2 may be transmitted to the first port D1 through a plurality of paths. Specifically, the electrical signal may be transmitted to the first port D1 along a path of the first inductor L1. The electrical signal may further be transmitted to the first port D1 along paths of the second capacitor C2, the second inductor L2, and the first capacitor C1. The electrical signal may further be transmitted to the first port D1 along paths of the third capacitor C3, the third inductor L3, and the first capacitor C1. The electrical signal may further be transmitted to the first port D1 along paths of the fourth capacitor C4, the fourth inductor L4, and the first capacitor C1. Certainly, this application is not limited thereto. This is not specifically limited herein.

Therefore, any one of the second-level resonance network 12, the third-level resonance network 13, and the fourth-level resonance network 14 in FIG. 17 may be separately constructed with the first-level resonance network 11 as a resonance network, and the first-level resonance network 11, the second-level resonance network 12, the third-level resonance network 13, and the fourth-level resonance network 14 further influence each other.

It should be noted that the first-level resonance network 11 may be used as a primary resonance network, and mainly influences a notch filter depth of an overall passband of the first resonance structure.

The following specifically describes a relationship between an insertion loss and frequency of the plurality of resonance networks in the first resonance structure shown in FIG. 17.

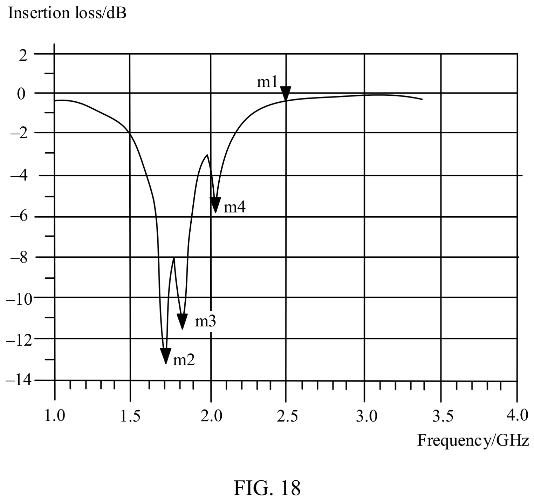

For a schematic diagram of a relationship between an insertion loss and frequency of the resonance structure in FIG. 17, refer to FIG. 18. As shown in FIG. 18, an insertion loss of the resonance structure of FIG. 17 at an m1 point, namely at 2.490 GHz is -0.413 dB. Therefore, an absolute value of the insertion loss at 2.490 GHz is 0.413 dB.

As further shown in FIG. 18, an insertion loss of the resonance structure of FIG. 17 at an m2 point, namely at 1.720 GHz is -13.989 dB. Therefore, an absolute value of the insertion loss at 1.720 GHz is 13.989 dB. An insertion loss at an m3 point, namely at 1.820 GHz is -11.266 dB. Therefore, an absolute value of the insertion loss at 1.820 GHz is 11.266 dB. An insertion loss at an m4 point, namely at 2.050 GHz is - 5.942 dB. Therefore, an absolute value of the insertion loss at 2.050 GHz is 5.942 dB.

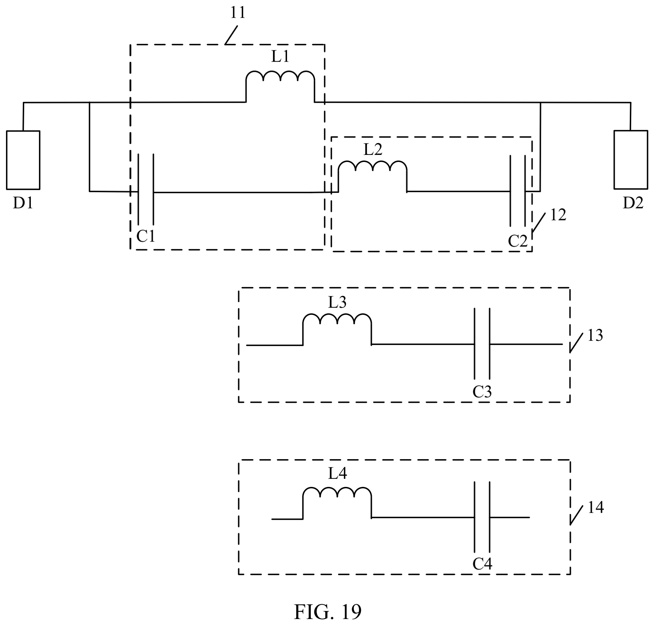

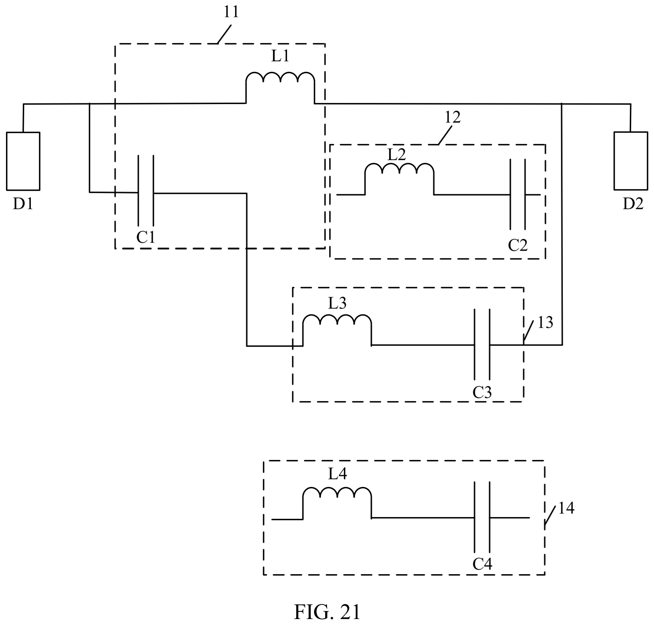

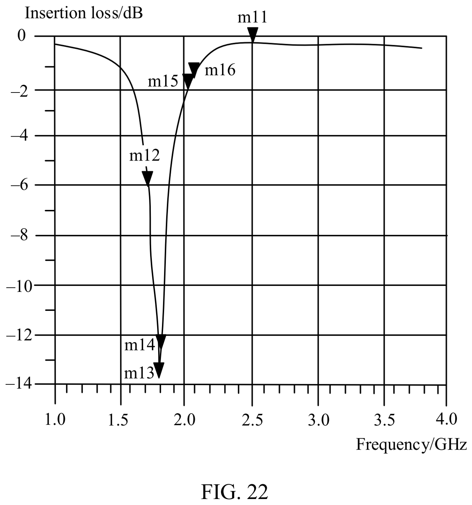

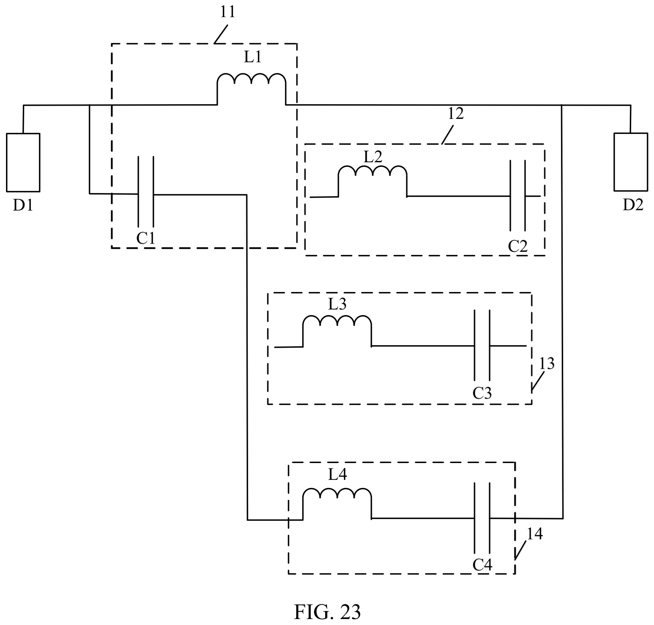

The foregoing results indicate that the resonance structure of FIG. 17 can suppress a bandwidth frequency of 1.710 to 2.170 GHz.
1. The following compares the resonance structure of FIG. 17 with the resonance network of FIG. 19, the resonance network of FIG. 21, and the resonance network of FIG. 23 to describe an insertion loss situation of the resonance structure of FIG. 17 provided by this embodiment of this application. FIG. 19 shows a schematic diagram of combining a first-level resonance network 11 and a second-level resonance network 12. FIG. 21 shows a schematic diagram of combining a first-level resonance network 11 and a third-level resonance network 13. FIG. 22 shows a schematic diagram of combining a first-level resonance network 11 and a fourth-level resonance network 14. The diagrams are described one by one below.

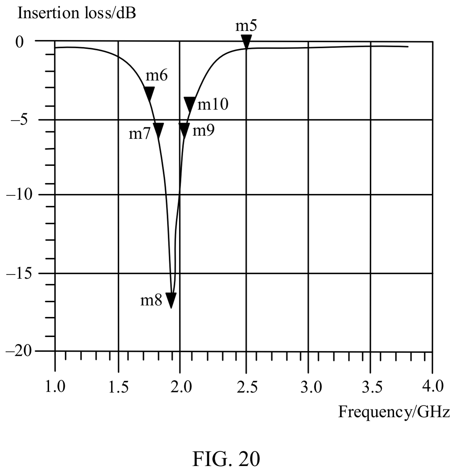

1) With reference to FIG. 19, FIG. 20 correspondingly shows a schematic diagram of a relationship between an insertion loss and frequency of a resonance network in FIG. 19. The third-level resonance network 13 and the fourth-level resonance network 14 are not connected to the resonance network shown in FIG. 19.

As shown in FIG. 19, the resonance network includes a first port D1, a first capacitor C1, a first inductor L1, a second inductor L2, a second capacitor C2, and a second port D2.

A first end of the first capacitor C1 is separately electrically connected to a first end of the first inductor L1 and the first port D1. A second end of the first capacitor C1 is electrically connected to a first end of the second inductor L2. A second end of the second inductor L2 is electrically connected to a first end of the second capacitor C2. A second end of the second capacitor C2 is separately electrically connected to a second end of the first inductor L1 and the second port D2.

As shown in FIG. 20, an insertion loss of the resonance network of FIG. 19 at an m5 point, namely at 2.490 GHz is -0.349 dB. Therefore, an absolute value of the insertion loss at 2.490 GHz is 0.349 dB.

As further shown in FIG. 20, an insertion loss of the resonance network of FIG. 19 at an m6 point, namely at 1.720 GHz is -3.132 dB. Therefore, an absolute value of the insertion loss at 1.720 GHz is 3.132 dB. An insertion loss at an m7 point, namely at 1.820 GHz is -6.785 dB. Therefore, an absolute value of the insertion loss at 1.820 GHz is 6.785 dB. An insertion loss at an m8 point, namely at 1.920 GHz is -16.691 dB. Therefore, an absolute value of the insertion loss at 1.920 GHz is 16.691 dB. An insertion loss at an m9 point, namely at 2.020 GHz is -6.294 dB. Therefore, an absolute value of the insertion loss at 2.020 GHz is 6.294 dB. An insertion loss at an m10 point, namely at 2.050 GHz is -4.887 dB. Therefore, an absolute value of the insertion loss at 2.050 GHz is 4.887 dB.

The foregoing results indicate that the resonance network of FIG. 19 can suppress a frequency around 1.920 GHz, but has a poor suppression effect on other frequencies in the range of 1.710 to 2.170 GHz.

2) With reference to FIG. 21, FIG. 22 correspondingly shows a schematic diagram of a relationship between an insertion loss and frequency of a resonance network in FIG. 21. The second-level resonance network 12 and the fourth-level resonance network 14 are not connected to the resonance network shown in FIG. 21.

As shown in FIG. 21, the resonance network includes a first port D1, a first capacitor C1, a first inductor L1, a third inductor L3, a third capacitor C3, and a second port D2.

A first end of the first capacitor C1 is separately electrically connected to a first end of the first inductor L1 and the first port D1. A second end of the first capacitor C1 is electrically connected to a first end of the third inductor L3. A second end of the third inductor L3 is electrically connected to a first end of the third capacitor C3. A second end of the third capacitor C3 is separately electrically connected to a second end of the first inductor L1 and the second port D2.

As shown in FIG. 22, an insertion loss of the resonance network of FIG. 21 at an m11 point, namely at 2.490 GHz is -0.208 dB. Therefore, an absolute value of the insertion loss at 2.490 GHz is 0.208 dB.

As further shown in FIG. 22, an insertion loss of the resonance network of FIG. 21 at an m12 point, namely at 1.720 GHz is -6.254 dB. Therefore, an absolute value of the insertion loss at 1.720 GHz is 6.254 dB. An insertion loss at an m13 point, namely at 1.800 GHz is -13.472 dB. Therefore, an absolute value of the insertion loss at 1.800 GHz is 13.472 dB. An insertion loss at an m14 point, namely at 1.820 GHz is -12.361 dB. Therefore, an absolute value of the insertion loss at 1.820 GHz is 12.361 dB. An insertion loss at an m15 point, namely at 2.020 GHz is -1.464 dB. Therefore, an absolute value of the insertion loss at 2.020 GHz is 1.464 dB. An insertion loss at an m16 point, namely at 2.050 GHz is -1.230 dB. Therefore, an absolute value of the insertion loss at 2.050 GHz is 1.230 dB.

The foregoing results indicate that the resonance network of FIG. 21 can suppress a frequency around 1.800 GHz, but has a poor suppression effect on other frequencies in the range of 1.710 to 2.170 GHz.

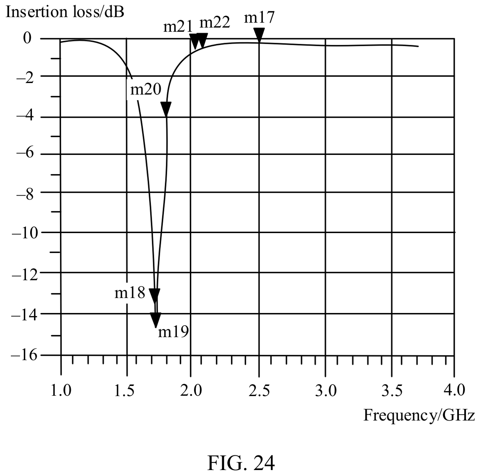

3) With reference to FIG. 23, FIG. 24 correspondingly shows a schematic diagram of a relationship between an insertion loss and frequency of a resonance network in FIG. 23. The second-level resonance network 12 and the third-level resonance network 13 are not connected to the resonance network shown in FIG. 23.

As shown in FIG. 23, the resonance network includes a first port D1, a first capacitor C1, a first inductor L1, a fourth inductor L4, a fourth capacitor C4, and a second port D2.

A first end of the first capacitor C1 is separately electrically connected to a first end of the first inductor L1 and the first port D1. A second end of the first capacitor C1 is electrically connected to a first end of the fourth inductor L4. A second end of the fourth inductor L4 is electrically connected to a first end of the fourth capacitor C4. A second end of the fourth capacitor C4 is separately electrically connected to a second end of the first inductor L1 and the second port D2.

As shown in FIG. 24, an insertion loss of the resonance network of FIG. 23 at an m17 point, namely at 2.490 GHz is -0.106 dB. Therefore, an absolute value of the insertion loss at 2.490 GHz is 0.106 dB.

As further shown in FIG. 24, an insertion loss of the resonance network of FIG. 23 at an m18 point, namely at 1.720 GHz is -14.995 dB. Therefore, an absolute value of the insertion loss at 1.720 GHz is 14.995 dB. An insertion loss at an m19 point, namely at 1.730 GHz is -15.031 dB. Therefore, an absolute value of the insertion loss at 1.730 GHz is 15.031 dB. An insertion loss at an m20 point, namely at 1.820 GHz is -3.943 dB. Therefore, an absolute value of the insertion loss at 1.820 GHz is 3.943 dB. An insertion loss at an m21 point, namely at 2.020 GHz is -0.420 dB. Therefore, an absolute value of the insertion loss at 2.020 GHz is 0.420 dB. An insertion loss at an m22 point, namely at 2.050 GHz is -0.382 dB. Therefore, an absolute value of the insertion loss at 2.050 GHz is 0.382 dB.

The foregoing results indicate that the resonance network of FIG. 23 can suppress a frequency around 1.730 GHz, but has a poor suppression effect on other frequencies in the range of 1.710 to 2.170 GHz.

Through calculation, a sum of the absolute value (0.349 dB) of the insertion loss of the resonance network of FIG. 19 at 2.490 GHz, the absolute value (0.208 dB) of the insertion loss of the resonance network of FIG. 21 at 2.490 GHz, and the absolute value (0.106 dB) of the insertion loss of the resonance network of FIG. 23 at 2.490 GHz is 0.743 dB (0.106 dB+0.208 dB+0.349 dB=0.663 dB).

It can be seen that according to this embodiment of this application, the absolute value of the insertion loss of the resonance structure of FIG. 17 at 2.490 GHz is 0.413 dB, which is less than the sum (0.663 dB) of the absolute value (0.349 dB) of the insertion loss of the resonance network of FIG. 19 at 2.490 GHz, the absolute value (0.208 dB) of the insertion loss of the resonance network of FIG. 21 at 2.490 GHz, and the absolute value (0.106 dB) of the insertion loss of the resonance network of FIG. 23 at 2.490 GHz. To be specific, an absolute value of an insertion loss of the first resonance structure provided in this embodiment of this application is less than a sum of absolute values of insertion losses of the respective levels of resonance networks.

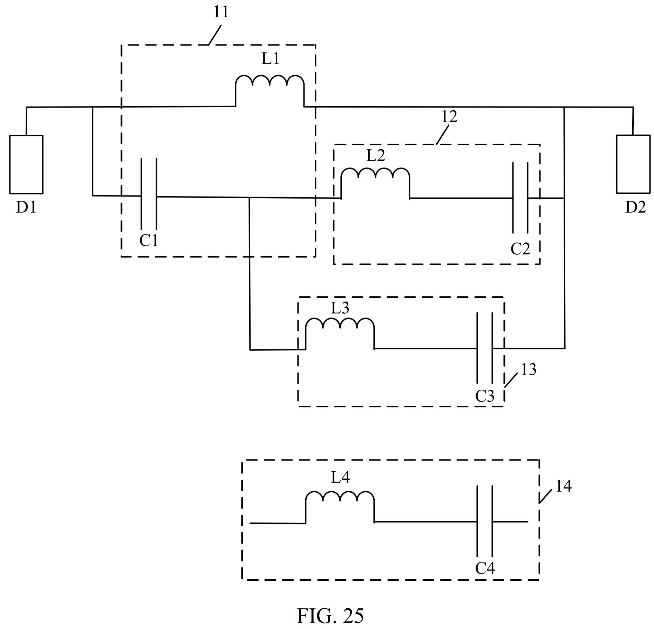

2. Referring to the resonance network of FIG. 19, the resonance network of FIG. 25, and the resonance structure of FIG. 17 sequentially, the resonance structure of FIG. 17 is compared with the resonance network of FIG. 19 and the resonance network of FIG. 25, to describe an insertion loss situation of the first resonance structure of FIG. 17 provided by this embodiment of this application.

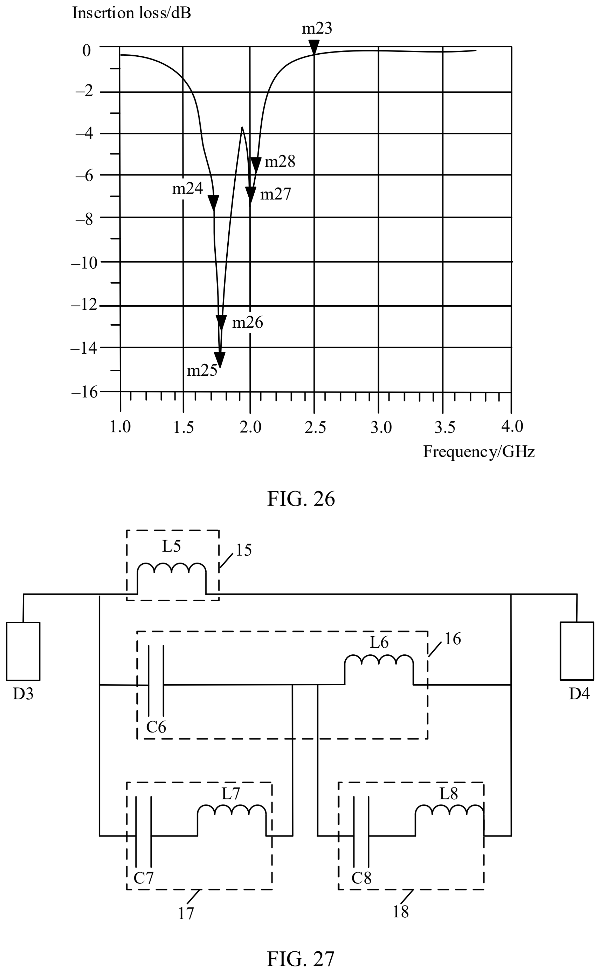

1) FIG. 25 shows a schematic diagram of combining a first-level resonance network 11, a second-level resonance network 12, and a third-level resonance network 13. FIG. 26 correspondingly shows a schematic diagram of a relationship between an insertion loss and frequency of the resonance network in FIG. 25. The fourth-level resonance network 14 is not connected to the resonance network shown in FIG. 25.

As shown in FIG. 25, the resonance network includes a first port D1, a first capacitor C1, a first inductor L1, a second inductor L2, a second capacitor C2, a third inductor L3, a third capacitor C3, and a second port D2.

A first end of the first capacitor C1 is separately electrically connected to a first end of the first inductor L1 and the first port D1. A second end of the first capacitor C1 is separately electrically connected to a first end of the second inductor L2 and a first end of the third inductor L3. A second end of the second inductor L2 is electrically connected to a first end of the second capacitor C2. A second end of the third inductor L3 is electrically connected to a first end of the third capacitor C3. A second end of the third capacitor C3 is separately electrically connected to a second end of the second capacitor C2, a second end of the first inductor L1, and the second port D2.

As shown in FIG. 26, an insertion loss of the resonance network of FIG. 25 at an m23 point, namely at 2.490 GHz is -0.395 dB. Therefore, an absolute value of the insertion loss at 2.490 GHz is 0.395 dB.

As further shown in FIG. 26, an insertion loss of the resonance network of FIG. 25 at an m24 point, namely at 1.720 GHz is -7.667 dB. Therefore, an absolute value of the insertion loss at 1.720 GHz is 7.667 dB. An insertion loss at an m25 point, namely at 1.800 GHz is -14.997 dB. Therefore, an absolute value of the insertion loss at 1.800 GHz is 14.997 dB. An insertion loss at an m26 point, namely at 1.820 GHz is -13.091 dB. Therefore, an absolute value of the insertion loss at 1.820 GHz is 13.091 dB. An insertion loss at an m27 point, namely at 2.020 GHz is -7.340 dB. Therefore, an absolute value of the insertion loss at 2.020 GHz is 7.340 dB. An insertion loss at an m28 point, namely at 2.050 GHz is -5.964 dB. Therefore, an absolute value of the insertion loss at 2.050 GHz is 5.964 dB.

The foregoing results indicate that the resonance network of FIG. 25 can suppress a frequency around 1.800 GHz or 2.020GHz, but has a poor suppression effect on other frequencies in the range of 1.710 to 2.170 GHz.

It can be seen that, from the resonance network of FIG. 19 and the resonance network of FIG. 25 to the first resonance structure of FIG. 17, the respective levels of resonance networks are added level by level, so that response frequency points are pulled relative to each other. It can be seen that the plurality of levels of resonance networks in the first resonance structure of FIG. 17 are nested with each other, but the plurality of levels of resonance networks are simply connected in series and/or parallel to generate an influence.

2) Alternatively, the first-level resonance network 11, the second-level resonance network 12, and the fourth-level resonance network 14 may be combined. Details are not described herein again.

3) Alternatively, the first-level resonance network 11, the third-level resonance network 13, and the fourth-level resonance network 14 may be combined. Details are not described herein again.

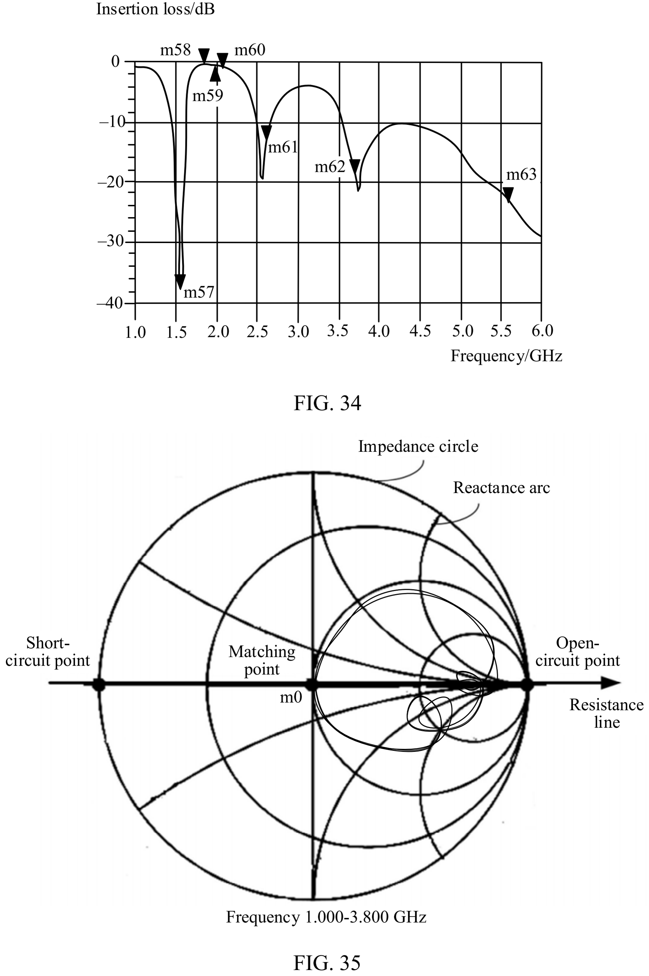

FIG. 35 is a schematic diagram of a simplified Smith chart. The following briefly describes the Smith chart in FIG. 35.

As shown in FIG. 35, the Smith chart includes a resistance line, impedance circles, and reactance arcs. A plurality of tangent circles are the impedance circles. The resistance line is a horizontal axis. A left intersection of a largest impedance circle and the resistance line is a short-circuit point, a right intersection of the largest impedance circle and the resistance line is an open-circuit point, and the center of the circle is a matching point. An arc radiating from the open-circuit point to a circumference is a reactance arc.

Each point in the Smith chart represents an impedance value in a complex form. Impedance refers to resistance of a circuit to a point, and consists of a real resistance and an imaginary reactance. The impedance circle is an equal real line, which may alternatively be referred to as an equal resistance line, and resistance of all points thereon is equal. The resistance line and the reactance arc are equal imaginary lines, which may alternatively be referred to as equal reactance lines, and reactance of all points thereon is not positive or negative. A part above the resistance line is referred to as an inductance region, and reactance of all points thereon is positive. A part below the resistance line is referred to as a capacitance region, and reactance of all points thereon is negative.

For example, the resistance of the short-circuit point in FIG. 35 may be 0 ohm, and the reactance may be 0 ohm. The resistance of the open-circuit point may be infinity, and the reactance may be 0 ohm. The resistance of the matching point may be 50 ohm, and the reactance may be 0 ohm.

In addition, the Smith chart further includes a plurality of admittance circles (not shown in the figure) and a plurality of susceptance arcs (not shown in the figure). Conductance of all points on each admittance circle is equal. Susceptance of all points on each susceptance arc is equal. The Smith chart is usually used for impedance matching between resonance structures. The impedance matching means that an input impedance and an output impedance are approximately equal and in opposite directions. In this way, the resonance structure can operate normally with high efficiency. If the impedance between the resonance structures is not matched, the operating efficiency of the resonance structure is low. In severe case, the resonance structure may even operate exceptionally or be directly burned out. A process of performing impedance matching in the Smith chart is to determine, according to a matching point and an impedance point of a resonance structure at a frequency, a matching circuit to be connected to pull the resonance structure from the impedance point of the frequency to the matching point and a connection manner.

It should be noted that in this embodiment of this application, it is not strictly limited that the resonance structure operates at the open-circuit point, the short-circuit point, and the matching point of the Smith chart, but the resonance structure operates near the open-circuit point, near the short-circuit point, and near the matching point.

As shown in FIG. 35, in the Smith chart, a frequency of an m0 point is 3.580 GHz.

In the first resonance structure provided in this embodiment of this application, a plurality of levels of resonance networks are nested with each other, to form an overall single-level multi-resonance structure. The respective levels of resonance networks in the single-level multi-resonance structure influence each other, and a resonance superposition mode with a non-serial structure is created, so that an insertion loss obtained after superposing the plurality of resonance networks is not simply serial addition. Instead, by means of mutual influence among the plurality of levels of resonance networks, an insertion loss in a passband of the resonance structure may not be increased as resonance frequency points are increased. To be specific, an insertion loss obtained after a plurality of resonance cavities are superposed hardly increases, and may be smaller. In addition, because of mutual influence among the plurality of levels of resonance networks in the single-level multi-resonance structure, multi-frequency point resonance can be formed by the first resonance structure at a particular required frequency point, thereby broadening an application of the first resonance structure.

Therefore, an embodiment of this application provides a high-performance first resonance structure. A passband impedance of the first resonance structure may be close to 50 ohm.

In the foregoing Embodiment 1, the following structural deformation may further be performed.

Optionally, after the first inductor L1 and the first capacitor C1 are connected in series, the first-level resonance network 11, the second-level resonance network 12, the third-level resonance network 13, and the fourth-level resonance network 14 form different first resonance structures.

Optionally, after the second inductor L2 and the second capacitor C2 are connected in parallel, the second-level resonance network 12, the first-level resonance network 11, the third-level resonance network 13, and the fourth-level resonance network 14 form different first resonance structures.

Optionally, after the third inductor L3 and the third capacitor C3 are connected in parallel, the third-level resonance network 13, the first-level resonance network 11, the second-level resonance network 12, and the fourth-level resonance network 14 form different first resonance structures.

Optionally, after the fourth inductor L4 and the fourth capacitor C4 are connected in parallel, the fourth-level resonance network 14, the first-level resonance network 11, the second-level resonance network 12, and the third-level resonance network 13 form different first resonance structures.

Optionally, after positions of the first inductor L1 and the first capacitor C1 are interchanged, the first-level resonance network 11, the second-level resonance network 12, the third-level resonance network 13, and the fourth-level resonance network 14 form different first resonance structures.

Optionally, after positions of the second inductor L2 and the second capacitor C2 are interchanged, the second-level resonance network 12, the first-level resonance network 11, the third-level resonance network 13, and the fourth-level resonance network 14 form different first resonance structures.

Optionally, after positions of the third inductor L3 and the third capacitor C3 are interchanged, the third-level resonance network 13, the first-level resonance network 11, the second-level resonance network 12, and the fourth-level resonance network 14 form different first resonance structures.

Optionally, after positions of the fourth inductor L4 and the fourth capacitor C4 are interchanged, the fourth-level resonance network 14, the first-level resonance network 11, the second-level resonance network 12, and the third-level resonance network 13 form different first resonance structures.

Certainly, this application is not limited thereto. This is not specifically described one by one herein.

### Embodiment 2

Optionally, as an implementable manner, referring to FIG. 27, a case of a first resonance structure according to an embodiment of this application is specifically described.

As shown in FIG. 27, the resonance structure includes: a third port D3, a fifth-level resonance network 15, a sixth-level resonance network 16, a seventh-level resonance network 17, an eighth-level resonance network 18, and a fourth port D4.

The fifth-level resonance network 15 includes a fifth inductor L5. The sixth-level resonance network 16 includes a sixth capacitor C6 and a sixth inductor L6, and the sixth capacitor C6 is connected in series to the sixth inductor L6. The seventh-level resonance network 17 includes a seventh capacitor C7 and a seventh inductor L7, and the seventh capacitor C7 is connected in series to the seventh inductor L7. The eighth-level resonance network 18 includes an eighth capacitor C8 and an eighth inductor L8, and the eighth capacitor C8 is connected in series to the eighth inductor L8. In addition, the fifth-level resonance network 15 is connected in parallel to the sixth-level resonance network 16. The seventh-level resonance network 17 is connected in parallel to two ends of the sixth capacitor C6 in the sixth-level resonance network 16. The eighth-level resonance network 18 is connected in parallel to two ends of the sixth inductor L6 in the sixth-level resonance network 16.

Specifically, as shown in FIG. 27, a first end of the fifth inductor L5 is separately electrically connected to a first end of the sixth capacitor C6, a first end of the seventh capacitor C7, and the third port D3. A second end of the fifth inductor L5 is separately electrically connected to a second end of the sixth inductor L6, a second end of the eighth inductor L8, and the fourth port D4. A second end of the sixth capacitor C6 is separately electrically connected to a first end of the sixth inductor L6, a second end of the seventh inductor L7, and a first end of the eighth capacitor C8. A second end of the seventh capacitor C7 is electrically connected to a first end of the seventh inductor L7. A second end of the eighth capacitor C8 is electrically connected to a first end of the eighth inductor L8.

In an actual application, in FIG. 27, an inductance value of the fifth inductor L5 may be 3.0 nH. A capacitance value of the sixth capacitor C6 may be 1.2 pF. An inductance value of the sixth inductor L6 may be 2.0 nH. A capacitance value of the seventh capacitor C7 may be 0.5 pF. An inductance value of the seventh inductor L7 may be 5.1 nH. A capacitance value of the eighth capacitor C8 may be 1.8 pF. An inductance value of the eighth inductor L8 may be 1.5 nH. Certainly, the capacitance value of each capacitor and the inductance value of each inductor are not limited thereto. This is not specifically limited herein.

It should be noted that the third port D3 and the fourth port D4 in FIG. 27 may be the same as or different from the first port D1 and the second port D2 in FIG. 17, depending on an actual application.

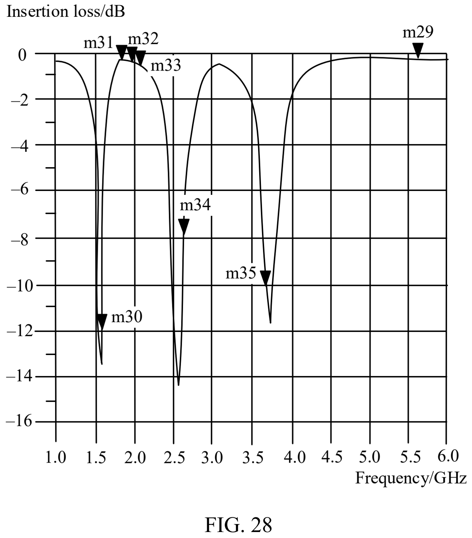

For a schematic diagram of a relationship between an insertion loss and frequency of the resonance structure in FIG. 27, refer to FIG. 28. As shown in FIG. 28, an insertion loss of the resonance structure of FIG. 27 at an m29 point, namely at 5.640 GHz is -0.005 dB. Therefore, an absolute value of the insertion loss at 5.640 GHz is 0.005 dB.

As further shown in FIG. 28, an insertion loss of the resonance structure of FIG. 27 at an m30 point, namely at 1.570 GHz is -12.050 dB. Therefore, an absolute value of the insertion loss at 1.570 GHz is 12.050 dB. An insertion loss at an m31 point, namely at 1.880 GHz is -0.266 dB. Therefore, an absolute value of the insertion loss at 1.880 GHz is 0.266 dB. An insertion loss at an m32 point, namely at 1.920 GHz is - 0.312 dB. Therefore, an absolute value of the insertion loss at 1.920 GHz is 0.312 dB. An insertion loss at an m33 point, namely at 2.030 GHz is -0.478 dB. Therefore, an absolute value of the insertion loss at 2.030 GHz is 0.478 dB. An insertion loss at an m34 point, namely at 2.620 GHz is -7.806 dB. Therefore, an absolute value of the insertion loss at 2.620 GHz is 7.806 dB. An insertion loss at an m35 point, namely at 3.690 GHz is -9.992 dB. Therefore, an absolute value of the insertion loss at 3.690 GHz is 9.992 dB.

The foregoing results indicate that the resonance structure of FIG. 27 can suppress a bandwidth frequency of 1.710 to 2.170 GHz, and can also suppress a frequency around 3.690 GHz.

In the first resonance structure provided in this embodiment of this application, a plurality of levels of resonance networks are nested with each other, to form an overall single-level multi-resonance structure. The respective levels of resonance networks in the single-level multi-resonance structure influence each other, and a resonance superposition mode with a non-serial structure is created, so that an insertion loss obtained after superposing the plurality of resonance networks is not simply serial addition. Instead, by means of mutual influence among the plurality of levels of resonance networks, an insertion loss in a passband of the resonance structure may not be increased as resonance points are increased. To be specific, an insertion loss obtained after a plurality of resonance cavities are superposed hardly increases. In addition, because of mutual influence among the plurality of levels of resonance networks in the single-level multi-resonance structure, multi-frequency point resonance can be formed by the first resonance structure at a particular required frequency point.

Therefore, an embodiment of this application provides a high-performance resonance structure. The resonance structure may form a filter for suppressing passbands of a global position system (global position system, GPS), a wireless fidelity (wireless fidelity, WIFI) 2.4G, B34 and B39 of a second harmonic of the wireless fidelity, and a global system for mobile communications (global system for mobile communications, GSM). In addition, a passband insertion loss may be less than 0.5 dB, and the performance is excellent.

In the foregoing Embodiment 2, the following structural deformation may further be performed.

Optionally, after the sixth capacitor C6 and the sixth inductor L6 are connected in parallel, the sixth-level resonance network 16, the fifth-level resonance network 15, the seventh-level resonance network 17, and the eighth-level resonance network 18 form different first resonance structures.

Optionally, after the seventh capacitor C7 and the seventh inductor L7 are connected in parallel, the seventh-level resonance network 17, the fifth-level resonance network 15, the sixth-level resonance network 16, and the eighth-level resonance network 18 form different first resonance structures.

Optionally, after the eighth capacitor C8 and the eighth inductor L8 are connected in parallel, the eighth-level resonance network 18, the fifth-level resonance network 15, the sixth-level resonance network 16, and the seventh-level resonance network 17 form different first resonance structures.

Optionally, after the fifth inductor L5 is replaced with the fifth capacitor C5, the fifth-level resonance network 15, the sixth-level resonance network 16, the seventh-level resonance network 17, and the eighth-level resonance network 18 form different first resonance structures.

Optionally, after positions of the sixth capacitor C6 and the sixth inductor L6 are interchanged, the sixth-level resonance network 16, the fifth-level resonance network 15, the seventh-level resonance network 17, and the eighth-level resonance network 18 form different first resonance structures.

Optionally, after positions of the seventh capacitor C7 and the seventh inductor L7 are interchanged, the seventh-level resonance network 17, the fifth-level resonance network 15, the sixth-level resonance network 16, and the eighth-level resonance network 18 form different first resonance structures.

Optionally, after positions of the eighth capacitor C8 and the eighth inductor L8 are interchanged, the eighth-level resonance network 18, the fifth-level resonance network 15, the sixth-level resonance network 16, and the seventh-level resonance network 17 form different first resonance structures.

Certainly, this application is not limited thereto. This is not specifically described one by one herein.

### Embodiment 3

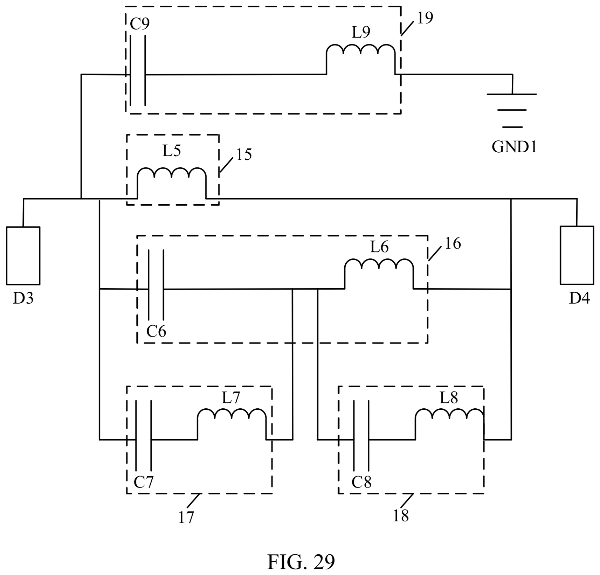

Optionally, as an implementable manner, referring to FIG. 29, a case of a resonance structure according to an embodiment of this application is specifically described.

As shown in FIG. 29, the resonance structure includes: a first resonance structure of FIG. 27 and a ninth-level resonance network 19, and specifically includes a third port D3, a fifth-level resonance network 15, a sixth-level resonance network 16, a seventh-level resonance network 17, an eighth-level resonance network 18, a ninth-level resonance network 19, a ground GND1, and a fourth port D4.

The fifth-level resonance network 15 includes a fifth inductor L5. The sixth-level resonance network 16 includes a sixth capacitor C6 and a sixth inductor L6, and the sixth capacitor C6 is connected in series to the sixth inductor L6. The seventh-level resonance network 17 includes a seventh capacitor C7 and a seventh inductor L7, and the seventh capacitor C7 is connected in series to the seventh inductor L7. The eighth-level resonance network 18 includes an eighth capacitor C8 and an eighth inductor L8, and the eighth capacitor C8 is connected in series to the eighth inductor L8. The ninth-level resonance network 19 includes a ninth capacitor C9 and a ninth inductor L9, and the ninth capacitor C9 is connected in series to the ninth inductor L9. In addition, the fifth-level resonance network 15 is connected in parallel to the sixth-level resonance network 16. The seventh-level resonance network 17 is connected in parallel to two ends of the sixth capacitor C6 in the sixth-level resonance network 16. The eighth-level resonance network 18 is connected in parallel to two ends of the sixth inductor L6 in the sixth-level resonance network 16, and finally is connected in parallel to the ninth-level resonance network 19.

Specifically, as shown in FIG. 29, a first end of the fifth inductor L5 is separately electrically connected to a first end of the sixth capacitor C6, a first end of the seventh capacitor C7, a first end of the ninth capacitor C9, and the third port D3. A second end of the fifth inductor L5 is separately electrically connected to a second end of the sixth inductor L6, a second end of the eighth inductor L8, and the fourth port D4. A second end of the sixth capacitor C6 is separately electrically connected to a first end of the sixth inductor L6, a second end of the seventh inductor L7, and a first end of the eighth capacitor C8. A second end of the seventh capacitor C7 is electrically connected to a first end of the seventh inductor L7. A second end of the eighth capacitor C8 is electrically connected to a first end of the eighth inductor L8. A second end of the ninth capacitor C9 is electrically connected to a first end of the ninth inductor L9. A second end of the ninth inductor L9 is connected to the ground GND1.

In an actual application, in FIG. 27, an inductance value of the fifth inductor L5 may be 3.0 nH. A capacitance value of the sixth capacitor C6 may be 1.2 pF. An inductance value of the sixth inductor L6 may be 2.0 nH. A capacitance value of the seventh capacitor C7 may be 0.5 pF. An inductance value of the seventh inductor L7 may be 5.1 nH. A capacitance value of the eighth capacitor C8 may be 1.8 pF. An inductance value of the eighth inductor L8 may be 1.5 nH. A capacitance value of the ninth capacitor C9 may be 0.2 pF. An inductance value of the ninth inductor L9 may be 27 nH. Certainly, the capacitance value of each capacitor and the inductance value of each inductor are not limited thereto. This is not specifically limited herein.

It should be noted that the third port D3 and the fourth port D4 in FIG. 29 may be the same as or different from the first port D1 and the second port D2 in FIG. 17, depending on an actual application.

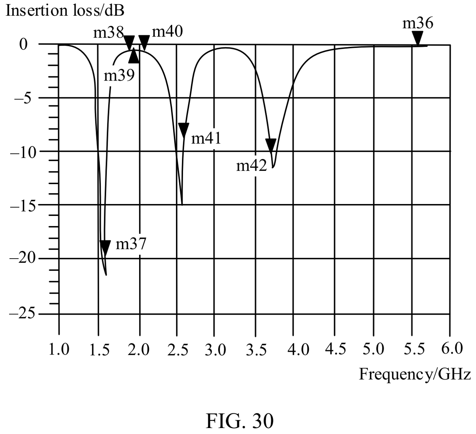

For a schematic diagram of a relationship between an insertion loss and frequency of the resonance structure in FIG. 29, refer to FIG. 30. As shown in FIG. 30, an insertion loss of the resonance structure of FIG. 29 at an m36 point, namely at 5.640 GHz is -0.126 dB. Therefore, an absolute value of the insertion loss at 5.640 GHz is 0.126 dB.

As further shown in FIG. 30, an insertion loss of the resonance structure of FIG. 29 at an m37 point, namely at 1.570 GHz is -19.111 dB. Therefore, an absolute value of the insertion loss at 1.570 GHz is 19.111 dB. An insertion loss at an m38 point, namely at 1.880 GHz is -0.594 dB. Therefore, an absolute value of the insertion loss at 1.880 GHz is 0.594 dB. An insertion loss at an m39 point, namely at 1.920 GHz is - 0.622 dB. Therefore, an absolute value of the insertion loss at 1.920 GHz is 0.622 dB. An insertion loss at an m40 point, namely at 2.030 GHz is -0.733 dB. Therefore, an absolute value of the insertion loss at 2.030 GHz is 0.733 dB. An insertion loss at an m41 point, namely at 2.620 GHz is -7.813 dB. Therefore, an absolute value of the insertion loss at 2.620 GHz is 7.813 dB. An insertion loss at an m42 point, namely at 3.690 GHz is -9.987 dB. Therefore, an absolute value of the insertion loss at 3.690 GHz is 9.987 dB.

The foregoing results indicate that the resonance structure of FIG. 29 can suppress a bandwidth frequency of 1.710 to 2.170 GHz, and can also suppress a frequency around 1.570 GHz, 2.620 GHz, or 3.690 GHz.

In the resonance structure provided in this embodiment of this application, the first resonance structure and another resonance network are combined in a parallel. Because a plurality of levels of resonance networks in the first resonance structure of FIG. 27 are nested with each other to form a single-level multi-resonance structure, an insertion loss in a passband may not be increased as resonance points are increased. In addition, because the plurality of levels of resonance networks in the single-level multi-resonance structure influence each other, multi-frequency point resonance can be formed at a particular required frequency point. In addition, with reference to the ninth-level resonance network, a GPS can be more deeply suppressed.

Therefore, an embodiment of this application provides a high-performance resonance structure. Compared with the resonance structure of FIG. 27 (an absolute value of an insertion loss at 1.570 GHz is 12.050 dB), although a passband insertion loss of the resonance structure is slightly increased, an absolute value of an insertion loss at 1.570 GHz is 19.111 dB. To be specific, a suppression depth of a GPS may reach 19.111 dB. Therefore, when a radio frequency signal passes through the resonance structure, the resonance structure can further filter clutter of a GPS frequency point, thereby further reducing interference received by the GPS.

In the foregoing Embodiment 3, the following structural deformation may further be performed.

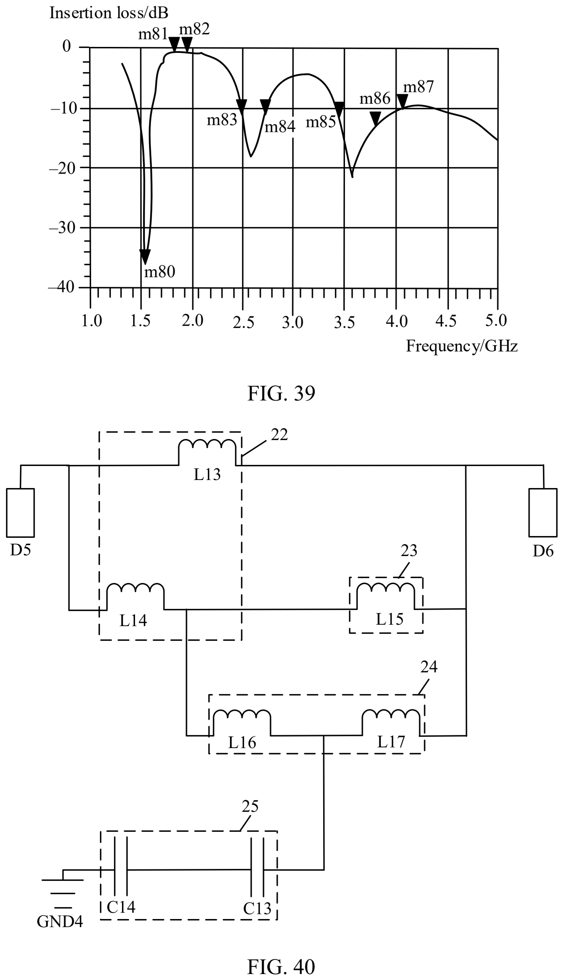

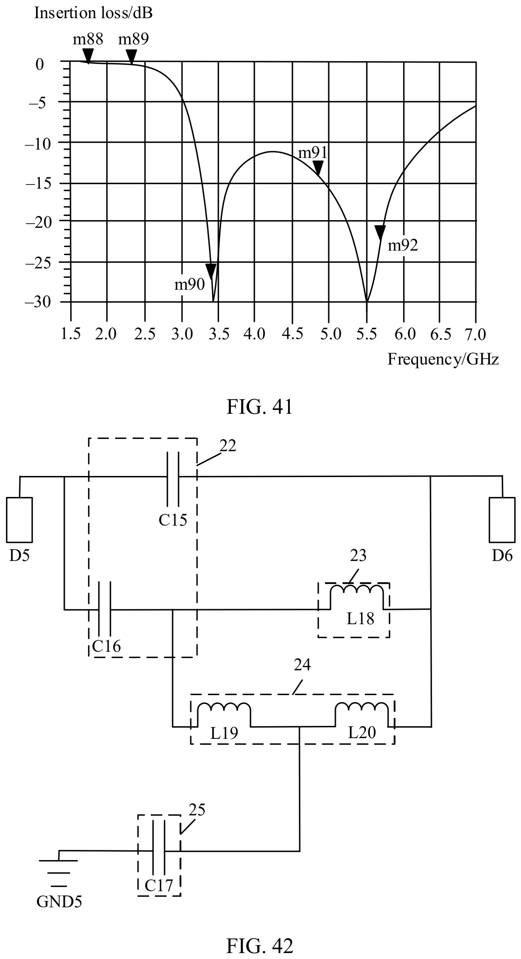

Optionally, the first resonance structure in FIG. 29 may be replaced with the first resonance structure of FIG. 17 or various deformations of the first resonance structure of FIG. 17, a first resonance structure of FIG. 40 or various deformations of the first resonance structure of FIG. 40, or a first resonance structure of FIG. 42 or various deformations of the first resonance structure of FIG. 42, to form a plurality of different resonance structures.

Certainly, this application is not limited thereto. This is not specifically described one by one herein.

### Embodiment 4

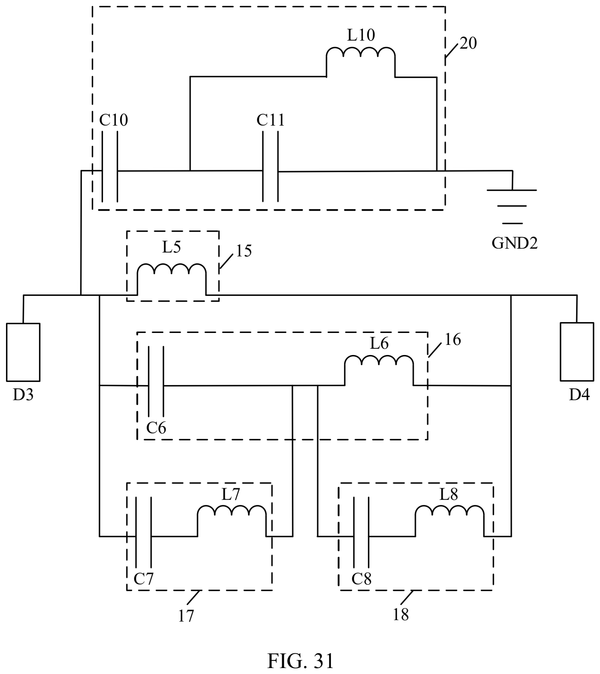

Optionally, as an implementable manner, referring to FIG. 31, a case of a resonance structure according to an embodiment of this application is specifically described.

As shown in FIG. 31, the resonance structure includes: a first resonance structure of FIG. 27 and a tenth-level resonance network 20, and specifically includes a third port D3, a fifth-level resonance network 15, a sixth-level resonance network 16, a seventh-level resonance network 17, an eighth-level resonance network 18, a tenth-level resonance network 20, a ground GND2, and a fourth port D4.

The fifth-level resonance network 15 includes a fifth inductor L5. The sixth-level resonance network 16 includes a sixth capacitor C6 and a sixth inductor L6, and the sixth capacitor C6 is connected in series to the sixth inductor L6. The seventh-level resonance network 17 includes a seventh capacitor C7 and a seventh inductor L7, and the seventh capacitor C7 is connected in series to the seventh inductor L7. The eighth-level resonance network 18 includes an eighth capacitor C8 and an eighth inductor L8, and the eighth capacitor C8 is connected in series to the eighth inductor L8. The tenth-level resonance network 20 includes a tenth capacitor C10, an eleventh capacitor C11, and a tenth inductor L10. The eleventh capacitor C11 is connected in parallel to the tenth inductor L10 and is connected in series to the tenth capacitor C10. In addition, the fifth-level resonance network 15 is connected in parallel to the sixth-level resonance network 16. The seventh-level resonance network 17 is connected in parallel to two ends of the sixth capacitor C6 in the sixth-level resonance network 16. The eighth-level resonance network 18 is connected in parallel to two ends of the sixth inductor L6 in the sixth-level resonance network 16, and finally is connected in parallel to the tenth-level resonance network 20.

Specifically, as shown in FIG. 31, a first end of the fifth inductor L5 is separately electrically connected to a first end of the sixth capacitor C6, a first end of the seventh capacitor C7, a first end of the tenth capacitor C10, and the third port D3. A second end of the fifth inductor L5 is separately electrically connected to a second end of the sixth inductor L6, a second end of the eighth inductor L8, and the fourth port D4. A second end of the sixth capacitor C6 is separately electrically connected to a first end of the sixth inductor L6, a second end of the seventh inductor L7, and a first end of the eighth capacitor C8. A second end of the seventh capacitor C7 is electrically connected to a first end of the seventh inductor L7. A second end of the eighth capacitor C8 is electrically connected to a first end of the eighth inductor L8. A second end of the tenth capacitor C10 is separately electrically connected to a first end of the eleventh capacitor C11 and a first end of the tenth inductor L10. A second end of the eleventh capacitor C11 is electrically connected to a second end of the tenth inductor L10 and is connected to the ground GND2.

In an actual application, in FIG. 31, an inductance value of the fifth inductor L5 may be 3.0 nH. A capacitance value of the sixth capacitor C6 may be 1.2 pF. An inductance value of the sixth inductor L6 may be 2.0 nH. A capacitance value of the seventh capacitor C7 may be 0.5 pF. An inductance value of the seventh inductor L7 may be 5.1 nH. A capacitance value of the eighth capacitor C8 may be 1.8 pF. An inductance value of the eighth inductor L8 may be 1.5 nH. A capacitance value of the tenth capacitor C10 may be 2.4 pF. A capacitance value of the eleventh capacitor C11 may be 5.6 pF. An inductance value of the tenth inductor L10 may be 1.5 nH. Certainly, the capacitance value of each capacitor and the inductance value of each inductor are not limited thereto. This is not specifically limited herein.

It should be noted that the third port D3 and the fourth port D4 in FIG. 31 may be the same as or different from the first port D1 and the second port D2 in FIG. 17, depending on an actual application.

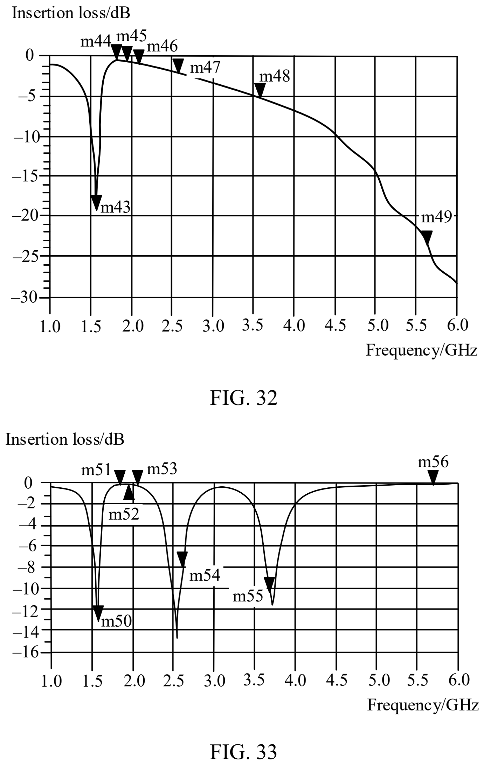

For a schematic diagram of a relationship between an insertion loss and frequency of the tenth-level resonance network 20 of the resonance structure in FIG. 31, refer to FIG. 32. As shown in FIG. 32, an insertion loss of the tenth-level resonance network 20 at an m43 point, namely at 1.570 GHz is -19.311 dB. Therefore, an absolute value of the insertion loss at 1.570 GHz is 19.311 dB. An insertion loss at an m44 point, namely at 1.880 GHz is -0.378 dB. Therefore, an absolute value of the insertion loss at 1.880 GHz is 0.378 dB. An insertion loss at an m45 point, namely at 1.920 GHz is - 0.416 dB. Therefore, an absolute value of the insertion loss at 1.920 GHz is 0.416 dB. An insertion loss at an m46 point, namely at 2.030 GHz is -0.615 dB. Therefore, an absolute value of the insertion loss at 2.030 GHz is 0.615 dB. An insertion loss at an m47 point, namely at 2.620 GHz is -2.115 dB. Therefore, an absolute value of the insertion loss at 2.620 GHz is 2.115 dB. An insertion loss at an m48 point, namely at 3.690 GHz is -5.484 dB. Therefore, an absolute value of the insertion loss at 3.690 GHz is 5.484 dB. An insertion loss at an m49 point, namely at 5.640 GHz is -23.487 dB. Therefore, an absolute value of the insertion loss at 5.640 GHz is 23.487 dB.

In the resonance structure of FIG. 31, for a schematic diagram of a relationship between an insertion loss and frequency of a resonance structure formed by the fifth-level resonance network 15, the sixth-level resonance network 16, the seventh-level resonance network 17, and the eighth-level resonance network 18, refer to FIG. 33. As shown in FIG. 33, an insertion loss at an m50 point, namely at 1.570 GHz is -12.057 dB. Therefore, an absolute value of the insertion loss at 1.570 GHz is 12.057 dB. An insertion loss at an m51 point, namely at 1.880 GHz is -0.266 dB. Therefore, an absolute value of the insertion loss at 1.880 GHz is 0.266 dB. An insertion loss at an m52 point, namely at 1.920 GHz is -0.312 dB. Therefore, an absolute value of the insertion loss at 1.920 GHz is 0. 312 dB. An insertion loss at an m53 point, namely at 2.030 GHz is -0.478 dB. Therefore, an absolute value of the insertion loss at 2.030 GHz is 0. 478 dB. An insertion loss at an m54 point, namely at 2.620 GHz is -7.806 dB. Therefore, an absolute value of the insertion loss at 2.620 GHz is 7.806 dB. An insertion loss at an m55 point, namely at 3.690 GHz is -9.992 dB. Therefore, an absolute value of the insertion loss at 3.690 GHz is 9.992 dB. An insertion loss at an m56 point, namely at 5.640 GHz is -0.125 dB. Therefore, an absolute value of the insertion loss at 5.640 GHz is 0.125 dB.

For a schematic diagram of a relationship between an insertion loss and frequency of the resonance structure in FIG. 31, refer to FIG. 34. As shown in FIG. 34, an insertion loss of the resonance structure of FIG. 31 at an m57 point, namely at 1.570 GHz is -35.904 dB. Therefore, an absolute value of the insertion loss at 1.570 GHz is 35.904 dB. An insertion loss at an m58 point, namely at 1.880 GHz is -16.111 dB. Therefore, an absolute value of the insertion loss at 1.880 GHz is 16.111 dB. An insertion loss at an m59 point, namely at 1.920 GHz is -0.548 dB. Therefore, an absolute value of the insertion loss at 1.920 GHz is 0.548 dB. An insertion loss at an m60 point, namely at 2.030 GHz is -0.616 dB. Therefore, an absolute value of the insertion loss at 2.030 GHz is 0.616 dB. An insertion loss at an m61 point, namely at 2.620 GHz is -12.784 dB. Therefore, an absolute value of the insertion loss at 2.620 GHz is 12.784 dB. An insertion loss at an m62 point, namely at 3.690 GHz is -18.961 dB. Therefore, an absolute value of the insertion loss at 3.690 GHz is 18.961 dB. An insertion loss at an m63 point, namely at 5.640 GHz is -23.732 dB. Therefore, an absolute value of the insertion loss at 5.640 GHz is 23.732 dB.

The foregoing results indicate that the resonance structure of FIG. 31 can suppress a bandwidth frequency of 1.570 to 5.640 GHz.

In the resonance structure provided in this embodiment of this application, the first resonance structure and another resonance network are combined in a parallel. Because a plurality of levels of resonance networks in the first resonance structure of FIG. 27 are nested with each other to form an overall single-level multi-resonance structure, an insertion loss in a passband may not be increased as resonance points are increased. In addition, because the plurality of levels of resonance networks in the single-level multi-resonance structure influence each other, multi-frequency point resonance can be formed at a particular required frequency point. In addition, with reference to a tenth-level resonance network, suppression of a GPS, a 2.5 generation mobile communication technology (2.5 generation, 2.5G), digital video high definition (high definition2, hd2), 5G wifi, and the like can further be implemented.

Therefore, an embodiment of this application provides a high-performance resonance structure. Compared with the resonance structure of FIG. 27 (an absolute value of an insertion loss at 1.570 GHz is 12.050 dB), an absolute value of an insertion loss of the resonance structure at 1.570 GHz is 35.904 dB. To be specific, a suppression depth of a GPS may reach 35.904 dB, which is equivalent to doubling the suppression depth of the GPS. Therefore, when a radio frequency signal passes through the resonance structure, the resonance structure can further filter clutter of a GPS frequency point, thereby further reducing interference received by the GPS. In addition, a passband insertion loss is also greatly reduced.

In the foregoing Embodiment 4, the following structural deformation may further be performed.

Optionally, the first resonance structure in FIG. 31 may be replaced with the first resonance structure of FIG. 17 or various deformations of the first resonance structure of FIG. 17, a first resonance structure of FIG. 40 or various deformations of the first resonance structure of FIG. 40, or a first resonance structure of FIG. 42 or various deformations of the first resonance structure of FIG. 42, to form a plurality of different resonance structures.

Certainly, this application is not limited thereto. This is not specifically described one by one herein.

### Embodiment 5

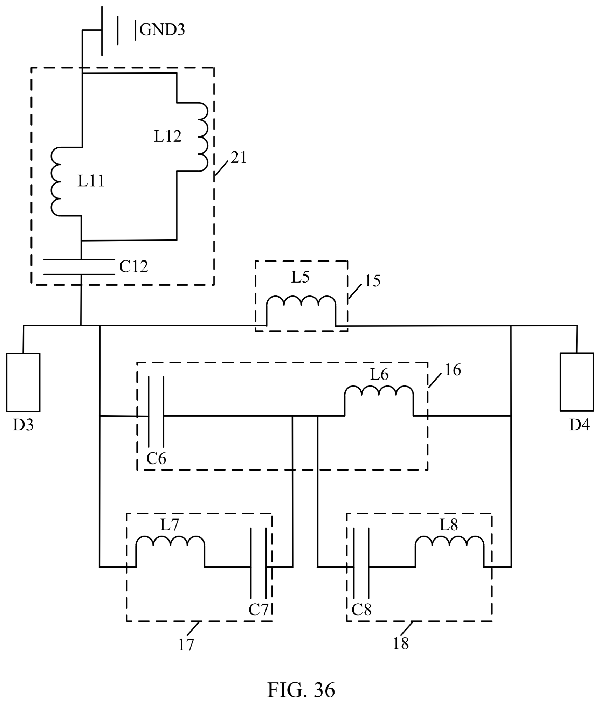

Optionally, as an implementable manner, referring to FIG. 36, a case of a resonance structure according to an embodiment of this application is specifically described.

As shown in FIG. 36, the resonance structure includes: a third port D3, a fifth-level resonance network 15, a sixth-level resonance network 16, a seventh-level resonance network 17, an eighth-level resonance network 18, an eleventh-level resonance network 21, a ground GND3, and a fourth port D4.

The fifth-level resonance network 15 includes a fifth inductor L5. The sixth-level resonance network 16 includes a sixth capacitor C6 and a sixth inductor L6, and the sixth capacitor C6 is connected in series to the sixth inductor L6. The seventh-level resonance network 17 includes a seventh inductor L7 and a seventh capacitor C7, and the seventh inductor L7 is connected in series to the seventh capacitor C7. The eighth-level resonance network 18 includes an eighth capacitor C8 and an eighth inductor L8, and the eighth capacitor C8 is connected in series to the eighth inductor L8. The eleventh-level resonance network 21 includes a twelfth capacitor C12, an eleventh inductor L11, and a twelfth inductor L12. The eleventh inductor L11 is connected in parallel to the twelfth inductor L12 and is connected in series to the twelfth capacitor C12. In addition, the fifth-level resonance network 15 is connected in parallel to the sixth-level resonance network 16. The seventh-level resonance network 17 is connected in parallel to two ends of the sixth capacitor C6 in the sixth-level resonance network 16. The eighth-level resonance network 18 is connected in parallel to two ends of the sixth inductor L6 in the sixth-level resonance network 16, is connected in parallel to a tenth-level resonance network 20, and finally is connected in parallel to the eleventh-level resonance network 21.

Specifically, as shown in FIG. 36, a first end of the fifth inductor L5 is separately electrically connected to a first end of the sixth capacitor C6, a first end of the seventh inductor L7, a first end of the twelfth capacitor C12, and the third port D3. A second end of the fifth inductor L5 is separately electrically connected to a second end of the sixth inductor L6, a second end of the eighth inductor L8, and the fourth port D4. A second end of the sixth capacitor C6 is separately electrically connected to a first end of the sixth inductor L6, a second end of the seventh capacitor C7, and a first end of the eighth capacitor C8. A second end of the seventh inductor L7 is electrically connected to a first end of the seventh capacitor C7. A second end of the eighth capacitor C8 is electrically connected to a first end of the eighth inductor L8. A second end of the twelfth capacitor C12 is separately electrically connected to a first end of the eleventh inductor L11 and a first end of the twelfth inductor L12. A second end of the eleventh inductor L11 is electrically connected to a second end of the twelfth inductor L12, and is connected to the ground GND3.

In an actual application, in FIG. 36, an inductance value of the fifth inductor L5 may be 3.0 nH. A capacitance value of the sixth capacitor C6 may be 1.2 pF. An inductance value of the sixth inductor L6 may be 2.2 nH. A capacitance value of the seventh capacitor C7 may be 0.4 pF. An inductance value of the seventh inductor L7 may be 6.2 nH. A capacitance value of the eighth capacitor C8 may be 1.8 pF. An inductance value of the eighth inductor L8 may be 1.5 nH. A capacitance value of the twelfth capacitor C12 may be 2.4 pF. An inductance value of the eleventh inductor L11 may be 5.6 nH. An inductance value of the twelfth inductor L12 may be 1.5 nH. Certainly, the capacitance value of each capacitor and the inductance value of each inductor are not limited thereto. This is not specifically limited herein.

It should be noted that the third port D3 and the fourth port D4 in FIG. 36 may be the same as or different from the first port D1 and the second port D2 in FIG. 17, depending on an actual application.

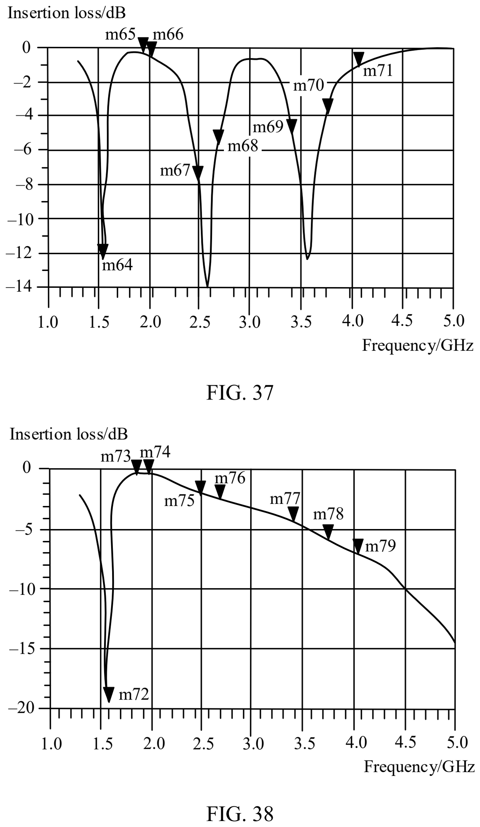

In the resonance structure of FIG. 36, for a schematic diagram of a relationship between an insertion loss and frequency of a resonance structure formed by the fifth-level resonance network 15, the sixth-level resonance network 16, the seventh-level resonance network 17, and the eighth-level resonance network 18, refer to FIG. 37. As shown in FIG. 37, an insertion loss at an m64 point, namely at 1.570 GHz is -12.654 dB. Therefore, an absolute value of the insertion loss at 1.570 GHz is 12.654 dB. An insertion loss at an m65 point, namely at 1.920 GHz is -0.366 dB. Therefore, an absolute value of the insertion loss at 1.920 GHz is 0. 366 dB. An insertion loss at an m66 point, namely at 2.030 GHz is -0.571 dB. Therefore, an absolute value of the insertion loss at 2.030 GHz is 0. 571 dB. An insertion loss at an m67 point, namely at 2.490 GHz is -7.869 dB. Therefore, an absolute value of the insertion loss at 2.490 GHz is 7.869 dB. An insertion loss at an m68 point, namely at 2.690 GHz is -5.592 dB. Therefore, an absolute value of the insertion loss at 2.690 GHz is 5.592 dB. An insertion loss at an m69 point, namely at 3.420 GHz is -4.893 dB. Therefore, an absolute value of the insertion loss at 3.420 GHz is 4.893 dB. An insertion loss at an m70 point, namely at 3.760 GHz is -3.842 dB. Therefore, an absolute value of the insertion loss at 3.760 GHz is 3.842 dB. An insertion loss at an m71 point, namely at 4.050 GHz is -0.995 dB. Therefore, an absolute value of the insertion loss at 4.050 GHz is 0.995 dB.

It can be seen from the foregoing results that, a passband insertion loss of a resonance structure formed by the fifth-level resonance network 15, the sixth-level resonance network 16, the seventh-level resonance network 17, and the eighth-level resonance network 18 may be within 0.5 dB, and suppression for a GPS band is approximately 10 dB, suppression for a B41 band is approximately 10 dB, and suppression for 3.42 to 3.85G is approximately 10 dB.

For a schematic diagram of a relationship between an insertion loss and frequency of the eleventh-level resonance network 21 of the resonance structure in FIG. 36, refer to FIG. 38. As shown in FIG. 38, an insertion loss of the eleventh-level resonance network 21 at an m72 point, namely at 1.570 GHz is -19.241 dB. Therefore, an absolute value of the insertion loss at 1.570 GHz is 19.241 dB. An insertion loss at an m73 point, namely at 1.920 GHz is -0.416 dB. Therefore, an absolute value of the insertion loss at 1.920 GHz is 0.416 dB. An insertion loss at an m74 point, namely at 2.030 GHz is -0.615 dB. Therefore, an absolute value of the insertion loss at 2.030 GHz is 0.615 dB. An insertion loss at an m75 point, namely at 2.490 GHz is -1.769 dB. Therefore, an absolute value of the insertion loss at 2.490 GHz is 1.769 dB. An insertion loss at an m76 point, namely at 2.690 GHz is -2.306 dB. Therefore, an absolute value of the insertion loss at 2.690 GHz is 2.306 dB. An insertion loss at an m77 point, namely at 3.420 GHz is -4.465 dB. Therefore, an absolute value of the insertion loss at 3.420 GHz is 4.465 dB. An insertion loss at an m78 point, namely at 3.760 GHz is -5.770 dB. Therefore, an absolute value of the insertion loss at 3.760 GHz is 5.770 dB. An insertion loss at an m79 point, namely at 4.050 GHz is -7.038 dB. Therefore, an absolute value of the insertion loss at 4.050 GHz is 7.038 dB.

It can be seen from the foregoing results that, a passband insertion loss of the eleventh-level resonance network 21 is approximately 0.5 dB, suppression for a GPS band is approximately 15 dB, and suppression for over 3.42G is 5 dB.

For a schematic diagram of a relationship between an insertion loss and frequency of the resonance structure in FIG. 36, refer to FIG. 39. As shown in FIG. 39, an insertion loss of the resonance structure of FIG. 36 at an m80 point, namely at 1.570 GHz is -36.449 dB. Therefore, an absolute value of the insertion loss at 1.570 GHz is 36.449 dB. An insertion loss at an m81 point, namely at 1.920 GHz is -0.545 dB. Therefore, an absolute value of the insertion loss at 1.920 GHz is 0.545 dB. An insertion loss at an m82 point, namely at 2.030 GHz is -0.656 dB. Therefore, an absolute value of the insertion loss at 2.030 GHz is 0.656 dB. An insertion loss at an m83 point, namely at 2.490 GHz is -11.010 dB. Therefore, an absolute value of the insertion loss at 2.490 GHz is 11.010 dB. An insertion loss at an m84 point, namely at 2.690 GHz is -10.663 dB. Therefore, an absolute value of the insertion loss at 2.690 GHz is 10.663 dB. An insertion loss at an m85 point, namely at 3.420 GHz is -11.340 dB. Therefore, an absolute value of the insertion loss at 3.420 GHz is 11.340 dB. An insertion loss at an m86 point, namely at 3.760 GHz is -13.132 dB. Therefore, an absolute value of the insertion loss at 3.760 GHz is 13.132 dB. An insertion loss at an m87 point, namely at 4.050 GHz is -10.039 dB. Therefore, an absolute value of the insertion loss at 4.050 GHz is 10.039 dB.

The foregoing results indicate that in the resonance structure of FIG. 36, the fifth-level resonance network 15 and the sixth-level resonance network 16 may form a primary resonance. The primary resonance may influence depths of all zero points, frequency points, and passband insertion losses. Specifically, the primary resonance may provide a low-frequency resonance, provide a 1.XG frequency point and zero point, and influence a zero point frequency of a 2.5G harmonic. The seventh-level resonance network 17 may be used as a secondary resonance, for providing a frequency point and zero point of a harmonic frequency of over 3G, and influencing a zero point frequency of 1.5G and 2.5G. The eighth-level resonance network 18 may be used as a secondary resonance, for providing a 2.5G frequency point and zero point, and influencing a zero point frequency of a 1.5G harmonic.

In the resonance structure provided in this embodiment of this application, the first resonance structure and another resonance network are combined in a parallel. Because a plurality of levels of resonance networks in the first resonance structure are nested with each other to form a single-level multi-resonance structure, an insertion loss in a passband may not be increased as resonance points are increased. In addition, because the plurality of levels of resonance networks in the single-level multi-resonance structure influence each other, multi-frequency point resonance can be formed at a particular required frequency point. In addition, with reference to the eleventh resonance network, a GPS, 1.5G, 2.5G, and the like can further be suppressed.

In the foregoing Embodiment 5, the following structural deformation may further be performed.

Optionally, the first resonance structure in FIG. 36 may be replaced with the first resonance structure of FIG. 17 or various deformations of the first resonance structure of FIG. 17, a first resonance structure of FIG. 40 or various deformations of the first resonance structure of FIG. 40, or a first resonance structure of FIG. 42 or various deformations of the first resonance structure of FIG. 42, to form a plurality of different resonance structures.

Certainly, this application is not limited thereto. This is not specifically described one by one herein.

### Embodiment 6

Optionally, as an implementable manner, referring to FIG. 40, a case of a first resonance structure according to an embodiment of this application is specifically described.

As shown in FIG. 40, the resonance structure includes: a fifth port D5, a twelfth-level resonance network 22, a thirteenth-level resonance network 23, a fourteenth-level resonance network 24, a fifteenth-level resonance network 25, a ground GND4, and a sixth port D6.

The twelfth-level resonance network 22 includes a thirteenth inductor L13 and a fourteenth inductor L14, and the thirteenth inductor L13 is connected in parallel to the fourteenth inductor L14. The thirteenth-level resonance network 23 includes a fifteenth inductor L15. The fourteenth-level resonance network 24 includes a sixteenth inductor L16 and a seventeenth inductor L17, and the sixteenth inductor L16 is connected in series to the seventeenth inductor L17. The fifteenth-level resonance network 25 includes a thirteenth capacitor C13 and a fourteenth capacitor C14, and the thirteenth capacitor C13 is connected in series to the fourteenth capacitor C14. In addition, after being connected in parallel to the fourteenth-level resonance network 24, the fifteenth-level resonance network 25 is connected parallel to the fifteenth inductor L15 in the thirteenth-level resonance network 23, is connected in series to the fourteenth inductor L14 in the thirteenth-level resonance network 23, and is finally connected in parallel to the twelfth-level resonance network 22.

Specifically, as shown in FIG. 40, a first end of the fourteenth inductor L14 is separately electrically connected to a first end of the thirteenth inductor L13 and the fifth port D5. A second end of the fourteenth inductor L14 is separately electrically connected to a first end of the fifteenth inductor L15 and a first end of the sixteenth inductor L16. A second end of the sixteenth inductor L16 is separately electrically connected to a first end of the seventeenth inductor L17 and a first end of the thirteenth capacitor C13. A second end of the thirteenth capacitor C13 is electrically connected to a first end of the fourteenth capacitor C14. A second end of the fourteenth capacitor C14 is connected to a ground. A second end of the seventeenth inductor L17 is separately electrically connected to a second end of the fifteenth inductor L15, a second end of the thirteenth inductor L13, and the sixth port D6.

In an actual application, in FIG. 40, an inductance value of the thirteenth inductor L13 may be 4.3 nH. An inductance value of the fourteenth inductor L14 may be 1.0 nH. An inductance value of the fifteenth inductor L15 may be 39 nH. An inductance value of the sixteenth inductor L16 may be 5.6 nH. An inductance value of the seventeenth inductor L17 may be 5.6 nH. A capacitance value of the thirteenth capacitor C13 may be 2.2 pF. A capacitance value of the fourteenth capacitor C14 may be 1.0 pF. Certainly, the capacitance value of each capacitor and the inductance value of each inductor are not limited thereto. This is not specifically limited herein.

For a schematic diagram of a relationship between an insertion loss and frequency of the resonance structure in FIG. 40, refer to FIG. 41. As shown in FIG. 41, an insertion loss of the resonance structure of FIG. 40 at an m88 point, namely at 1.710 GHz is -0.105 dB. Therefore, an absolute value of the insertion loss at 1.710 GHz is 0.105 dB. An insertion loss at an m89 point, namely at 2.400 GHz is -0.379 dB. Therefore, an absolute value of the insertion loss at 2.400 GHz is 0.379 dB. An insertion loss at an m90 point, namely at 3.400 GHz is -26.473 dB. Therefore, an absolute value of the insertion loss at 3.400 GHz is 26.473 dB. An insertion loss at an m91 point, namely at 4.800 GHz is -13.714 dB. Therefore, an absolute value of the insertion loss at 4.800 GHz is 13.714 dB. An insertion loss at an m92 point, namely at 5.730 GHz is -21.357 dB. Therefore, an absolute value of the insertion loss at 5.730 GHz is 21.357 dB.

The foregoing results indicate that the resonance structure of FIG. 40 can implement suppression of GSM_MB_TX. MB represents a medium frequency.

In the first resonance structure provided in this embodiment of this application, a plurality of levels of resonance networks are nested with each other, to form an overall single-level multi-resonance structure. The respective levels of resonance networks in the single-level multi-resonance structure influence each other, and a resonance superposition mode with a non-serial structure is created, so that an insertion loss obtained after superposing the plurality of resonance networks is not simply serial addition. Instead, by means of mutual influence among the plurality of levels of resonance networks, an insertion loss in a passband of the resonance structure may not be increased as resonance points are increased. To be specific, an insertion loss obtained after a plurality of resonance cavities are superposed hardly increases. In addition, because of mutual influence among the plurality of levels of resonance networks in the single-level multi-resonance structure, multi-frequency point resonance can be formed by the first resonance structure at a particular required frequency point. Therefore, an embodiment of this application provides a high-performance resonance structure.

### Embodiment 7

Optionally, as an implementable manner, referring to FIG. 42, a case of a first resonance structure according to an embodiment of this application is specifically described.

As shown in FIG. 42, the resonance structure includes: a fifth port D5, a twelfth-level resonance network 22, a thirteenth-level resonance network 23, a fourteenth-level resonance network 24, a fifteenth-level resonance network 25, a ground GND5, and a sixth port D6.

The twelfth-level resonance network 22 includes a fifteenth capacitor C15 and a sixteenth capacitor C16, and the fifteenth capacitor C15 is connected in parallel to the sixteenth capacitor C16. The thirteenth-level resonance network 23 includes an eighteenth inductor L18. The fourteenth-level resonance network 24 includes a nineteenth inductor L19 and a twentieth inductor L20, and the nineteenth inductor L19 is connected in series to the twentieth inductor L20. The fifteenth-level resonance network 25 includes a seventeenth capacitor C17. In addition, after being connected in parallel to the fourteenth-level resonance network 24, the fifteenth-level resonance network 25 is connected parallel to the thirteenth-level resonance network 23, is connected in series to the sixteenth capacitor C16 in the twelfth-level resonance network 22, and is finally connected in parallel to the fifteenth capacitor C15 in the twelfth-level resonance network 22.

Specifically, as shown in FIG. 42, a first end of the sixteenth capacitor C16 is separately electrically connected to a first end of the fifteenth capacitor C15 and the seventh port D7. A second end of the sixteenth capacitor C16 is separately electrically connected to a first end of the eighteenth inductor L18 and a first end of the nineteenth inductor L19. A second end of the nineteenth inductor L19 is separately electrically connected to a first end of the twentieth inductor L20 and a first end of the seventeenth capacitor C17. A second end of the seventeenth capacitor C17 is connected to the ground GND5. A second end of the twentieth inductor L20 is separately electrically connected to a second end of the eighteenth inductor L18, a second end of the fifteenth capacitor C15, and the eighth port D8.

In an actual application, in FIG. 42, an inductance value of the eighteenth inductor L18 may be 39 nH. An inductance value of the nineteenth inductor L19 may be 5.6 nH. An inductance value of the twentieth inductor L20 may be 4.7 nH. A capacitance value of the fifteenth capacitor C15 may be 1.5 pF. A capacitance value of the sixteenth capacitor C16 may be 6.8 pF. A capacitance value of the seventeenth capacitor C17 may be 1.0 pF. Certainly, the capacitance value of each capacitor and the inductance value of each inductor are not limited thereto. This is not specifically limited herein.

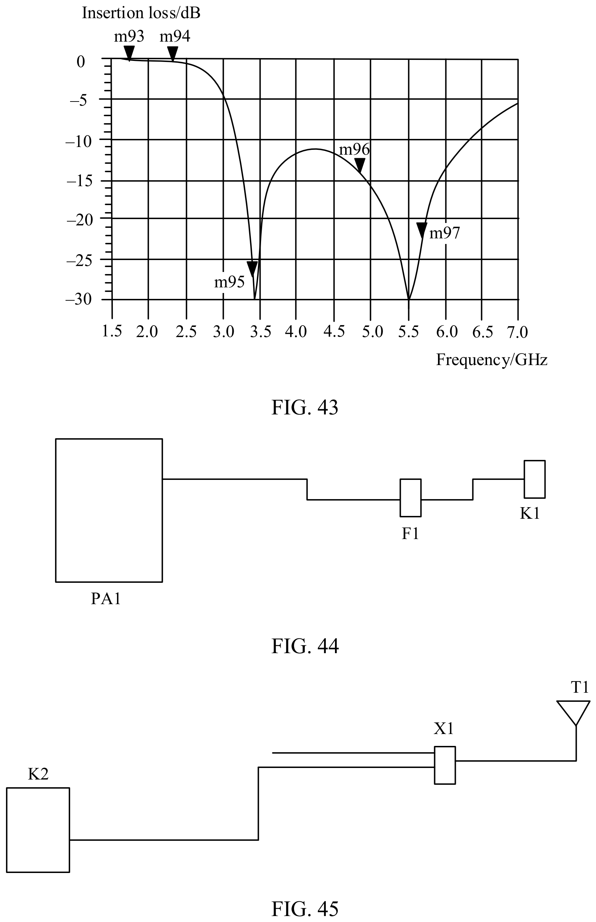

For a schematic diagram of a relationship between an insertion loss and frequency of the resonance structure in FIG. 42, refer to FIG. 43. As shown in FIG. 43, an insertion loss of the resonance structure of FIG. 42 at an m93 point, namely at 1.710 GHz is -0.105 dB. Therefore, an absolute value of the insertion loss at 1.710 GHz is 0.105 dB. An insertion loss at an m94 point, namely at 2.400 GHz is -0.379 dB. Therefore, an absolute value of the insertion loss at 2.400 GHz is 0.379 dB. An insertion loss at an m95 point, namely at 3.400 GHz is -26.473 dB. Therefore, an absolute value of the insertion loss at 3.400 GHz is 26.473 dB. An insertion loss at an m96 point, namely at 4.800 GHz is -13.714 dB. Therefore, an absolute value of the insertion loss at 4.800 GHz is 13.714 dB. An insertion loss at an m97 point, namely at 5.730 GHz is -21.357 dB. Therefore, an absolute value of the insertion loss at 5.730 GHz is 21.357 dB.

The foregoing results indicate that the resonance structure of FIG. 42 can implement suppression of GSM_LB_TX. LB represents a low frequency.

In the first resonance structure provided in this embodiment of this application, a plurality of levels of resonance networks are nested with each other, to form an overall single-level multi-resonance structure. The respective levels of resonance networks in the single-level multi-resonance structure influence each other, and a resonance superposition mode with a non-serial structure is created, so that an insertion loss obtained after superposing the plurality of resonance networks is not simply serial addition. Instead, by means of mutual influence among the plurality of levels of resonance networks, an insertion loss in a passband of the resonance structure may not be increased as resonance points are increased. To be specific, an insertion loss obtained after a plurality of resonance cavities are superposed hardly increases. In addition, because of mutual influence among the plurality of levels of resonance networks in the single-level multi-resonance structure, multi-frequency point resonance can be formed by the first resonance structure at a particular required frequency point. Therefore, an embodiment of this application provides a high-performance resonance structure.

It should be noted that in this application, different transformation combinations of a plurality of levels of resonance networks may be designed according to a requirement of resonance frequency points in a radio frequency system, to obtain a plurality of different first resonance structures, so as to implement different resonance functions.

In addition, in this application, the plurality of resonance structures provided in the foregoing embodiments may be combined in series and/or parallel with a resonance network in another related technology according to the requirement of the resonance frequency points, to obtain a plurality of different resonance structures, so as to achieve different technical effects. Details are not described herein.

An embodiment of this application further provides a radio frequency system. The radio frequency system may include a filter, a combiner, a notch filter, a duplexer, a multiplexer, an antenna, and the like. The device such as the filter, the combiner, the notch filter, the duplexer, and the multiplexer may include various different resonance structures provided in the foregoing embodiments of this application.

The foregoing various resonance structures of this application, for example, the first resonance structure of FIG. 17, the first resonance structure of FIG. 27, the first resonance structure of FIG. 40, the first resonance structure of FIG. 42, and a resonance structure including each first resonance structure and another resonance network (for example, the resonance network of FIG. 29, the resonance network of FIG. 31, and the resonance network of FIG. 36) may all be used in the device such as the filter, the combiner, the notch filter, the duplexer, and the multiplexer, to implement functions such as filtering, combining, and frequency selection.

FIG. 44 shows an application scenario of a filter in an actual application.

As shown in FIG. 44, a radio frequency system includes a radio frequency power amplifier (power amplifier, PA) PA 1, a first filter F1, and a first switch K1. One end of the first filter F1 is electrically connected to the radio frequency power amplifier PA 1, and the other end is electrically connected to the first switch K1. Therefore, the first filter F1 may receive an amplified signal transmitted by the radio frequency power amplifier PA 1, effectively filter the amplified signal by using a frequency point of a particular frequency or a frequency other than the frequency point to obtain a signal of a particular frequency, or eliminate a signal obtained after a particular frequency, and then transmit the processed signal when the first switch K1 is closed.

FIG. 45 shows an application scenario of a combiner in an actual application.

As shown in FIG. 45, a radio frequency system includes a second switch K2, a first combiner X1, and an antenna T1. One end of the first combiner X1 is electrically connected to the second switch K2, and the other end is electrically connected to the antenna T1. Therefore, the first combiner X1 may receive a multi-band signal when the second switch K2 is closed, combine the multi-band signal, and transmit the multi-band signal to the antenna T1.

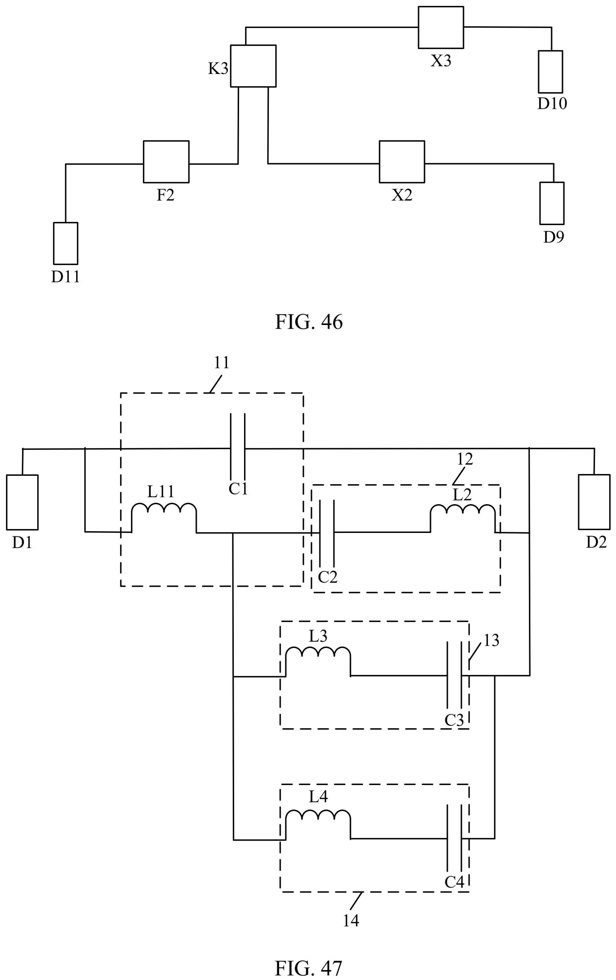

FIG. 46 shows an application scenario of a filter, a combiner, and the like in an actual application.

As shown in FIG. 46, the radio frequency system includes a ninth port D9, a tenth port D10, a second combiner X2, a third combiner X3, a third switch K3, a second filter F2 and an eleventh port D11. A first end of the second combiner X2 is electrically connected to the ninth port D9. A second end of the second combiner X2 is electrically connected to the third switch K3. A first end of the third combiner X3 is electrically connected to the tenth port D10. A second end of the third combiner X3 is electrically connected to the third switch K3. A first end of the second filter F2 is electrically connected to the third switch K3. A second end of the second filter F2 is electrically connected to the eleventh port D11.

In an actual application, the first resonance structure of FIG. 40 may be applied to the second filter F2, and certainly is not limited thereto. This is not specifically limited herein.

Before the combiner in this embodiment of this application is described, the combiner is first briefly described by using a brief schematic diagram of a combiner in FIG. 46.

In FIG. 46, for example, the second combiner X2 may be designed to allow a high-frequency signal to pass through and prevent a low-frequency signal from passing through. To be specific, in the second combiner X2, a high frequency is a passband, and a low frequency is a stop band. The third combiner X3 may be designed to allow a low-frequency signal to pass through and prevent a high-frequency signal from passing through. To be specific, in the third combiner X3, a high frequency is a stop band, and a low frequency is a passband. Therefore, after a signal sent from the ninth port D9 passes through the second combiner X2, and a signal sent from the tenth port D10 passes through the third combiner X3, the signals are combined to the eleventh port D11.

Therefore, the first resonance structure provided in the foregoing embodiment of this application and a resonance structure including each first resonance structure and another resonance network may be used for the second combiner X2 and/or the third combiner X3 shown in FIG. 46, to form a plurality of combiners of different structures.

It should be noted that FIG. 46 is shown by using an example in which a radio frequency system includes two combiners. Certainly, this is not limited thereto. The radio frequency system may further include three or more combiners. At least one combiner in each radio frequency system may include the first resonance structure provided in the foregoing embodiment of this application, and a resonance structure including the first resonance structure and another resonance network. This is not specifically limited herein.

In the radio frequency system provided in this embodiment of this application, at least some of the devices such as the filter, the combiner, the notch filter, the duplexer, and the multiplexer have the resonance structure provided in the foregoing embodiments. In the resonance structure, a plurality of levels of resonance networks are nested with each other, to form an overall single-level multi-resonance structure. In this way, an insertion loss obtained after superposing the plurality of resonance networks is not simply serial addition. Instead, by means of mutual influence among the plurality of levels of resonance networks, an insertion loss in a passband of the resonance structure may not be increased as resonance frequency points are increased, and multi-frequency point resonance can be formed at a particular required frequency point. In this way, a high-performance device such as a filter, a combiner, a notch filter, a duplexer, and a multiplexer is obtained.

The following specifically describes a plurality of combiners according to an embodiment of this application.

### Embodiment 8

Optionally, as an implementable manner, referring to FIG. 47 and FIG. 17, a case of a combiner according to an embodiment of this application is specifically described.

FIG. 47 and FIG. 17 respectively show two slightly different first resonance structures according to an embodiment of this application. The two first resonance structures may be respectively used in any combiner in FIG. 46.

As shown in FIG. 47, the resonance structure includes: a first port D1, a first-level resonance network 11, a second-level resonance network 12, a third-level resonance network 13, a fourth-level resonance network 14, and a second port D2.

The first-level resonance network 11 includes a first inductor L1 and a first capacitor C1, and the first inductor L1 is connected in parallel to the first capacitor C1. The second-level resonance network 12 includes a second inductor L2 and a second capacitor C2, and the second inductor L2 is connected in series to the second capacitor C2. The third-level resonance network 13 includes a third inductor L3 and a third capacitor C3, and the third inductor L3 is connected in series to the third capacitor C3. The fourth-level resonance network 14 includes a fourth inductor L4 and a fourth capacitor C4, and the fourth inductor L4 is connected in series to the fourth capacitor C4. In addition, after being connected in parallel to the third-level resonance network 13, the fourth-level resonance network 14 is connected in parallel to the second-level resonance network 12, is connected in series to the first capacitor C1 in the first-level resonance network 11, and then is connected in parallel to the first inductor L1 in the first-level resonance network 11.

Specifically, as shown in FIG. 47, a first end of the first inductor L1 is separately electrically connected to a first end of the first capacitor C1 and the first port D1. A second end of the first inductor L1 is separately electrically connected to a first end of the second capacitor C2, a first end of the third inductor L3, and a first end of the fourth inductor L4. A second end of the third inductor L3 is electrically connected to a first end of the third capacitor C3. A second end of the fourth inductor L4 is electrically connected to a first end of the fourth capacitor C4. A second end of the first capacitor C1 is separately electrically connected to a second end of the second inductor L2, a second end of the third capacitor C3, a second end of the fourth capacitor C4, and the second port D2.

In an actual application, a capacitance value of the first capacitor C1 in FIG. 47 may be 1.2 pF. An inductance value of the first inductor L1 may be 2.0 nH. A capacitance value of the second capacitor C2 may be 0.4 pF. An inductance value of the second inductor L2 may be 4.3 nH. A capacitance value of the third capacitor C3 may be 2.0 pF. An inductance value of the third inductor L3 may be 2.4 nH. A capacitance value of the fourth capacitor C4 may be 1.3 pF. An inductance value of the fourth inductor L4 may be 1.8 nH. Certainly, the capacitance value of each capacitor and the inductance value of each inductor are not limited thereto. This is not specifically limited herein.

In an actual application, a capacitance value of the first capacitor C1 in FIG. 17 may be 3.0 pF. An inductance value of the first inductor L1 may be 2.4 nH. A capacitance value of the second capacitor C2 may be 1.5 pF. An inductance value of the second inductor L2 may be 5.6 nH. A capacitance value of the third capacitor C3 may be 2.2 pF. An inductance value of the third inductor L3 may be 3.0 nH. A capacitance value of the fourth capacitor C4 may be 1.8 pF. An inductance value of the fourth inductor L4 may be 3.0 nH. Certainly, this application is not limited thereto. This is not specifically limited herein.

The following specifically describes a relationship between an insertion loss and frequency of the combiner formed in FIG. 47 and FIG. 17.

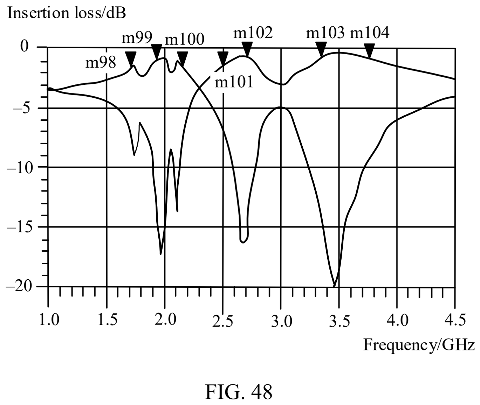

For a schematic diagram of a relationship between an insertion loss and frequency of the combiner formed in FIG. 47 and FIG. 17, refer to FIG. 48. As shown in FIG. 48, an insertion loss at an m98 point, namely at 1.710 GHz is -1.712 dB. Therefore, an absolute value of the insertion loss at 1.710 GHz is 1.712 dB. An insertion loss at an m99 point, namely at 1.900 GHz is -1.171 dB. Therefore, an absolute value of the insertion loss at 1.900 GHz is 1.171 dB. An insertion loss at an m100 point, namely at 2.170 GHz is -1.598 dB. Therefore, an absolute value of the insertion loss at 2.170 GHz is 1.598 dB. An insertion loss at an m101 point, namely at 2.490 GHz is - 1.652 dB. Therefore, an absolute value of the insertion loss at 2.490 GHz is 1.652 dB. An insertion loss at an m102 point, namely at 2.690 GHz is -0.830 dB. Therefore, an absolute value of the insertion loss at 2.690 GHz is 0.830 dB. An insertion loss at an m103 point, namely at 3.300 GHz is -0.977 dB. Therefore, an absolute value of the insertion loss at 3.300 GHz is 0.977 dB. An insertion loss at an m104 point, namely at 3.800 GHz is -1.018 dB. Therefore, an absolute value of the insertion loss at 3.800 GHz is 1.018 dB.

The foregoing results indicate that, in the combiner, a medium frequency of 1.710 to 2.170 GHz is a passband, and a high frequency of 2.490 to 3.800 GHz is a passband, so that combination can be implemented.

### Embodiment 9

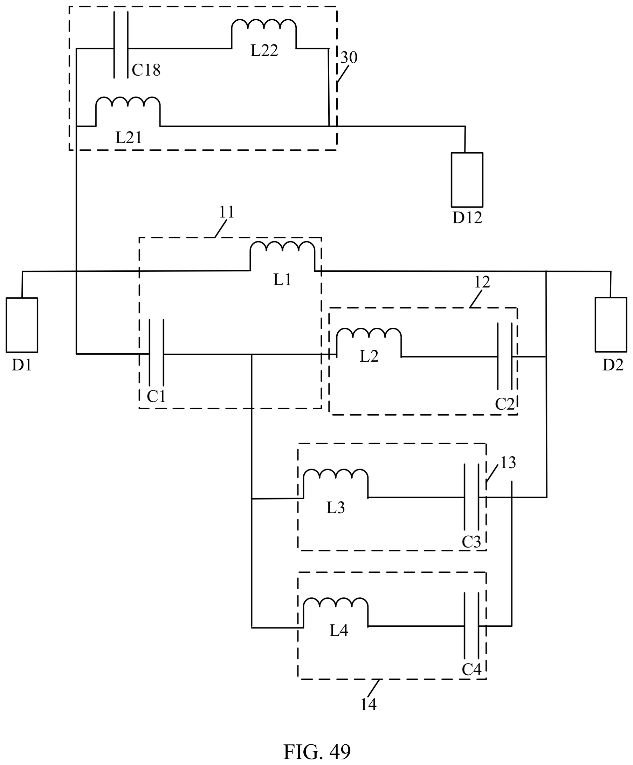

Optionally, as an implementable manner, referring to FIG. 49, a case of a combiner according to an embodiment of this application is specifically described.

FIG. 49 is a combiner formed by combining the first resonance structure of FIG. 17 and a twentieth-level resonance network 30.

As shown in FIG. 49, the twentieth-level resonance network 30 includes a twenty-first inductor L21, an eighteenth capacitor C18, a twenty-second inductor L22, and a twelfth port D12. The eighteenth capacitor C18 is connected in series to the twenty-second inductor L22 and is connected in parallel to the twenty-first inductor L21.

Specifically, as shown in FIG. 49, a first end of the first capacitor C1 is separately electrically connected to a first end of the first inductor L1, a first end of the twenty-first inductor L21, a first end of the eighteenth capacitor C18, and the first port D1. A second end of the first capacitor C1 is separately electrically connected to a first end of the second inductor L2, a first end of the third inductor L3, and a first end of the fourth inductor L4. A second end of the second inductor L2 is electrically connected to a first end of the second capacitor C2. A second end of the third inductor L3 is electrically connected to a first end of the third capacitor C3. A second end of the fourth inductor L4 is electrically connected to a first end of the fourth capacitor C4. A second end of the first inductor L1 is separately electrically connected to a second end of the second capacitor C2, a second end of the third capacitor C3, a second end of the fourth capacitor C4, and the second port D2. A second end of the eighteenth capacitor C18 is electrically connected to a first end of the twenty-second inductor L22. A second end of the twenty-first inductor L21 is separately electrically connected to a second end of the twenty-second inductor L22 and the twelfth port D12.

In an actual application, an inductance value of the twenty-first inductor L21 in FIG. 49 may be 1.5 nH. A capacitance value of the eighteenth capacitor C18 may be 1.5 pF. An inductance value of the twenty-second inductor L22 may be 1.2 nH. Certainly, this application is not limited thereto. This is not specifically limited herein.

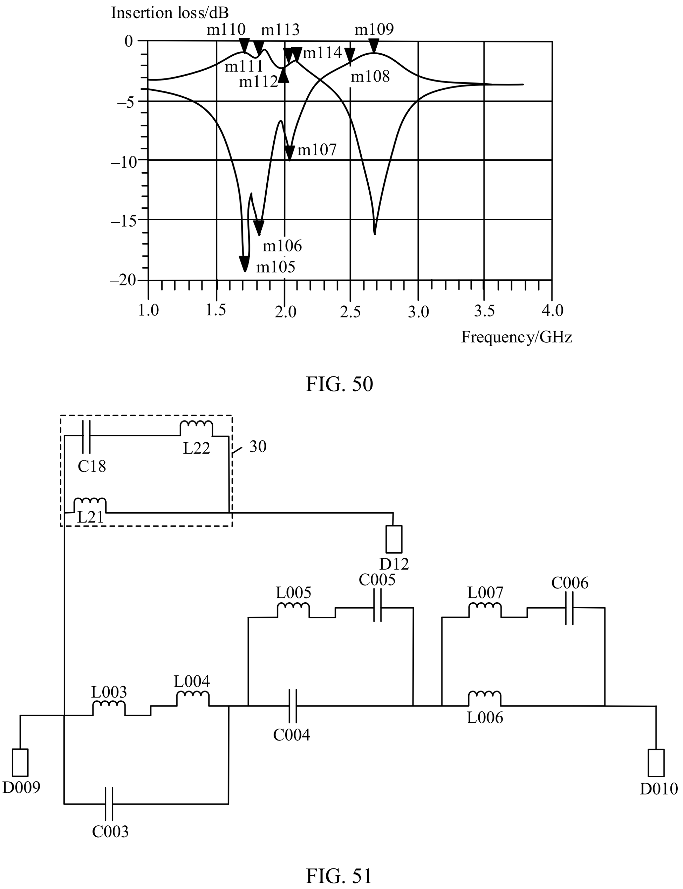

For a schematic diagram of a relationship between an insertion loss and frequency of the combiner in FIG. 49, refer to FIG. 50. As shown in FIG. 50, an insertion loss of the combiner of FIG. 49 at an m105 point, namely at 1.700 GHz is - 19.217 dB. Therefore, an absolute value of the insertion loss at 1.700 GHz is 19.217 dB. An insertion loss at an m106 point, namely at 1.820 GHz is -16.204 dB. Therefore, an absolute value of the insertion loss at 1.820 GHz is 16.204 dB. An insertion loss at an m107 point, namely at 2.050 GHz is -10.028 dB. Therefore, an absolute value of the insertion loss at 2.050 GHz is 10.028 dB. An insertion loss at an m108 point, namely at 2.490 GHz is -2.241 dB. Therefore, an absolute value of the insertion loss at 2.490 GHz is 2.241 dB. An insertion loss at an m109 point, namely at 2.700 GHz is -0.963 dB. Therefore, an absolute value of the insertion loss at 2.700 GHz is 0.963 dB. An insertion loss at an m110 point, namely at 1.710 GHz is -1.262 dB. Therefore, an absolute value of the insertion loss at 1.710 GHz is 1.262 dB. An insertion loss at an m111 point, namely at 1.720 GHz is -1.774 dB. Therefore, an absolute value of the insertion loss at 1.720 GHz is 1.774 dB. An insertion loss at an m112 point, namely at 1.990 GHz is - 2.345 dB. Therefore, an absolute value of the insertion loss at 1.990 GHz is 2.345 dB. An insertion loss at an m113 point, namely at 2.060 GHz is -2.241 dB. Therefore, an absolute value of the insertion loss at 2.060 GHz is 2.241 dB. An insertion loss at an m114 point, namely at 2.170 GHz is -1.529 dB. Therefore, an absolute value of the insertion loss at 2.170 GHz is 1.529 dB.

The foregoing results indicate that, in the combiner, a medium frequency of 1.710 to 2.170 GHz is a passband, and a high frequency of 2.490 to 2.700 GHz is a passband, so that combination can be implemented.
1. The following compares a combiner in FIG. 51 formed by combining the resonance network of FIG. 11 and the twentieth-level resonance network 30 with the combiner provided in FIG. 49 according to this embodiment of this application.

As shown in FIG. 51, a first end of the capacitor C003 is separately electrically connected to a first end of the inductor L003, a first end of the twenty-first inductor L21, a first end of the eighteenth capacitor C18, and the port 009. A second end of the capacitor C003 is separately electrically connected to a second end of the inductor L004, a first end of the capacitor C004, and a first end of the inductor L005. A second end of the inductor L003 is electrically connected to a first end of the inductor L004. A second end of the capacitor C004 is separately electrically connected to a first end of the inductor L006, a second end of the capacitor C005, and a first end of the inductor L007. A second end of the inductor L005 is electrically connected to a first end of the capacitor C005. A second end of the inductor L006 is separately electrically connected to a second end of the capacitor C006 and the port D010. A second end of the inductor L007 is electrically connected to a first end of C006. A second end of the eighteenth capacitor C18 is electrically connected to a first end of the twenty-second inductor L22. A second end of the twenty-first inductor L21 is separately electrically connected to a second end of the twenty-second inductor L22 and the twelfth port D12.

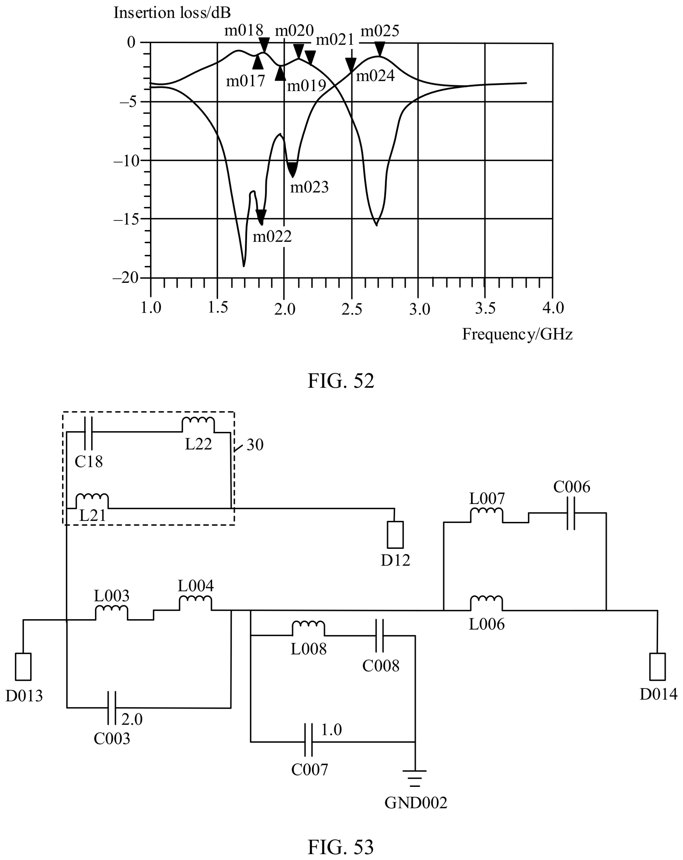

For a schematic diagram of a relationship between an insertion loss and frequency of the combiner in FIG. 51, refer to FIG. 52. As shown in FIG. 52, an insertion loss of the combiner of FIG. 51 at an m017 point, namely at 1.770 GHz is - 1.233 dB. Therefore, an absolute value of the insertion loss at 1.770 GHz is 1.233 dB. An insertion loss at an m018 point, namely at 1.850 GHz is -0.842 dB. Therefore, an absolute value of the insertion loss at 1.850 GHz is 0.842 dB. An insertion loss at an m019 point, namely at 1.980 GHz is -1.995 dB. Therefore, an absolute value of the insertion loss at 1.980 GHz is 1.995 dB. An insertion loss at an m020 point, namely at 2.080 GHz is -1.335 dB. Therefore, an absolute value of the insertion loss at 2.080 GHz is 1.335 dB. An insertion loss at an m021 point, namely at 2.170 GHz is -1.745 dB. Therefore, an absolute value of the insertion loss at 2.170 GHz is 1.745 dB. An insertion loss at an m022 point, namely at 1.820 GHz is -15.100 dB. Therefore, an absolute value of the insertion loss at 1.820 GHz is 15.100 dB. An insertion loss at an m023 point, namely at 2.010 GHz is -11.050 dB. Therefore, an absolute value of the insertion loss at 2.010 GHz is 11.050 dB. An insertion loss at an m024 point, namely at 2.490 GHz is -2.323 dB. Therefore, an absolute value of the insertion loss at 2.490 GHz is 2.323 dB. An insertion loss at an m025 point, namely at 2.700 GHz is -1.357 dB. Therefore, an absolute value of the insertion loss at 2.700 GHz is 1.357 dB.

The foregoing results indicate that, in the combiner, a medium frequency of 1.770 to 2.170 GHz is a passband, and a high frequency of 2.490 to 2.700 GHz is a passband, so that combination can be implemented.

2. The following compares a combiner in FIG. 53 formed by combining the resonance network of FIG. 15 and the twentieth-level resonance network 30 with the combiner provided in FIG. 49 according to this embodiment of this application.

As shown in FIG. 53, a first end of the capacitor C003 is separately electrically connected to a first end of the inductor L003, a first end of the twenty-first inductor L21, a first end of the eighteenth capacitor C18, and the port D013. A second end of the capacitor C003 is separately electrically connected to a first end of the inductor L004, a first end of the inductor L006, a first end of the inductor L007, a first end of the inductor L008, and a first end of the capacitor C007. A second end of the inductor L003 is electrically connected to a first end of the inductor L004. A second end of the inductor L008 is electrically connected to a first end of the capacitor C008. A second end of the capacitor C007 is electrically connected to a second end of the capacitor C008, and is connected to the ground GND002. A second end of the inductor L006 is electrically connected to a second end of the capacitor C006 and the port D014. A second end of the inductor L007 is electrically connected to a first end of the capacitor C006. A second end of the eighteenth capacitor C18 is electrically connected to a first end of the twenty-second inductor L22. A second end of the twenty-first inductor L21 is separately electrically connected to a second end of the twenty-second inductor L22 and the twelfth port D12.

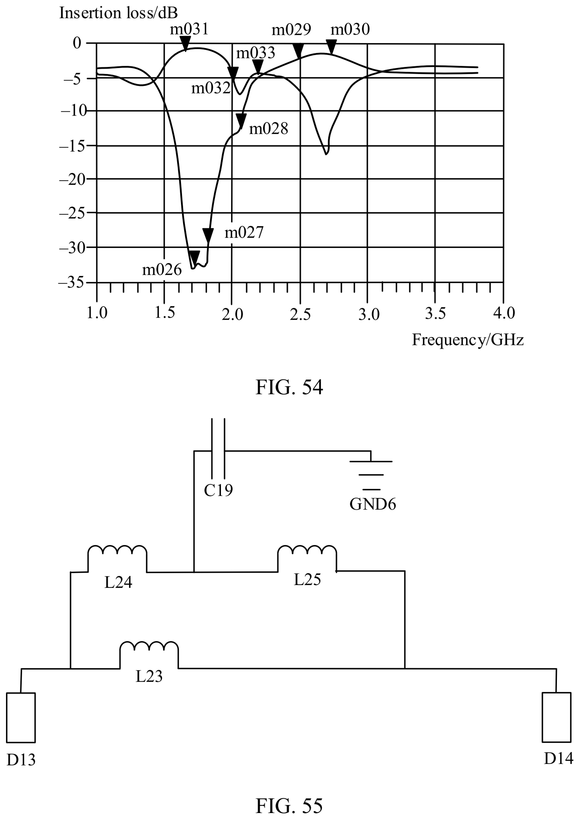

For a schematic diagram of a relationship between an insertion loss and frequency of the combiner in FIG. 53, refer to FIG. 54. As shown in FIG. 54, an insertion loss of the combiner of FIG. 53 at an m026 point, namely at 1.770 GHz is - 33.010 dB. Therefore, an absolute value of the insertion loss at 1.770 GHz is 33.010 dB. An insertion loss at an m027 point, namely at 1.820 GHz is -28.204 dB. Therefore, an absolute value of the insertion loss at 1.820 GHz is 28.204 dB. An insertion loss at an m028 point, namely at 2.050 GHz is -12.050 dB. Therefore, an absolute value of the insertion loss at 2.050 GHz is 12.050 dB. An insertion loss at an m029 point, namely at 2.490 GHz is -2.106 dB. Therefore, an absolute value of the insertion loss at 2.490 GHz is 2.106 dB. An insertion loss at an m030 point, namely at 2.700 GHz is -1.407 dB. Therefore, an absolute value of the insertion loss at 2.700 GHz is 1.407 dB. An insertion loss at an m031 point, namely at 1.710 GHz is -0.696 dB. Therefore, an absolute value of the insertion loss at 1.710 GHz is 0.696 dB. An insertion loss at an m032 point, namely at 2.010 GHz is -5.511 dB. Therefore, an absolute value of the insertion loss at 2.010 GHz is 5.511 dB. An insertion loss at an m033 point, namely at 2.170 GHz is - 4.441 dB. Therefore, an absolute value of the insertion loss at 2.170 GHz is 4.441 dB.

The foregoing results indicate that, in the combiner, a medium frequency of 1.710 to 2.170 GHz is a passband, and a high frequency of 2.490 to 2.700 GHz is a passband, so that combination can be implemented.

In the foregoing Embodiment 9, the following structural deformation may further be performed.

Optionally, the first resonance structure in FIG. 49 may be replaced with the first resonance structure of FIG. 27 or various deformations of the first resonance structure of FIG. 27, a first resonance structure of FIG. 40 or various deformations of the first resonance structure of FIG. 40, a first resonance structure of FIG. 42 or various deformations of the first resonance structure of FIG. 42, or a first resonance structure of FIG. 47 or various deformations of the first resonance structure of FIG. 47, to form different resonance structures.

Certainly, this application is not limited thereto. This is not specifically described one by one herein.

### Embodiment 10

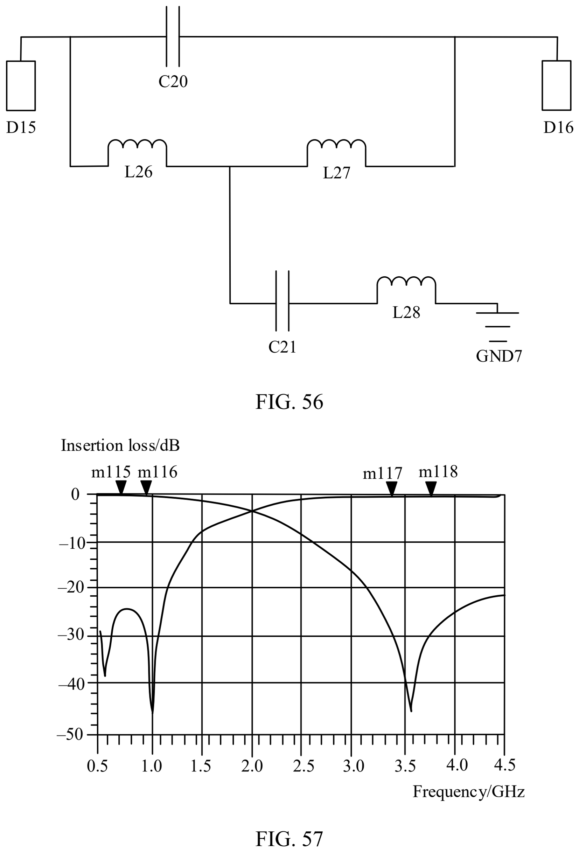

Optionally, as an implementable manner, referring to FIG. 55 and FIG. 56, a case of a combiner according to an embodiment of this application is specifically described. A first resonance structure of FIG. 55 and a first resonance structure of FIG. 56 may be respectively used in any combiner in FIG. 46.

As shown in FIG. 55, the resonance structure includes: a thirteenth port D13, a twenty-third inductor L23, a twenty-fourth inductor L24, a twenty-fifth inductor L25, a nineteenth capacitor C19, a ground GND6, and a fourteenth port D14.

Specifically, as shown in FIG. 55, a first end of the twenty-third inductor L23 is separately electrically connected to a first end of the twenty-fourth inductor L24 and the thirteenth port D13. A second end of the twenty-fourth inductor L24 is separately electrically connected to a first end of the nineteenth capacitor C19 and a first end of the twenty-fifth inductor L25. A second end of the twenty-third inductor L23 is separately electrically connected to a second end of the twenty-fifth inductor L25 and the fourteenth port D14. A second end of the nineteenth capacitor C19 is connected to the ground GND6.

In an actual application, in FIG. 55, an inductance value of the twenty-third inductor L23 may be 5.6 nH. An inductance value of the twenty-fourth inductor L24 may be 22 nH. An inductance value of the twenty-fifth inductor L25 may be 1.8 nH. A capacitance value of the nineteenth capacitor C19 may be 1.2 pF. Certainly, the capacitance value of each capacitor and the inductance value of each inductor are not limited thereto. This is not specifically limited herein.

As shown in FIG. 56, the resonance structure includes: a fifteenth port D15, a twentieth capacitor C20, a twenty-sixth inductor L26, a twenty-seventh inductor L27, a twenty-first capacitor C21, a twenty-eighth inductor L28, a ground GND7, and a sixteenth port D16.

Specifically, as shown in FIG. 56, a first end of the twenty-sixth inductor L26 is separately electrically connected to a first end of the twentieth capacitor C20 and the fifteenth port D15. A second end of the twenty-sixth inductor L26 is separately electrically connected to a first end of the twenty-seventh inductor L27 and a first end of the twenty-first capacitor C21. A second end of the twentieth capacitor C20 is separately electrically connected to a second end of the twenty-seventh inductor L27 and the sixteenth port D16. A second end of the twenty-first capacitor C21 is electrically connected to a first end of the twenty-eighth inductor L28. A second end of the twenty-eighth inductor L28 is connected to the ground GND7.

In an actual application, in FIG. 56, an inductance value of the twenty-sixth inductor L26 may be 68 nH. An inductance value of the twenty-seventh inductor L27 may be 1.8 nH. An inductance value of the twenty-eighth inductor L28 may be 5.6 nH. A capacitance value of the twentieth capacitor C20 may be 1.2 pF. A capacitance value of the twenty-first capacitor C21 may be 3.3 pF. Certainly, the capacitance value of each capacitor and the inductance value of each inductor are not limited thereto. This is not specifically limited herein.

The following specifically describes a relationship between an insertion loss and frequency of the combiner formed in FIG. 55 and FIG. 56.

For a schematic diagram of a relationship between an insertion loss and frequency of the combiner formed in FIG. 55 and FIG. 56, refer to FIG. 57. As shown in FIG. 57, an insertion loss at an m115 point, namely at 0.710 GHz is -0.122 dB. Therefore, an absolute value of the insertion loss at 0.710 GHz is 0.122 dB. An insertion loss at an m116 point, namely at 0.960 GHz is -0.126 dB. Therefore, an absolute value of the insertion loss at 0.960 GHz is 0.126 dB. An insertion loss at an m117 point, namely at 3.300 GHz is -0.113 dB. Therefore, an absolute value of the insertion loss at 3.300 GHz is 0.113 dB. An insertion loss at an m118 point, namely at 3.800 GHz is - 0.073 dB. Therefore, an absolute value of the insertion loss at 3.800 GHz is 0.073 dB.

The foregoing results indicate that, in the combiner, a low frequency of 0.710 to 0.960 GHz is a passband, and a high frequency of 3.300 to 3.800 GHz is a passband, so that combination can be implemented.

### Embodiment 11

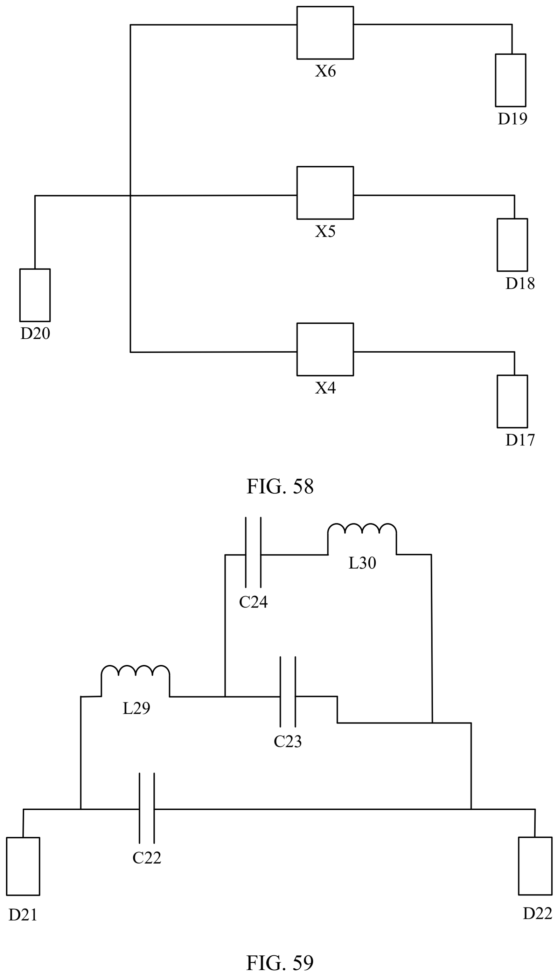

Optionally, as an implementable manner, referring to FIG. 59 to FIG. 61, a case of a combiner according to an embodiment of this application is specifically described.

FIG. 58 shows an application scenario of a combiner in an actual application.

As shown in FIG. 58, a radio frequency system includes a seventeenth port D17, a fourth combiner X4, an eighteenth port D18, a fifth combiner X5, a nineteenth port D19, a sixth combiner X6, and a twentieth port D20. A first end of the fourth combiner X4 is electrically connected to the seventeenth port D17, and a second end is electrically connected to the twentieth port D20. A first end of the fifth combiner X5 is electrically connected to the eighteenth port D18, and a second end is electrically connected to the twentieth port D20. A first end of the sixth combiner X6 is electrically connected to the nineteenth port D19, and a second end is electrically connected to the twentieth port D20. Therefore, the seventeenth port D17, the eighteenth port D18, and the nineteenth port D19 may respectively input signals in different bands to the fourth combiner X4, the fifth combiner X5, and the sixth combiner X6, so as to perform combination.

For example, a passband of the fourth combiner X4 is a low frequency, a passband of the fifth combiner X5 is a medium frequency, and a passband of the sixth combiner X6 is a high frequency. Certainly, this application is not limited thereto. This is not specifically limited herein.

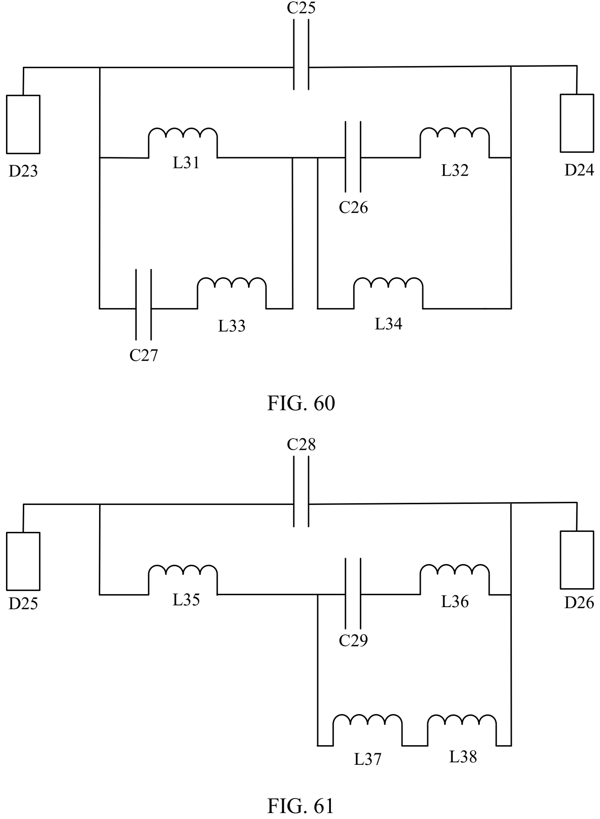

The first resonance structure of FIG. 59, the first resonance structure of FIG. 60, and the first resonance structure of FIG. 61 may be respectively used in any combiner in FIG. 58 depending on a passband of each first resonance structure.

As shown in FIG. 59, the resonance structure includes: a twenty-first port D21, a twenty-second capacitor C22, a twenty-ninth inductor L29, a twenty-third capacitor C23, a twenty-fourth capacitor C24, a thirtieth inductor L30, and a twenty-second port D22.

Specifically, as shown in FIG. 59, a first end of the twenty-second capacitor C22 is separately electrically connected to a first end of the twenty-ninth capacitor L29 and the twenty-first port D21. A second end of the twenty-ninth capacitor L29 is separately electrically connected to a first end of the twenty-third capacitor C23 and a first end of the twenty-fourth capacitor C24. A second end of the twenty-fourth capacitor C24 is electrically connected to a first end of the thirtieth inductor L30. A second end of the twenty-second capacitor C22 is separately electrically connected to a second end of the twenty-third capacitor C23, a second end of the thirtieth inductor L30, and the twenty-second port D22.

In an actual application, an inductance value of the twenty-ninth capacitor L29 in FIG. 59 may be 5.6 nH. An inductance value of the thirtieth capacitor L30 may be 4.3 nH. A capacitance value of the twenty-second capacitor C22 may be 0.3 pF. A capacitance value of the twenty-third capacitor C23 may be 1.8 pF. A capacitance value of the twenty-fourth capacitor C24 may be 3.0 pF. Certainly, the capacitance value of each capacitor and the inductance value of each inductor are not limited thereto. This is not specifically limited herein.

As shown in FIG. 60, the resonance structure includes: a twenty-third port D23, a twenty-fifth capacitor C25, a thirty-first inductor L31, a twenty-sixth capacitor C26, a thirty-second inductor L32, a twenty-seventh capacitor C27, a thirty-third inductor L33, a thirty-fourth inductor L34, and a twenty-fourth port D24.

Specifically, as shown in FIG. 60, a first end of the thirty-first inductor L31 is separately electrically connected to a first end of the twenty-fifth capacitor C25, a first end of the twenty-seventh capacitor C27, and a twenty-third port D23. A second end of the twenty-seventh capacitor C27 is electrically connected to a first end of the thirty-third inductor L33. A second end of the thirty-first inductor L31 is separately electrically connected to a first end of the twenty-sixth capacitor C26, a second end of the thirty-third inductor L33, and a first end of the thirty-fourth inductor L34. A second end of the twenty-sixth capacitor C26 is electrically connected to a first end of the thirty-second inductor L32. A second end of the twenty-fifth capacitor C25 is separately electrically connected to a second end of the thirty-second inductor L32, a second end of the thirty-fourth inductor L34, and the twenty-fourth port D24.

In an actual application, in FIG. 60, an inductance value of the thirty-first inductor L31 may be 22 nH. An inductance value of the thirty-second inductor L32 may be 22 nH. An inductance value of the thirty-third inductor L33 may be 5.6 nH. An inductance value of the thirty-fourth inductor L34 may be 0.6 nH. A capacitance value of the twenty-fifth capacitor C25 may be 0.3 pF. A capacitance value of the twenty-sixth capacitor C26 may be 0.2 pF. A capacitance value of the twenty-seventh capacitor C27 may be 1.0 pF. Certainly, the capacitance value of each capacitor and the inductance value of each inductor are not limited thereto. This is not specifically limited herein.

As shown in FIG. 61, the resonance structure includes: a twenty-fifth port D25, a twenty-eighth capacitor C28, a thirty-fifth inductor L35, a twenty-ninth capacitor C29, a thirty-sixth inductor L36, a thirty-seventh inductor L37, a thirty-eighth inductor L38, and a twenty-sixth port D26.

Specifically, as shown in FIG. 61, a first end of the thirty-fifth inductor L35 is separately electrically connected to a first end of the twenty-eighth capacitor C28 and the twenty-fifth port D25. A second end of the thirty-fifth inductor L35 is separately electrically connected to a first end of the twenty-ninth capacitor C29 and a first end of the thirty-seventh inductor L37. A second end of the twenty-ninth capacitor C29 is electrically connected to a first end of the thirty-sixth inductor L36. A second end of the thirty-seventh inductor L37 is electrically connected to a first end of the thirty-eighth inductor L38. A second end of the twenty-eighth capacitor C28 is separately electrically connected to a second end of the thirty-sixth inductor L36, a second end of the thirty-eighth inductor L38, and the twenty-sixth port D26.

In an actual application, in FIG. 61, an inductance value of the thirty-fifth inductor L35 may be 4.7 nH. An inductance value of the thirty-sixth inductor L36 may be 3.0 nH. An inductance value of the thirty-seventh inductor L37 may be 1.2 nH. An inductance value of the thirty-eighth inductor L38 may be 8.2 nH. A capacitance value of the twenty-eighth capacitor C28 may be 1.8 pF. A capacitance value of the twenty-ninth capacitor C29 may be 1.5 pF. Certainly, the capacitance value of each capacitor and the inductance value of each inductor are not limited thereto. This is not specifically limited herein.

The following specifically describes a relationship between an insertion loss and frequency of the combiner formed in FIG. 59 to FIG. 61.

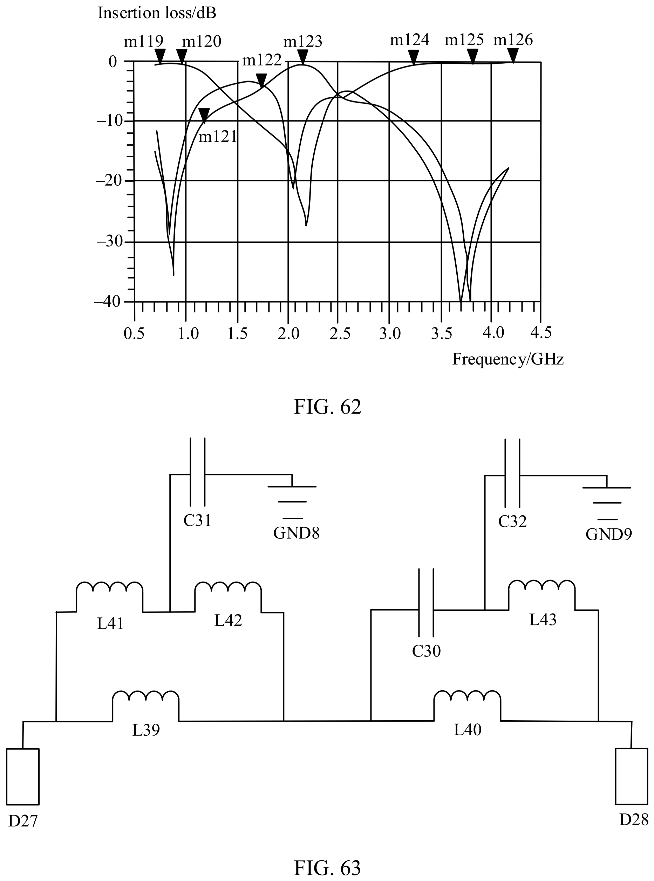

For a schematic diagram of a relationship between an insertion loss and frequency of the combiner formed in FIG. 59 to FIG. 61, refer to FIG. 62. As shown in FIG. 62, an insertion loss at an m119 point, namely at 0.750 GHz is -0.541 dB. Therefore, an absolute value of the insertion loss at 0.750 GHz is 0.541 dB. An insertion loss at an m120 point, namely at 0.960 GHz is -0.582 dB. Therefore, an absolute value of the insertion loss at 0.960 GHz is 0.582 dB. An insertion loss at an m121 point, namely at 1.200 GHz is -10.000 dB. Therefore, an absolute value of the insertion loss at 1.200 GHz is 10.000 dB. An insertion loss at an m122 point, namely at 1.720 GHz is -5.900 dB. Therefore, an absolute value of the insertion loss at 1.720 GHz is 5.900 dB. An insertion loss at an m123 point, namely at 2.150 GHz is -0.999 dB. Therefore, an absolute value of the insertion loss at 2.150 GHz is 0.999 dB. An insertion loss at an m124 point, namely at 3.300 GHz is -0.567 dB. Therefore, an absolute value of the insertion loss at 3.300 GHz is 0.567 dB. An insertion loss at an m125 point, namely at 3.800 GHz is -0.324 dB. Therefore, an absolute value of the insertion loss at 3.800 GHz is 0.324 dB. An insertion loss at an m126 point, namely at 4.200 GHz is -0.651 dB. Therefore, an absolute value of the insertion loss at 4.200 GHz is 0.651 dB.

The foregoing results indicate that, in the combiner, a low frequency of 0.750 to 0.960 GHz is a passband, a medium frequency of 1.200 to 2.150 GHz is a passband, and a high frequency of 3.300 to 4.200 GHz is a passband, so that combination can be implemented.

### Embodiment 12

Optionally, as an implementable manner, referring to FIG. 63 to FIG. 65, a case of a combiner according to an embodiment of this application is specifically described.

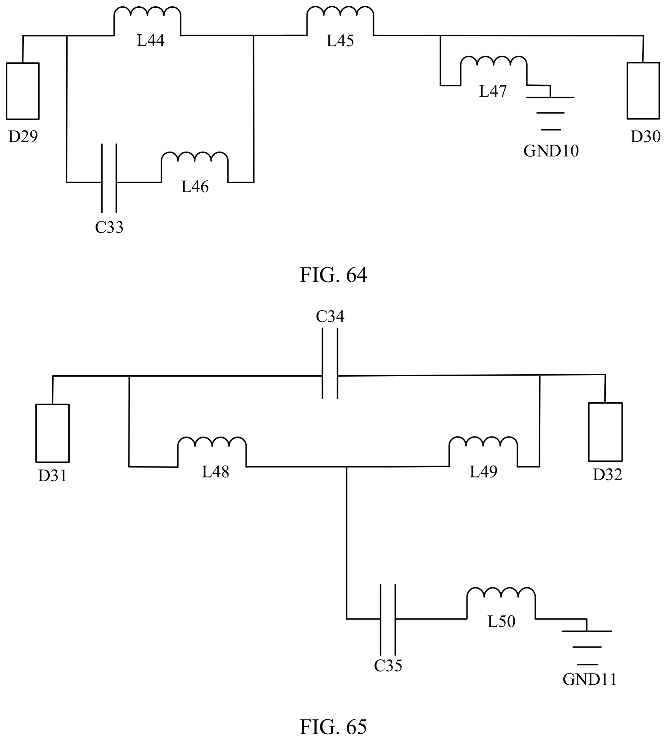

The first resonance structure of FIG. 63, the first resonance structure of FIG. 64, and the first resonance structure of FIG. 65 may be respectively used in any combiner in FIG. 58 depending on a passband of each first resonance structure.

As shown in FIG. 63, the resonance structure includes: a twenty-seventh port D27, a thirty-ninth inductor L39, a fortieth inductor L40, a forty-first inductor L41, a forty-second inductor L42, a forty-third inductor L43, a thirtieth capacitor C30, a thirty-first capacitor C31, a thirty-second capacitor C32, a ground GND8, a ground GND9, and a twenty-eighth port D28.

Specifically, as shown in FIG. 63, a first end of the thirty-ninth inductor L39 is separately electrically connected to a first end of the forty-first inductor L41 and the twenty-seventh port D27. A first end of the forty-first inductor L41 is separately electrically connected to a first end of the forty-second inductor L42 and a first end of the thirty-first capacitor C31. A second end of the thirty-ninth inductor L39 is separately electrically connected to a first end of the fortieth inductor L40, a second end of the forty-second inductor L42, and a first end of the thirtieth capacitor C30. A second end of the thirtieth capacitor C30 is separately electrically connected to a first end of the thirty-second capacitor C32 and a first end of the forty-third inductor L43. A second end of the thirty-first capacitor C31 is connected to the GND8. A second end of the thirty-second capacitor C32 is connected to the GND9. A second end of the fortieth inductor L40 is separately electrically connected to a second end of the forty-third inductor L43 and the twenty-eighth port D28.

In an actual application, in FIG. 63, an inductance value of the thirty-ninth inductor L39 may be 5.5 nH. An inductance value of the fortieth inductor L40 may be 3.0 nH. An inductance value of the forty-first inductor L41 may be 27 nH. An inductance value of the forty-second inductor L42 may be 1.8 nH. An inductance value of the forty-third inductor L43 may be 2.2 nH. A capacitance value of the thirtieth capacitor C30 may be 3.0 pF. A capacitance value of the thirty-first capacitor C31 may be 1.0 pF. A capacitance value of the thirty-second capacitor C32 may be 1.5 pF. Certainly, the capacitance value of each capacitor and the inductance value of each inductor are not limited thereto. This is not specifically limited herein.

As shown in FIG. 64, the resonance structure includes: a twenty-ninth port D29, a thirty-third capacitor C33, a forty-fourth inductor L44, a forty-fifth inductor L45, a forty-sixth inductor L46, a forty-seventh inductor L47, and a thirtieth port D30.

Specifically, as shown in FIG. 64, a first end of the forty-fourth inductor L44 is separately electrically connected to a first end of the thirty-third capacitor C33 and the twenty-ninth port D29. A second end of the thirty-third capacitor C33 is electrically connected to a first end of the forty-sixth inductor L46. A second end of the forty-fourth inductor L44 is separately electrically connected to a first end of the forty-fifth inductor L45 and a second end of the forty-sixth inductor L46. A second end of the forty-fifth inductor L45 is separately electrically connected to a first end of the forty-seventh inductor L47 and the thirtieth port D30. A second end of the forty-seventh inductor L47 is connected to a ground GND10.

In an actual application, in FIG. 64, an inductance value of the forty-fourth inductor L44 may be 22 nH. An inductance value of the forty-fifth inductor L45 may be 8.2 nH. An inductance value of the forty-sixth inductor L46 may be 5.6 nH. An inductance value of the forty-seventh inductor L47 may be 18 nH. A capacitance value of the thirty-third capacitor C33 may be 1.5 pF. Certainly, the capacitance value of each capacitor and the inductance value of each inductor are not limited thereto. This is not specifically limited herein.

As shown in FIG. 65, the resonance structure includes: a thirty-first port D31, a thirty-fourth capacitor C34, a forty-eighth inductor L48, a forty-ninth inductor L49, a thirty-fifth capacitor C35, a fiftieth inductor L50, a ground GND11, and a thirty-second port D32.

Specifically, as shown in FIG. 65, a first end of the forty-eighth inductor L48 is separately electrically connected to a first end of the thirty-fourth capacitor C34 and the thirty-first port D31. A second end of the forty-eighth inductor L48 is separately electrically connected to a first end of the forty-ninth inductor L49 and a first end of the thirty-fifth capacitor C35. A second end of the forty-ninth inductor L49 is separately electrically connected to a second end of the thirty-fourth capacitor C34 and the thirty-second port D32. A second end of the thirty-fifth capacitor C35 is electrically connected to a first end of the fiftieth inductor L50. A second end of the fiftieth inductor L50 is connected to the ground GND11.

In an actual application, in FIG. 65, an inductance value of the forty-eighth inductor L48 may be 68 nH. An inductance value of the forty-ninth inductor L49 may be 1.8 nH. An inductance value of the fiftieth inductor L50 may be 5.6 nH. A capacitance value of the thirty-fourth capacitor C34 may be 1.2 pF. A capacitance value of the thirty-fifth capacitor C35 may be 3.3 pF. Certainly, the capacitance value of each capacitor and the inductance value of each inductor are not limited thereto. This is not specifically limited herein.

The following specifically describes a relationship between an insertion loss and frequency of the combiner formed in FIG. 63 to FIG. 65.

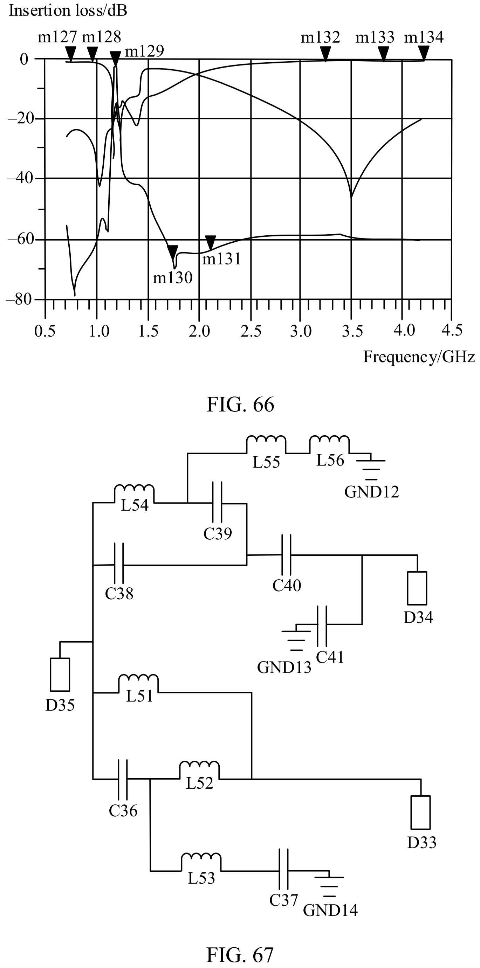

For a schematic diagram of a relationship between an insertion loss and frequency of the combiner formed in FIG. 63 to FIG. 65, refer to FIG. 66. As shown in FIG. 66, an insertion loss at an m127 point, namely at 0.750 GHz is -0.342 dB. Therefore, an absolute value of the insertion loss at 0.750 GHz is 0.342 dB. An insertion loss at an m128 point, namely at 0.960 GHz is -0.462 dB. Therefore, an absolute value of the insertion loss at 0.960 GHz is 0.462 dB. An insertion loss at an m129 point, namely at 1.180 GHz is -1.944 dB. Therefore, an absolute value of the insertion loss at 1.180 GHz is 1.944 dB. An insertion loss at an m130 point, namely at 1.720 GHz is - 69.500 dB. Therefore, an absolute value of the insertion loss at 1.720 GHz is 69.500 dB. An insertion loss at an m131 point, namely at 2.150 GHz is -63.200 dB. Therefore, an absolute value of the insertion loss at 2.150 GHz is 63.200 dB. An insertion loss at an m132 point, namely at 3.300 GHz is -0.159 dB. Therefore, an absolute value of the insertion loss at 3.300 GHz is 0.159 dB. An insertion loss at an m133 point, namely at 3.800 GHz is -0.121 dB. Therefore, an absolute value of the insertion loss at 3.800 GHz is 0.121 dB. An insertion loss at an m134 point, namely at 4.200 GHz is -0.169 dB. Therefore, an absolute value of the insertion loss at 4.200 GHz is 0.169 dB.

The foregoing results indicate that, in the combiner, a low frequency of 0.750 to 0.960 GHz is a passband, a medium frequency of 1.180 to 2.150 GHz is a passband, and a high frequency of 3.300 to 4.200 GHz is a passband, so that combination can be implemented.

### Embodiment 13

Optionally, as an implementable manner, referring to FIG. 67, a case of a combiner according to an embodiment of this application is specifically described.

As shown in FIG. 67, the resonance structure includes: a thirty-third port D33, a fifty-first inductor L51, a thirty-sixth capacitor C36, a fifty-second inductor L52, a fifty-third inductor L53, a thirty-seventh capacitor C37, a ground GND14, a thirty-fourth port D34, a thirty-eighth capacitor C38, a fifty-fourth inductor L54, a thirty-ninth capacitor C39, a fifty-fifth inductor L55, a fifty-sixth inductor L56, a fortieth capacitor C40, a forty-first capacitor C41, and a thirty-fifth port D35.

Specifically, as shown in FIG. 67, a first end of the fifty-first inductor L51 is separately electrically connected to a first end of the thirty-sixth capacitor C36, a first end of the thirty-eighth capacitor C38, a first end of the fifty-fourth inductor L54, and the thirty-fifth port D35. A second end of the thirty-sixth capacitor C36 is separately electrically connected to a first end of the fifty-second inductor L52 and a first end of the fifty-third inductor L53. A second end of the fifty-first inductor L51 is separately electrically connected to a second end of the fifty-second inductor L52 and the thirty-third port D33. A second end of the fifty-third inductor L53 is separately electrically connected to a first end of the thirty-seventh capacitor C37. A second end of the thirty-seventh capacitor C37 is connected to the ground GND14. A second end of the fifty-fourth inductor L54 is separately electrically connected to a first end of the thirty-ninth capacitor C39 and a first end of the fifty-fifth inductor L55. A second end of the thirty-eighth capacitor C38 is separately electrically connected to a second end of the thirty-ninth capacitor C39 and a first end of the fortieth capacitor C40. A second end of the fifty-fifth inductor L55 is electrically connected to a first end of the fifty-sixth inductor L56. A second end of the fifty-sixth inductor L56 is connected to the ground GND12. A second end of the fortieth capacitor C40 is separately electrically connected to a first end of the forty-first capacitor C41 and the thirty-fourth port D34. A second end of the forty-first capacitor C41 is connected to the ground GND13.

In an actual application, in FIG. 67, an inductance value of the fifty-first inductor L51 may be 3.6 nH. An inductance value of the fifty-second inductor L52 may be 3.3 nH. An inductance value of the fifty-third inductor L53 may be 22 nH. An inductance value of the fifty-fourth inductor L54 may be 3.0 nH. An inductance value of the fifty-fifth inductor L55 may be 47 nH. An inductance value of the fifty-sixth inductor L56 may be 22 nH. A capacitance value of the thirty-sixth capacitor C36 may be 1.0 pF. A capacitance value of the thirty-seventh capacitor C37 may be 0.2 pF. A capacitance value of the thirty-eighth capacitor C38 may be 1.8 pF. A capacitance value of the thirty-ninth capacitor C39 may be 3.3 pF. A capacitance value of the fortieth capacitor C40 may be 27 pF. A capacitance value of the forty-first capacitor C41 may be 0.5 pF. Certainly, the capacitance value of each capacitor and the inductance value of each inductor are not limited thereto. This is not specifically limited herein.

The following specifically describes a relationship between an insertion loss and frequency of the combiner of FIG. 67.

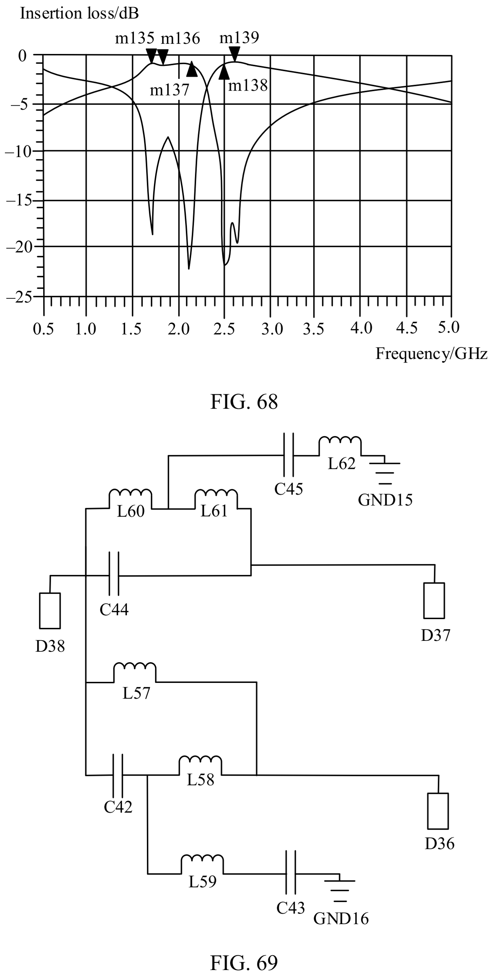

For a schematic diagram of a relationship between an insertion loss and frequency of the combiner of FIG. 67, refer to FIG. 68. As shown in FIG. 68, an insertion loss at an m135 point, namely at 1.709 GHz is -0.582 dB. Therefore, an absolute value of the insertion loss at 1.709 GHz is 0.582 dB. An insertion loss at an m136 point, namely at 1.836 GHz is -0.964 dB. Therefore, an absolute value of the insertion loss at 1.836 GHz is 0.964 dB. An insertion loss at an m137 point, namely at 2.170 GHz is -0.991 dB. Therefore, an absolute value of the insertion loss at 2.170 GHz is 0.991 dB. An insertion loss at an m138 point, namely at 2.495 GHz is -0.892 dB. Therefore, an absolute value of the insertion loss at 2.495 GHz is 0.892 dB. An insertion loss at an m139 point, namely at 2.690 GHz is -0.696 dB. Therefore, an absolute value of the insertion loss at 2.690 GHz is 0.696 dB.

The foregoing results indicate that, in the combiner, a medium frequency of 1.709 to 2.170 GHz is a passband, and a high frequency of 2.495 to 2.690 GHz is a passband, so that combination can be implemented. In addition, in the figure, the fifty-first inductor L51, the thirty-sixth capacitor C36, the fifty-second inductor L52, the fifty-third inductor L53, and the thirty-seventh capacitor C37 can implement suppression of B41. The thirty-fourth port D34, the thirty-eighth capacitor C38, the fifty-fourth inductor L54, the thirty-ninth capacitor C39, the fifty-fifth inductor L55, the fifty-sixth inductor L56, the fortieth capacitor C40, and the forty-first capacitor C41 can implement suppression of MB.

### Embodiment 14

Optionally, as an implementable manner, referring to FIG. 69, a case of a combiner according to an embodiment of this application is specifically described.

As shown in FIG. 69, the resonance structure includes: a thirty-eighth port D38, a fifty-seventh inductor L57, a forty-second capacitor C42, a fifty-eighth inductor L58, a fifty-ninth inductor L59, a forty-third capacitor C43, a ground GND16, a thirty-sixth port D36, a forty-fourth capacitor C44, a sixtieth inductor L60, a sixty-first inductor L61, a forty-fifth capacitor C45, a sixty-second inductor L62, a ground GND15, and a thirty-seventh port D37.

Specifically, as shown in FIG. 69, a first end of the forty-fourth capacitor C44 is separately electrically connected to a first end of the sixtieth inductor L60, a first end of the fifty-seventh inductor L57, a first end of the forty-second capacitor C42, and the thirty-eighth port D38. A second end of the forty-second capacitor C42 is separately electrically connected to a first end of the fifty-eighth inductor L58 and a first end of the fifty-ninth inductor L59. A second end of the fifty-seventh inductor L57 is separately electrically connected to a second end of the fifty-eighth inductor L58 and the thirty-sixth port D36. A second end of the fifty-ninth inductor L59 is electrically connected to a first end of the forty-third capacitor C43. A second end of the forty-third capacitor C43 is connected to the ground GND16. A second end of the sixtieth inductor L60 is separately electrically connected to a first end of the forty-fifth capacitor C45 and a first end of the sixty-first inductor L61. A second end of the forty-fourth capacitor C44 is separately electrically connected to a second end of the sixty-first inductor L61 and the thirty-seventh port D37. A second end of the forty-fifth capacitor C45 is electrically connected to a first end of the sixty-second inductor L62. A second end of the sixty-second inductor L62 is connected to the ground GND15.

In an actual application, in FIG. 69, an inductance value of the fifty-seventh inductor L57 may be 5.6 nH. An inductance value of the fifty-eighth inductor L58 may be 1.3 nH. An inductance value of the fifty-ninth inductor L59 may be 5.6 nH. An inductance value of the sixtieth inductor L60 may be 22 nH. An inductance value of the sixty-first inductor L61 may be 3.0 nH. An inductance value of the sixty-second inductor L62 may be 10 nH. A capacitance value of the forty-second capacitor C42 may be 0.5 pF. A capacitance value of the forty-third capacitor C43 may be 1.2 pF. A capacitance value of the forty-fourth capacitor C44 may be 2.2 pF. A capacitance value of the forty-fifth capacitor C45 may be 1.8 pF. Certainly, the capacitance value of each capacitor and the inductance value of each inductor are not limited thereto. This is not specifically limited herein.

The following specifically describes a relationship between an insertion loss and frequency of the combiner of FIG. 69.

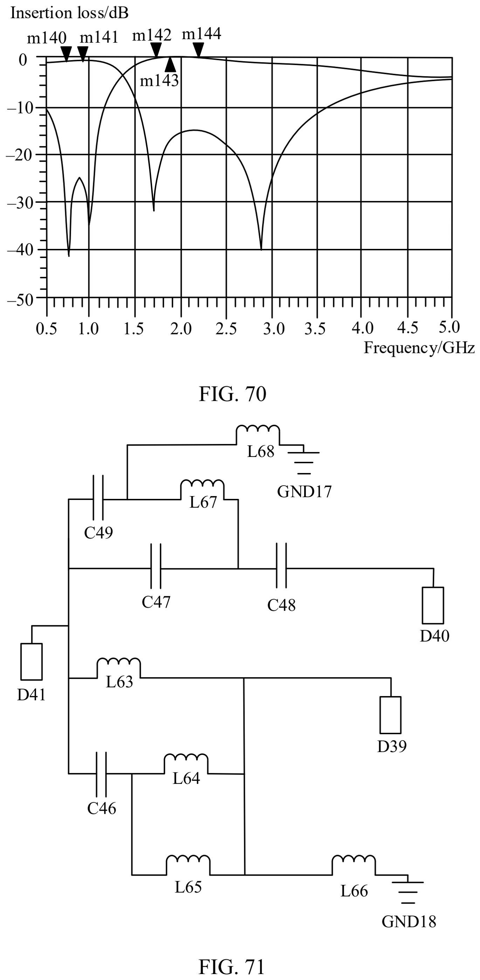

For a schematic diagram of a relationship between an insertion loss and frequency of the combiner of FIG. 69, refer to FIG. 70. As shown in FIG. 70, an insertion loss at an m140 point, namely at 0.710 GHz is -0.198 dB. Therefore, an absolute value of the insertion loss at 0.710 GHz is 0.198 dB. An insertion loss at an m141 point, namely at 0.960 GHz is -0.235 dB. Therefore, an absolute value of the insertion loss at 0.960 GHz is 0.235 dB. An insertion loss at an m142 point, namely at 1.709 GHz is -0.297 dB. Therefore, an absolute value of the insertion loss at 1.709 GHz is 0.297 dB. An insertion loss at an m143 point, namely at 1.836 GHz is -0.295 dB. Therefore, an absolute value of the insertion loss at 1.836 GHz is 0.295 dB. An insertion loss at an m144 point, namely at 2.170 GHz is -0.316 dB. Therefore, an absolute value of the insertion loss at 2.170 GHz is 0.316 dB.

The foregoing results indicate that, in the combiner, a low frequency of 0.710 to 0.960 GHz is a passband, and a medium frequency of 1.709 to 2.170 GHz is a passband, so that combination can be implemented. In addition, in the figure, the forty-fourth capacitor C44, the sixtieth capacitor L60, the sixty-first capacitor L61, the forty-fifth capacitor C45, and the sixty-second capacitor L62 can implement suppression of MLB. The fifty-seventh inductor L57, the forty-second capacitor C42, the fifty-eighth inductor L58, the fifty-ninth inductor L59, and the forty-third capacitor C43 can implement suppression of LB.

### Embodiment 15

Optionally, as an implementable manner, referring to FIG. 71, a case of a combiner according to an embodiment of this application is specifically described.

As shown in FIG. 71, the resonance structure includes: a forty-first port D41, a sixty-third inductor L63, a forty-sixth capacitor C46, a sixty-fourth inductor L64, a sixty-fifth inductor L65, a sixty-sixth inductor L66, a ground GND18, a thirty-ninth port D39, a forty-seventh capacitor C47, a forty-eighth capacitor C48, a forty-ninth capacitor C49, a sixty-seventh inductor L67, a sixty-eighth inductor L68, a ground GND17, and a fortieth port D40.

Specifically, as shown in FIG. 71, a first end of the sixty-third inductor L63 is separately electrically connected to a first end of the forty-seventh capacitor C47, a first end of the forty-ninth capacitor C49, a first end of the forty-sixth capacitor C46, and the forty-first port D41. A second end of the forty-sixth capacitor C46 is separately electrically connected to a first end of the sixty-fourth inductor L64 and a first end of the sixty-fifth inductor L65. A second end of the sixty-third inductor L63 is separately electrically connected to a second end of the sixty-fourth inductor L64, a second end of the sixty-fifth inductor L65, a first end of the sixty-sixth inductor L66, and the thirty-ninth port D39. A second end of the sixty-sixth inductor L66 is connected to the ground GND18. A second end of the forty-ninth capacitor C49 is separately electrically connected to a first end of the sixty-seventh inductor L67 and a first end of the sixty-eighth inductor L68. A second end of the forty-seventh capacitor C47 is separately electrically connected to a second end of the sixty-seventh inductor L67 and a first end of the forty-eighth capacitor C48. A second end of the forty-eighth capacitor C48 is electrically connected to the fortieth port D40. A second end of the sixty-eighth inductor L68 is connected to the GND17.

In an actual application, in FIG. 71, an inductance value of the sixty-third inductor L63 may be 3.0 nH. An inductance value of the sixty-fourth inductor L64 may be 3.0 nH. An inductance value of the sixty-fifth inductor L65 may be 1.0 nH. An inductance value of the sixty-sixth inductor L66 may be 8.2 nH. An inductance value of the sixty-seventh inductor L67 may be 3.0 nH. An inductance value of the sixty-eighth inductor L68 may be 22 nH. A capacitance value of the forty-sixth capacitor C46 may be 3.0 pF. A capacitance value of the forty-seventh capacitor C47 may be 1.8 pF. A capacitance value of the forty-eighth capacitor C48 may be 3.9 pF. A capacitance value of the forty-ninth capacitor C49 may be 8.2 pF. Certainly, the capacitance value of each capacitor and the inductance value of each inductor are not limited thereto. This is not specifically limited herein.

The following specifically describes a relationship between an insertion loss and frequency of the combiner of FIG. 71.

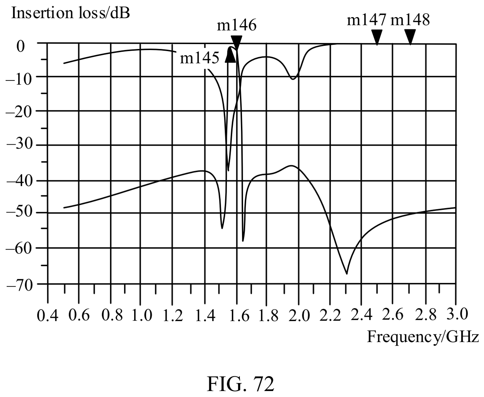

For a schematic diagram of a relationship between an insertion loss and frequency of the combiner of FIG. 71, refer to FIG. 72. As shown in FIG. 72, an insertion loss at an m145 point, namely at 1.570 GHz is -1.137 dB. Therefore, an absolute value of the insertion loss at 1.570 GHz is 1.137 dB. An insertion loss at an m146 point, namely at 1.600 GHz is -1.433 dB. Therefore, an absolute value of the insertion loss at 1.600 GHz is 1.433 dB. An insertion loss at an m147 point, namely at 2.496 GHz is -0.228 dB. Therefore, an absolute value of the insertion loss at 2.496 GHz is 0.228 dB. An insertion loss at an m148 point, namely at 2.690 GHz is -0.228 dB. Therefore, an absolute value of the insertion loss at 2.690 GHz is 0.228 dB.

The foregoing results indicate that, in the combiner, a medium frequency of 1.570 to 1.600 GHz is a passband, and a high frequency of 2.496 to 2.690 GHz is a passband, so that combination can be implemented. In addition, in the figure, the forty-seventh capacitor C47, the forty-eighth capacitor C48, the forty-ninth capacitor C49, the sixty-seventh inductor L67, and the sixty-eighth inductor L68 can implement suppression of a GPS. The sixty-third inductor L63, the forty-sixth capacitor C46, the sixty-fourth inductor L64, the sixty-fifth inductor L65, and the sixty-sixth inductor L66 can implement suppression of B41.

An embodiment of this application further provides an electronic device. The electronic device includes the foregoing radio frequency system.

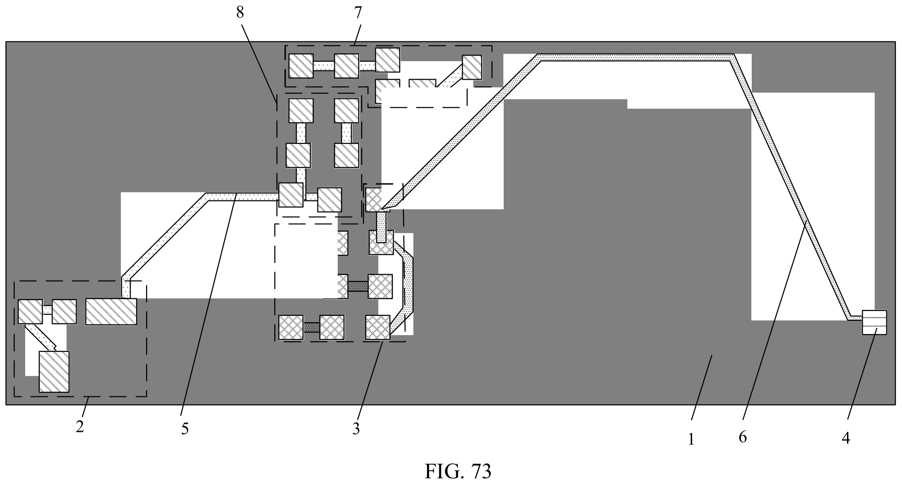

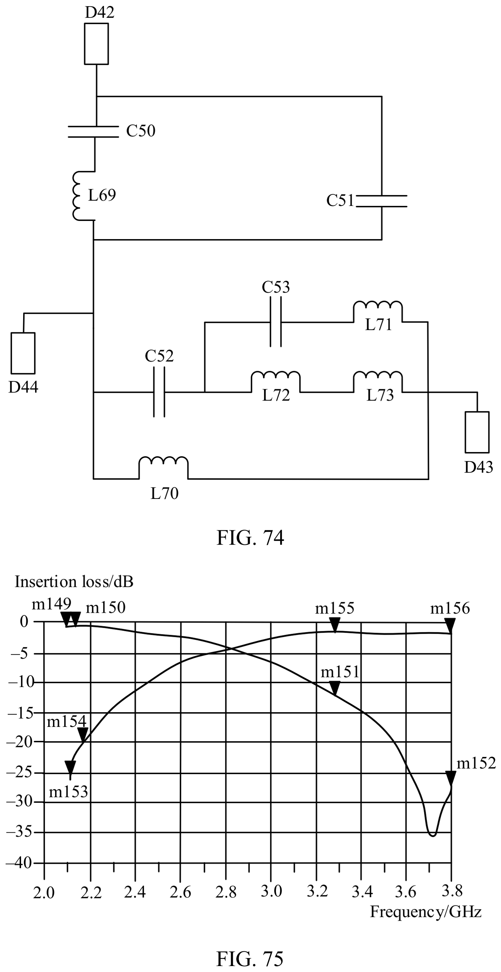

Optionally, as an implementable manner, referring to FIG. 73 and FIG. 74, a case of an electronic device according to an embodiment of this application is specifically described.

As shown in FIG. 73, the electronic device may include: a circuit board 1, and a third filter 2, a seventh combiner 3, and a chip 4 disposed on the circuit board 1. A first end of the seventh combiner 3 is electrically connected to the third filter 2 through a first route 5, and a second end is electrically connected to the chip 4 through a second route 6.

In an actual application, the first route 5 may be a B1 route. The B1 route may have a width of 270 mil and is a surface-layer route. Therefore, there is no hole in the circuit board.

In an actual application, the second route 6 may be an n78 route. The n78 route may have a width of 1050 mil. A width of a surface-layer route in the n78 route may be 350 mil. A width of an inner-layer route may be 700 mil. The inner-layer route needs to provide two via holes in the circuit board to implement an electrical connection.

In an actual application, the foregoing circuit board is not specifically limited. For example, the circuit board may be a PCB (printed circuit boards) or the like.

In an actual application, the foregoing chip is not specifically limited. For example, the chip may be a computing chip, a memory chip, or the like.

It should be noted that the seventh combiner 3 in FIG. 73 is a combiner to which a resonance structure according to an embodiment of this application is applied. For a specific schematic diagram of the resonance structure, refer to FIG. 74.

In addition, FIG. 73 further includes a notch filter 7 in the related technology and an eighth combiner 8 in the related technology. The notch filter 7 and the eighth combiner 8 in the related technology are not described in detail herein again.

### Embodiment 16

As shown in FIG. 74, a fourth combiner in FIG. 74 includes a forty-fourth port D44, a sixty-ninth inductor L69, a fiftieth capacitor C50, a fifty-first capacitor C51, a forty-second port D42, a fifty-second capacitor C52, a seventy inductor L70, a fifty-third capacitor C53, a seventy-first inductor L71, a seventy-second inductor L72, a seventy-third inductor L73, and a forty-third port D43.

Specifically, as shown in FIG. 74, a first end of the fifty-second capacitor C52 is separately electrically connected to a first end of the sixty-ninth inductor L69, a first end of the fifty-first capacitor C51, a first end of the seventieth inductor L70, and the forty-fourth port D44. A second end of the fifty-second capacitor C52 is separately electrically connected to a first end of the seventy-second inductor L72 and a first end of the fifty-third capacitor C53. A second end of the seventy-second inductor L72 is electrically connected to a first end of the seventy-third inductor L73. A second end of the fifty-third capacitor C53 is electrically connected to a first end of the seventy-first inductor L71. A second end of the seventy-first inductor L71 is separately electrically connected to a second end of the seventy-third inductor L73, a second end of the seventieth inductor L70, and the forty-third port D43. A second end of the sixty-ninth inductor L69 is electrically connected to a first end of the fiftieth capacitor C50. A second end of the fiftieth capacitor C50 is separately electrically connected to a second end of the fifty-first capacitor C51 and the forty-second port D42.

For a schematic diagram of a relationship between an insertion loss and frequency of the combiner in FIG. 74, refer to FIG. 75. As shown in FIG. 75, an insertion loss at an m149 point, namely at 2.110 GHz is -0.544 dB. Therefore, an absolute value of the insertion loss at 2.110 GHz is 0.544 dB. An insertion loss at an m150 point, namely at 2.170 GHz is -0.580 dB. Therefore, an absolute value of the insertion loss at 2.170 GHz is 0.580 dB. An insertion loss at an m151 point, namely at 3.300 GHz is -11.792 dB. Therefore, an absolute value of the insertion loss at 3.300 GHz is 11.792 dB. An insertion loss at an m152 point, namely at 3.782 GHz is -28.813 dB. Therefore, an absolute value of the insertion loss at 3.782 GHz is 28.813 dB. An insertion loss at an m153 point, namely at 2.115 GHz is -25.258 dB. Therefore, an absolute value of the insertion loss at 2.115 GHz is 25.258 dB. An insertion loss at an m154 point, namely at 2.170 GHz is -20.319 dB. Therefore, an absolute value of the insertion loss at 2.170 GHz is 20.319 dB. An insertion loss at an m155 point, namely at 3.300 GHz is -5.511 dB. Therefore, an absolute value of the insertion loss at 3.300 GHz is 5.511 dB. An insertion loss at an m156 point, namely at 3.800GHz is -1.767 dB. Therefore, an absolute value of the insertion loss at 3.800GHz is 1.767 dB.

It should be noted that a route insertion loss is excluded. An absolute value of an insertion loss of the combiner in FIG. 74 at an m149 point, namely at 2.110 GHz, is 0.200 dB. An absolute value of an insertion loss at an m156 point, namely at 3.800 GHz, is 0.400 dB.

The foregoing results indicate that, in the combiner, a medium frequency of 2.110 to 2.170 GHz is a passband, and a high frequency of 3.300 to 3.800 GHz is a passband, so that combination can be implemented. Specifically, the seventh combiner 3 in FIG. 73 may pass n78 and suppress B1. The eighth combiner 8 in the related technology in FIG. 73 may pass B1 and suppress n78.

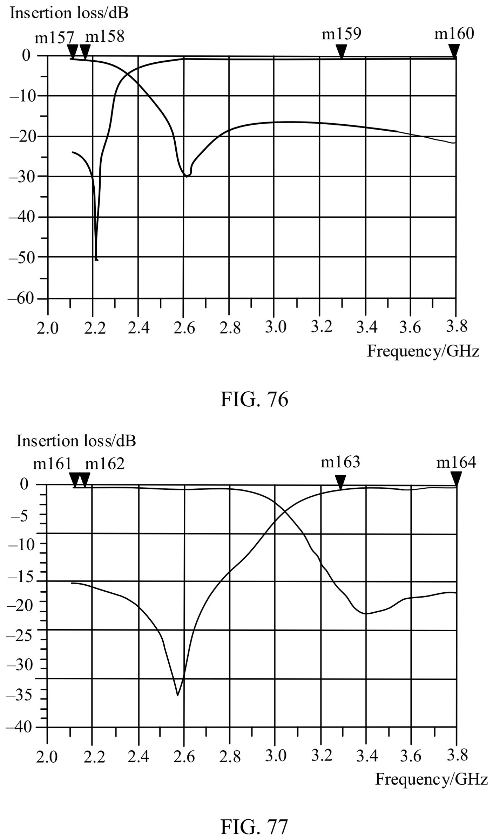

FIG. 76 shows a schematic diagram of a relationship between an insertion loss and frequency of a combiner (a structure of the combiner is not shown in the figure) in the related technology.

As shown in FIG. 76, an insertion loss of the combiner at an m157 point, namely at 2.110 GHz is -0.683 dB. Therefore, an absolute value of the insertion loss at 2.110 GHz is 0.683 dB. An insertion loss at an m158 point, namely at 2.170 GHz is - 0.854 dB. Therefore, an absolute value of the insertion loss at 2.170 GHz is 0.854 dB. An insertion loss at an m159 point, namely at 3.300 GHz is -0.523 dB. Therefore, an absolute value of the insertion loss at 3.300 GHz is 0.523 dB. An insertion loss at an m160 point, namely at 3.800 GHz is -0.605 dB. Therefore, an absolute value of the insertion loss at 3.800 GHz is 0.605 dB.

The foregoing results indicate that because the combiner in the related technology does not have a circuit board route, and the combiner has a large high-frequency insertion loss and a large low-frequency insertion loss, the performance is worse than that of the combiner in FIG. 74 provided in this embodiment of this application.

FIG. 77 shows a schematic diagram of a relationship between an insertion loss and frequency of another combiner (a structure of the combiner is not shown in the figure) in the related technology.

As shown in FIG. 77, an insertion loss of the combiner at an m161 point, namely at 2.110 GHz is -0.319 dB. Therefore, an absolute value of the insertion loss at 2.110 GHz is 0. 319 dB. An insertion loss at an m162 point, namely at 2.170 GHz is - 0.320 dB. Therefore, an absolute value of the insertion loss at 2.170 GHz is 0. 320 dB. An insertion loss at an m163 point, namely at 3.300 GHz is -0.893 dB. Therefore, an absolute value of the insertion loss at 3.300 GHz is 0. 893 dB. An insertion loss at an m164 point, namely at 3.800 GHz is -0.367 dB. Therefore, an absolute value of the insertion loss at 3.800 GHz is 0. 367 dB.

The foregoing results indicate that because the combiner in the related technology does not have a circuit board route, and the combiner has a large high-frequency insertion loss and a large low-frequency insertion loss, the performance is worse than that of the combiner in FIG. 74 provided in this embodiment of this application.

It should be understood that the foregoing descriptions are merely intended to help a person skilled in the art better understand embodiments of this application, but not to limit the scope of embodiments of this application. It is clear that a person skilled in the art may make various equivalent modifications or changes based on the foregoing examples. For example, some steps in various embodiments of the foregoing detection method may be unnecessary, or some steps may be newly added. Alternatively, any two or more of the foregoing embodiments may be combined. A modified, changed, or combined solution also falls within the scope of embodiments of this application.

It should be further understood that the foregoing description of embodiments of this application focuses on highlighting differences between the embodiments. For a same or similar description that is not mentioned, refer to each other. For brevity, details are not described herein again.

It should be further understood that a value of a sequence number of each of the foregoing processes does not mean an order of an execution sequence. The execution sequence of each process should be determined based on a function and internal logic of each process, and should not be construed as any limitation on the implementation processes of embodiments of this application.

It should be further understood that in embodiments of this application, "preset" and "predefined" may be implemented by pre-storing corresponding code, tables, or other forms that may be used to indicate related information in a device (for example, including an electronic device), and a specific implementation thereof is not limited in this application.

It should be further understood that division of manners, cases, types, and embodiments in embodiments of this application are merely for ease of description, but should not constitute a special limitation, and features in various manners, types, cases, and embodiments may be combined when there is no contradiction.

It should be further understood that in embodiments of this application, if there is no specific description and no logical conflict, terms and/or descriptions are consistent and may be mutually referenced between different embodiments, and technical features in different embodiments may be combined based on an internal logical relationship thereof to form a new embodiment.

Finally, it should be noted that the foregoing descriptions are merely specific implementations of this application, but are not intended to limit the protection scope of this application. Any variation or replacement within the technical scope disclosed in this application shall fall within the protection scope of this application. Therefore, the protection scope of this application shall be determined by the protection scope of the claims.

## Claims

1. A resonance structure, comprising at least a first resonance structure, wherein the first resonance structure comprises at least three levels of resonance networks, and the respective levels of resonance networks among the at least three levels of resonance networks are electrically connected in series and/or parallel; and the respective levels of resonance networks influence each other, so that a frequency point and frequency point depth of the first resonance structure are different from a frequency point and frequency point depth of at least one level of resonance network among the respective levels of resonance networks.

2. The resonance structure according to claim 1, wherein the first resonance structure comprises a first-level resonance network, a second-level resonance network, and a third-level resonance network, the first-level resonance network comprises at least a first inductor and a first capacitor connected in parallel, and the second-level resonance network is connected in series to the first inductor or the first capacitor; and
the third-level resonance network is connected in parallel to two ends of the second-level resonance network, the first inductor, or the first capacitor, or is connected in parallel to two ends of the second-level resonance network and the first capacitor connected in series, or is connected in parallel to two ends of the second-level resonance network and the first inductor connected in series.

3. The resonance structure according to claim 1, wherein the first resonance structure comprises four levels of resonance networks, and the respective levels of resonance networks are electrically connected in series and parallel; and the respective levels of resonance networks comprise at least one capacitor and/or inductor.

4. The resonance structure according to claim 3, wherein the first resonance structure comprises a first-level resonance network and a first secondary resonance network;
the first-level resonance network comprises at least a first inductor and a first capacitor connected in parallel; and
the first secondary resonance network comprises a second-level resonance network, a third-level resonance network, and a fourth-level resonance network, and the first secondary resonance network is connected in series to the first inductor or the first capacitor.

5. The resonance structure according to claim 4, wherein the second-level resonance network, the third-level resonance network, and the fourth-level resonance network in the first secondary resonance network are connected in parallel; and
the first secondary resonance network is connected in parallel to the first inductor after being connected in series to the first capacitor.

6. The resonance structure according to claim 5, wherein the second-level resonance network comprises a second inductor and a second capacitor connected in series, the third-level resonance network comprises a third inductor and a third capacitor connected in series, and the fourth-level resonance network comprises a fourth inductor and a fourth capacitor connected in series;
the first resonance structure further comprises a first port and a second port;
a first end of the first capacitor is separately electrically connected to a first end of the first inductor and the first port, and a second end of the first capacitor is separately electrically connected to a first end of the second inductor, a first end of the third inductor, and a first end of the fourth inductor; a second end of the second inductor is electrically connected to a first end of the second capacitor; a second end of the third inductor is electrically connected to a first end of the third capacitor; a second end of the fourth inductor is electrically connected to a first end of the fourth capacitor; and a second end of the first inductor is separately electrically connected to a second end of the second capacitor, a second end of the third capacitor, a second end of the fourth capacitor, and the second port.

7. The resonance structure according to claim 5, wherein the second-level resonance network comprises a second inductor and a second capacitor connected in series, the third-level resonance network comprises a third inductor and a third capacitor connected in series, and the fourth-level resonance network comprises a fourth inductor and a fourth capacitor connected in series;
the first resonance structure further comprises a first port and a second port;
a first end of the first inductor is separately electrically connected to a first end of the first capacitor and the first port, and a second end of the first inductor is separately electrically connected to a first end of the second capacitor, a first end of the third inductor, and a first end of the fourth inductor; a second end of the second capacitor is electrically connected to a first end of the second inductor; a second end of the third inductor is electrically connected to a first end of the third capacitor; a second end of the fourth inductor is electrically connected to a first end of the fourth capacitor; and a second end of the first capacitor is separately electrically connected to a second end of the second inductor, a second end of the third capacitor, a second end of the fourth capacitor, and the second port.

8. The resonance structure according to claim 3, wherein the first resonance structure comprises a fifth-level resonance network and a second secondary resonance network;
the fifth-level resonance network comprises at least a fifth inductor; and
the second secondary resonance network comprises a sixth-level resonance network, a seventh-level resonance network, and an eighth-level resonance network, and the second secondary resonance network is connected in parallel to the fifth inductor.

9. The resonance structure according to claim 8, wherein the fifth-level resonance network comprises a fifth inductor, the sixth-level resonance network comprises a sixth inductor and a sixth capacitor connected in series, the seventh-level resonance network comprises a seventh capacitor and a seventh inductor connected in series, and the eighth-level resonance network comprises an eighth capacitor and an eighth inductor connected in series;
the first resonance structure further comprises a third port and a fourth port;
a first end of the fifth inductor is separately electrically connected to a first end of the sixth capacitor, a first end of the seventh capacitor, and the third port, and a second end of the fifth inductor is separately electrically connected to a second end of the sixth inductor, a second end of the eighth inductor, and the fourth port; a second end of the sixth capacitor is separately electrically connected to a first end of the sixth inductor, a second end of the seventh inductor, and a first end of the eighth capacitor; a second end of the seventh capacitor is electrically connected to a first end of the seventh inductor; and a second end of the eighth capacitor is electrically connected to a first end of the eighth inductor.

10. The resonance structure according to claim 3, wherein the first resonance structure comprises a twelfth-level resonance network and a third secondary resonance network;
the twelfth-level resonance network comprises at least a thirteenth inductor and a fourteenth inductor connected in parallel, or a fifteenth capacitor and a sixteenth capacitor connected in parallel; and
the third secondary resonance network comprises a thirteenth-level resonance network, a fourteenth-level resonance network, and a fifteenth-level resonance network, the third secondary resonance network is connected in series to the thirteenth inductor or the fourteenth inductor, or the third secondary resonance network is connected in series to the fifteenth capacitor or the sixteenth capacitor.

11. The resonance structure according to claim 10, wherein the twelfth-level resonance network comprises a thirteenth inductor and a fourteenth inductor connected in parallel, the thirteenth-level resonance network comprises a fifteenth inductor, the fourteenth-level resonance network comprises a sixteenth inductor and a seventeenth inductor connected in series, and the fifteenth-level resonance network comprises a thirteenth capacitor and a fourteenth capacitor connected in series;
the first resonance structure further comprises a fifth port and a sixth port;
a first end of the fourteenth inductor is separately electrically connected to a first end of the thirteenth inductor and the fifth port, and a second end of the fourteenth inductor is separately electrically connected to a first end of the fifteenth inductor and a first end of the sixteenth inductor; a second end of the sixteenth inductor is separately electrically connected to a first end of the seventeenth inductor and a first end of the thirteenth capacitor; a second end of the thirteenth capacitor is electrically connected to a first end of the fourteenth capacitor, and a second end of the fourteenth capacitor is connected to a ground; and a second end of the seventeenth inductor is separately electrically connected to a second end of the fifteenth inductor, a second end of the thirteenth inductor, and the sixth port.

12. The resonance structure according to claim 10, wherein the twelfth-level resonance network comprises a fifteenth capacitor and a sixteenth capacitor connected in parallel, the thirteenth-level resonance network comprises an eighteenth inductor, the fourteenth-level resonance network comprises a nineteenth inductor and a twentieth inductor connected in series, and the fifteenth-level resonance network comprises a seventeenth capacitor;
the first resonance structure further comprises a fifth port and a sixth port;
a first end of the sixteenth capacitor is separately electrically connected to a first end of the fifteenth capacitor and the fifth port, and a second end of the sixteenth capacitor is separately electrically connected to a first end of the eighteenth inductor and a first end of the nineteenth inductor; a second end of the nineteenth inductor is separately electrically connected to a first end of the twentieth inductor and a first end of the seventeenth capacitor; a second end of the seventeenth capacitor is connected to a ground; and a second end of the twentieth inductor is separately electrically connected to a second end of the eighteenth inductor, a second end of the fifteenth capacitor, and the sixth port.

13. The resonance structure according to any one of claims 1 to 12, wherein the resonance structure further comprises a second resonance structure, the second resonance structure is electrically connected to the first resonance structure in series and/or parallel, and the second resonance structure and the first resonance structure do not influence each other.

14. The resonance structure according to claim 13, wherein the second resonance structure comprises a ninth-level resonance network, and the ninth-level resonance network is connected in parallel to the first resonance structure;
the ninth-level resonance network comprises a ninth capacitor and a ninth inductor connected in series;
the first resonance structure comprises a fifth-level resonance network, a sixth-level resonance network, a seventh-level resonance network, and an eighth-level resonance network, the fifth-level resonance network comprises a fifth inductor, the sixth-level resonance network comprises a sixth inductor and a sixth capacitor connected in series, the seventh-level resonance network comprises a seventh capacitor and a seventh inductor connected in series, and the eighth-level resonance network comprises an eighth capacitor and an eighth inductor connected in series; the first resonance structure further comprises a third port and a fourth port;
a first end of the fifth inductor is separately electrically connected to a first end of the sixth capacitor, a first end of the seventh capacitor, a first end of the ninth capacitor, and the third port, and a second end of the fifth inductor is separately electrically connected to a second end of the sixth inductor, a second end of the eighth inductor, and the fourth port; a second end of the sixth capacitor is separately electrically connected to a first end of the sixth inductor, a second end of the seventh inductor, and a first end of the eighth capacitor; a second end of the seventh capacitor is electrically connected to a first end of the seventh inductor; a second end of the eighth capacitor is electrically connected to a first end of the eighth inductor; and a second end of the ninth capacitor is electrically connected to a first end of the ninth inductor, and a second end of the ninth inductor is connected to a ground.

15. The resonance structure according to claim 13, wherein the second resonance structure comprises a tenth-level resonance network, and the tenth-level resonance network is connected in parallel to the first resonance structure;
the tenth-level resonance network comprises a tenth capacitor, an eleventh capacitor, and a tenth inductor, and the eleventh capacitor is connected in parallel to the tenth inductor and is connected in series to the tenth capacitor;
the first resonance structure comprises a fifth-level resonance network, a sixth-level resonance network, a seventh-level resonance network, and an eighth-level resonance network, the fifth-level resonance network comprises a fifth inductor, the sixth-level resonance network comprises a sixth inductor and a sixth capacitor connected in series, the seventh-level resonance network comprises a seventh capacitor and a seventh inductor connected in series, and the eighth-level resonance network comprises an eighth capacitor and an eighth inductor connected in series; the first resonance structure further comprises a third port and a fourth port;
a first end of the fifth inductor is separately electrically connected to a first end of the sixth capacitor, a first end of the seventh capacitor, a first end of the tenth capacitor, and the third port, and a second end of the fifth inductor is separately electrically connected to a second end of the sixth inductor, a second end of the eighth inductor, and the fourth port; a second end of the sixth capacitor is separately electrically connected to a first end of the sixth inductor, a second end of the seventh inductor, and a first end of the eighth capacitor; a second end of the seventh capacitor is electrically connected to a first end of the seventh inductor; a second end of the eighth capacitor is electrically connected to a first end of the eighth inductor; and a second end of the tenth capacitor is separately electrically connected to a first end of the eleventh capacitor and a first end of the tenth inductor, and a second end of the eleventh capacitor is electrically connected to a second end of the tenth inductor and is connected to a ground.

16. The resonance structure according to claim 13, wherein the second resonance structure comprises an eleventh-level resonance network, and the eleventh-level resonance network is connected in parallel to the first resonance structure;
the eleventh-level resonance network comprises a twelfth capacitor, an eleventh inductor, and a twelfth inductor, and the eleventh inductor is connected in parallel to the twelfth inductor and is connected in series to the twelfth capacitor;
the first resonance structure comprises a fifth-level resonance network, a sixth-level resonance network, a seventh-level resonance network, and an eighth-level resonance network, the fifth-level resonance network comprises a fifth inductor, the sixth-level resonance network comprises a sixth inductor and a sixth capacitor connected in series, the seventh-level resonance network comprises a seventh capacitor and a seventh inductor connected in series, and the eighth-level resonance network comprises an eighth capacitor and an eighth inductor connected in series; the first resonance structure further comprises a third port and a fourth port;
a first end of the fifth inductor is separately electrically connected to a first end of the sixth capacitor, a first end of the seventh inductor, a first end of the twelfth capacitor, and the third port, and a second end of the fifth inductor is separately electrically connected to a second end of the sixth inductor, a second end of the eighth inductor, and the fourth port; a second end of the sixth capacitor is separately electrically connected to a first end of the sixth inductor, a second end of the seventh capacitor, and a first end of the eighth capacitor; a second end of the seventh inductor is electrically connected to a first end of the seventh capacitor; a second end of the eighth capacitor is electrically connected to a first end of the eighth inductor; and a second end of the twelfth capacitor is separately electrically connected to a first end of the eleventh inductor and a first end of the twelfth inductor, and a second end of the eleventh inductor is electrically connected to a second end of the twelfth inductor and is connected to a ground.

17. A radio frequency system, comprising at least one of a filter, a combiner, a notch filter, a duplexer, and a multiplexer, wherein the filter, the combiner, the notch filter, the duplexer, or the multiplexer comprises the resonance structure according to any one of claims 1 to 16.

18. The radio frequency system according to claim 17, wherein the radio frequency system comprises a combiner, the combiner comprises at least two resonance structures, and the at least two resonance structures are configured to combine at least two signals.

19. The radio frequency system according to claim 18, wherein the combiner comprises a twentieth-level resonance network and a first resonance structure connected in parallel;
the twentieth-level resonance network comprises a twenty-first inductor, an eighteenth capacitor, a twenty-second inductor, and a twelfth port, and the eighteenth capacitor is connected in series to the twenty-second inductor and is connected in parallel to the twenty-first inductor;
the first resonance structure comprises a first-level resonance network, a second-level resonance network, a third-level resonance network, and a fourth-level resonance network, the first-level resonance network comprises a first inductor and a first capacitor connected in parallel, the second-level resonance network comprises a second inductor and a second capacitor connected in series, the third-level resonance network comprises a third inductor and a third capacitor connected in series, and the fourth-level resonance network comprises a fourth inductor and a fourth capacitor connected in series; the first resonance structure further comprises a first port and a second port;
a first end of the first capacitor is separately electrically connected to a first end of the first inductor, a first end of the twenty-first inductor, a first end of the eighteenth capacitor, and the first port, and a second end of the first capacitor is separately electrically connected to a first end of the second inductor, a first end of the third inductor, and a first end of the fourth inductor; a second end of the second inductor is electrically connected to a first end of the second capacitor; a second end of the third inductor is electrically connected to a first end of the third capacitor; a second end of the fourth inductor is electrically connected to a first end of the fourth capacitor; a second end of the first inductor is separately electrically connected to a second end of the second capacitor, a second end of the third capacitor, a second end of the fourth capacitor, and the second port; and a second end of the eighteenth capacitor is electrically connected to a first end of the twenty-second inductor, and a second end of the twenty-first inductor is separately electrically connected to a second end of the twenty-second inductor and the twelfth port.

20. The radio frequency system according to claim 18, wherein the combiner comprises a thirty-third port, a fifty-first inductor, a thirty-sixth capacitor, a fifty-second inductor, a fifty-third inductor, a thirty-seventh capacitor, a thirty-fourth port, a thirty-eighth capacitor, a fifty-fourth inductor, a thirty-ninth capacitor, a fifty-fifth inductor, a fifty-sixth inductor, a fortieth capacitor, a forty-first capacitor, and a thirty-fifth port;
a first end of the fifty-first inductor is separately electrically connected to a first end of the thirty-sixth capacitor, a first end of the thirty-eighth capacitor, a first end of the fifty-fourth inductor, and the thirty-fifth port, a second end of the thirty-sixth capacitor is separately electrically connected to a first end of the fifty-second inductor and a first end of the fifty-third inductor, a second end of the fifty-first inductor is separately electrically connected to a second end of the fifty-second inductor and the thirty-third port, a second end of the fifty-third inductor is separately electrically connected to a first end of the thirty-seventh capacitor, and a second end of the thirty-seventh capacitor is connected to a ground; a second end of the fifty-fourth inductor is separately electrically connected to a first end of the thirty-ninth capacitor and a first end of the fifty-fifth inductor, and a second end of the thirty-eighth capacitor is separately electrically connected to a second end of the thirty-ninth capacitor and a first end of the fortieth capacitor; a second end of the fifty-fifth inductor is electrically connected to a first end of the fifty-sixth inductor, and a second end of the fifty-sixth inductor is connected to a ground; a second end of the fortieth capacitor is separately electrically connected to a first end of the forty-first capacitor and the thirty-fourth port; and a second end of the forty-first capacitor is connected to a ground.

21. The radio frequency system according to claim 18, wherein the combiner comprises a thirty-eighth port, a fifty-seventh inductor, a forty-second capacitor, a fifty-eighth inductor, a fifty-ninth inductor, a forty-third capacitor, a thirty-sixth port, a forty-fourth capacitor, a sixtieth inductor, a sixty-first inductor, a forty-fifth capacitor, a sixty-second inductor, and a thirty-seventh port;
a first end of the forty-fourth capacitor is separately electrically connected to a first end of the sixtieth inductor, a first end of the fifty-seventh inductor, a first end of the forty-second capacitor, and the thirty-eighth port, a second end of the forty-second capacitor is separately electrically connected to a first end of the fifty-eighth inductor and a first end of the fifty-ninth inductor, and a second end of the fifty-seventh inductor is separately electrically connected to a second end of the fifty-eighth inductor and the thirty-sixth port; a second end of the fifty-ninth inductor is electrically connected to a first end of the forty-third capacitor, and a second end of the forty-third capacitor is connected to a ground; and a second end of the sixtieth inductor is separately electrically connected to a first end of the forty-fifth capacitor and a first end of the sixty-first inductor, a second end of the forty-fourth capacitor is separately electrically connected to a second end of the sixty-first inductor and the thirty-seventh port, a second end of the forty-fifth capacitor is electrically connected to a first end of the sixty-second inductor, and a second end of the sixty-second inductor is connected to a ground.

22. The radio frequency system according to claim 18, wherein the combiner comprises a forty-first port, a sixty-third inductor, a forty-sixth capacitor, a sixty-fourth inductor, a sixty-fifth inductor, a sixty-sixth inductor, a thirty-ninth port, a forty-seventh capacitor, a forty-eighth capacitor, a forty-ninth capacitor, a sixty-seventh inductor, a sixty-eighth inductor, and a fortieth port;
a first end of the sixty-third inductor is separately electrically connected to a first end of the forty-seventh capacitor, a first end of the forty-ninth capacitor, a first end of the forty-sixth capacitor, and the forty-first port, a second end of the forty-sixth capacitor is separately electrically connected to a first end of the sixty-fourth inductor and a first end of the sixty-fifth inductor, and a second end of the sixty-third inductor is separately electrically connected to a second end of the sixty-fourth inductor, a second end of the sixty-fifth inductor, a first end of the sixty-sixth inductor, and the thirty-ninth port; a second end of the sixty-sixth inductor is connected to a ground; a second end of the forty-ninth capacitor is separately electrically connected to a first end of the sixty-seventh inductor and a first end of the sixty-eighth inductor, a second end of the forty-seventh capacitor is separately electrically connected to a second end of the sixty-seventh inductor and a first end of the forty-eighth capacitor, and a second end of the forty-eighth capacitor is electrically connected to the fortieth port; and a second end of the sixty-eighth inductor is connected to a ground.

23. The radio frequency system according to claim 18, wherein the combiner comprises a forty-fourth port, a sixty-ninth inductor, a fiftieth capacitor, a fifty-first capacitor, a forty-second port, a fifty-second capacitor, a seventieth inductor, a fifty-third capacitor, a seventy-first inductor, a seventy-second inductor, a seventy-third inductor, and a forty-third port;
a first end of the fifty-second capacitor is separately electrically connected to a first end of the sixty-ninth inductor, a first end of the fifty-first capacitor, a first end of the seventieth inductor, and the forty-fourth port, and a second end of the fifty-second capacitor is separately electrically connected to a first end of the seventy-second inductor and a first end of the fifty-third capacitor; a second end of the seventy-second inductor is electrically connected to a first end of the seventy-third inductor; a second end of the fifty-third capacitor is electrically connected to a first end of the seventy-first inductor; a second end of the seventy-first inductor is separately electrically connected to a second end of the seventy-third inductor, a second end of the seventieth inductor, and the forty-third port; a second end of the sixty-ninth inductor is electrically connected to a first end of the fiftieth capacitor, and a second end of the fiftieth capacitor is separately electrically connected to a second end of the fifty-first capacitor and the forty-second port; and two ports are configured to input a signal, and a port is configured to output a signal.

24. An electronic device, comprising the radio frequency system according to any one of claims 17 to 23.

25. A resonance structure, comprising at least a first resonance structure, wherein the first resonance structure comprises at least three levels of resonance networks, and the respective levels of resonance networks among the at least three levels of resonance networks are electrically connected in series and/or parallel; the respective levels of resonance networks influence each other, so that a frequency point and frequency point depth of the first resonance structure are different from a frequency point and frequency point depth of at least one level of resonance network among the respective levels of resonance networks; the first resonance structure comprises four levels of resonance networks, and the respective levels of resonance networks are electrically connected in series and parallel; the respective levels of resonance networks comprise at least one capacitor and/or inductor;
the first resonance structure comprises a first-level resonance network and a first secondary resonance network, the first-level resonance network comprises at least a first inductor and/or a first capacitor connected in parallel, the first secondary resonance network comprises a second-level resonance network, a third-level resonance network, and a fourth-level resonance network, the first secondary resonance network is connected in series to the first inductor or the first capacitor, and the second-level resonance network, the third-level resonance network, and the fourth-level resonance network in the first secondary resonance network are connected in parallel; when the first-level resonance network comprises at least a first inductor and a first capacitor connected in parallel, the first secondary resonance network is connected in parallel to the first inductor after being connected in series to the first capacitor, the second-level resonance network comprises a second inductor and a second capacitor connected in series, the third-level resonance network comprises a third inductor and a third capacitor connected in series, the fourth-level resonance network comprises a fourth inductor and a fourth capacitor connected in series, the first resonance structure further comprises a first port and a second port, a first end of the first capacitor is separately electrically connected to a first end of the first inductor and the first port, a second end of the first capacitor is separately electrically connected to a first end of the second inductor, a first end of the third inductor, and a first end of the fourth inductor, a second end of the second inductor is electrically connected to a first end of the second capacitor, a second end of the third inductor is electrically connected to a first end of the third capacitor, a second end of the fourth inductor is electrically connected to a first end of the fourth capacitor, and a second end of the first inductor is separately electrically connected to a second end of the second capacitor, a second end of the third capacitor, a second end of the fourth capacitor, and the second port;
or, the first resonance structure comprises a first-level resonance network and a first secondary resonance network, the first-level resonance network comprises at least a first inductor and/or a first capacitor connected in parallel, the first secondary resonance network comprises a second-level resonance network, a third-level resonance network, and a fourth-level resonance network, the first secondary resonance network is connected in series to the first inductor or the first capacitor, and the second-level resonance network, the third-level resonance network, and the fourth-level resonance network in the first secondary resonance network are connected in parallel; when the first-level resonance network comprises at least a first inductor and a first capacitor connected in parallel, the first secondary resonance network is connected in parallel to the first capacitor after being connected in series to the first inductor, the second-level resonance network comprises a second inductor and a second capacitor connected in series, the third-level resonance network comprises a third inductor and a third capacitor connected in series, the fourth-level resonance network comprises a fourth inductor and a fourth capacitor connected in series, the first resonance structure further comprises a first port and a second port, a first end of the first inductor is separately electrically connected to a first end of the first capacitor and the first port, a second end of the first inductor is separately electrically connected to a first end of the second capacitor, a first end of the third inductor, and a first end of the fourth inductor, a second end of the second capacitor is electrically connected to a first end of the second inductor, a second end of the third inductor is electrically connected to a first end of the third capacitor, a second end of the fourth inductor is electrically connected to a first end of the fourth capacitor, and a second end of the first capacitor is separately electrically connected to a second end of the second inductor, a second end of the third capacitor, a second end of the fourth capacitor, and the second port;
or, the first resonance structure comprises a fifth-level resonance network and a second secondary resonance network, the fifth-level resonance network comprises at least a fifth inductor, the second secondary resonance network comprises a sixth-level resonance network, a seventh-level resonance network, and an eighth-level resonance network, the second secondary resonance network is connected in parallel to the fifth inductor, the fifth-level resonance network comprises a fifth inductor, the sixth-level resonance network comprises a sixth inductor and a sixth capacitor connected in series, the seventh-level resonance network comprises a seventh capacitor and a seventh inductor connected in series, the eighth-level resonance network comprises an eighth capacitor and an eighth inductor connected in series, the first resonance structure further comprises a third port and a fourth port, a first end of the fifth inductor is separately electrically connected to a first end of the sixth capacitor, a first end of the seventh capacitor, and the third port, a second end of the fifth inductor is separately electrically connected to a second end of the sixth inductor, a second end of the eighth inductor, and the fourth port, a second end of the sixth capacitor is separately electrically connected to a first end of the sixth inductor, a second end of the seventh inductor, and a first end of the eighth capacitor, a second end of the seventh capacitor is electrically connected to a first end of the seventh inductor, and a second end of the eighth capacitor is electrically connected to a first end of the eighth inductor.

26. The resonance structure according to claim 25, wherein the first resonance structure comprises a twelfth-level resonance network and a third secondary resonance network, the twelfth-level resonance network comprises at least a thirteenth inductor and a fourteenth inductor connected in parallel, the third secondary resonance network comprises a thirteenth-level resonance network, a fourteenth-level resonance network, and a fifteenth-level resonance network, the third secondary resonance network is connected in series to the thirteenth inductor or the fourteenth inductor, the thirteenth-level resonance network comprises a fifteenth inductor, the fourteenth-level resonance network comprises a sixteenth inductor and a seventeenth inductor connected in series, and the fifteenth-level resonance network comprises a thirteenth capacitor and a fourteenth capacitor connected in series;
the first resonance structure further comprises a fifth port and a sixth port;
a first end of the fourteenth inductor is separately electrically connected to a first end of the thirteenth inductor and the fifth port, and a second end of the fourteenth inductor is separately electrically connected to a first end of the fifteenth inductor and a first end of the sixteenth inductor; a second end of the sixteenth inductor is separately electrically connected to a first end of the seventeenth inductor and a first end of the thirteenth capacitor; a second end of the thirteenth capacitor is electrically connected to a first end of the fourteenth capacitor, and a second end of the fourteenth capacitor is connected to a ground; and a second end of the seventeenth inductor is separately electrically connected to a second end of the fifteenth inductor, a second end of the thirteenth inductor, and the sixth port.

27. The resonance structure according to claim 25, wherein the first resonance structure comprises a twelfth-level resonance network and a third secondary resonance network, the twelfth-level resonance network comprises at least a fifteenth capacitor and a sixteenth capacitor connected in parallel, the third secondary resonance network comprises a thirteenth-level resonance network, a fourteenth-level resonance network, and a fifteenth-level resonance network, the third secondary resonance network is connected in series to the fifteenth capacitor or the sixteenth capacitor, the thirteenth-level resonance network comprises an eighteenth inductor, the fourteenth-level resonance network comprises a nineteenth inductor and a twentieth inductor connected in series, and the fifteenth-level resonance network comprises a seventeenth capacitor;
the first resonance structure further comprises a fifth port and a sixth port;
a first end of the sixteenth capacitor is separately electrically connected to a first end of the fifteenth capacitor and the fifth port, and a second end of the sixteenth capacitor is separately electrically connected to a first end of the eighteenth inductor and a first end of the nineteenth inductor; a second end of the nineteenth inductor is separately electrically connected to a first end of the twentieth inductor and a first end of the seventeenth capacitor; a second end of the seventeenth capacitor is connected to a ground; and a second end of the twentieth inductor is separately electrically connected to a second end of the eighteenth inductor, a second end of the fifteenth capacitor, and the sixth port.

28. The resonance structure according to any one of claims 25 to 27, wherein the resonance structure further comprises a second resonance structure, the second resonance structure is electrically connected to the first resonance structure in series and/or parallel, and the second resonance structure and the first resonance structure do not influence each other.

29. The resonance structure according to claim 28, wherein the second resonance structure comprises a ninth-level resonance network, and the ninth-level resonance network is connected in parallel to the first resonance structure;
the ninth-level resonance network comprises a ninth capacitor and a ninth inductor connected in series;
the first resonance structure comprises a fifth-level resonance network, a sixth-level resonance network, a seventh-level resonance network, and an eighth-level resonance network, the fifth-level resonance network comprises a fifth inductor, the sixth-level resonance network comprises a sixth inductor and a sixth capacitor connected in series, the seventh-level resonance network comprises a seventh capacitor and a seventh inductor connected in series, and the eighth-level resonance network comprises an eighth capacitor and an eighth inductor connected in series; the first resonance structure further comprises a third port and a fourth port;
a first end of the fifth inductor is separately electrically connected to a first end of the sixth capacitor, a first end of the seventh capacitor, a first end of the ninth capacitor, and the third port, and a second end of the fifth inductor is separately electrically connected to a second end of the sixth inductor, a second end of the eighth inductor, and the fourth port; a second end of the sixth capacitor is separately electrically connected to a first end of the sixth inductor, a second end of the seventh inductor, and a first end of the eighth capacitor; a second end of the seventh capacitor is electrically connected to a first end of the seventh inductor; a second end of the eighth capacitor is electrically connected to a first end of the eighth inductor; and a second end of the ninth capacitor is electrically connected to a first end of the ninth inductor, and a second end of the ninth inductor is connected to a ground.

30. The resonance structure according to claim 28, wherein the second resonance structure comprises a tenth-level resonance network, and the tenth-level resonance network is connected in parallel to the first resonance structure;
the tenth-level resonance network comprises a tenth capacitor, an eleventh capacitor, and a tenth inductor, and the eleventh capacitor is connected in parallel to the tenth inductor and is connected in series to the tenth capacitor;
the first resonance structure comprises a fifth-level resonance network, a sixth-level resonance network, a seventh-level resonance network, and an eighth-level resonance network, the fifth-level resonance network comprises a fifth inductor, the sixth-level resonance network comprises a sixth inductor and a sixth capacitor connected in series, the seventh-level resonance network comprises a seventh capacitor and a seventh inductor connected in series, and the eighth-level resonance network comprises an eighth capacitor and an eighth inductor connected in series; the first resonance structure further comprises a third port and a fourth port;
a first end of the fifth inductor is separately electrically connected to a first end of the sixth capacitor, a first end of the seventh capacitor, a first end of the tenth capacitor, and the third port, and a second end of the fifth inductor is separately electrically connected to a second end of the sixth inductor, a second end of the eighth inductor, and the fourth port; a second end of the sixth capacitor is separately electrically connected to a first end of the sixth inductor, a second end of the seventh inductor, and a first end of the eighth capacitor; a second end of the seventh capacitor is electrically connected to a first end of the seventh inductor; a second end of the eighth capacitor is electrically connected to a first end of the eighth inductor; and a second end of the tenth capacitor is separately electrically connected to a first end of the eleventh capacitor and a first end of the tenth inductor, and a second end of the eleventh capacitor is electrically connected to a second end of the tenth inductor and is connected to a ground.

31. The resonance structure according to claim 28, wherein the second resonance structure comprises an eleventh-level resonance network, and the eleventh-level resonance network is connected in parallel to the first resonance structure;
the eleventh-level resonance network comprises a twelfth capacitor, an eleventh inductor, and a twelfth inductor, and the eleventh inductor is connected in parallel to the twelfth inductor and is connected in series to the twelfth capacitor;
the first resonance structure comprises a fifth-level resonance network, a sixth-level resonance network, a seventh-level resonance network, and an eighth-level resonance network, the fifth-level resonance network comprises a fifth inductor, the sixth-level resonance network comprises a sixth inductor and a sixth capacitor connected in series, the seventh-level resonance network comprises a seventh capacitor and a seventh inductor connected in series, and the eighth-level resonance network comprises an eighth capacitor and an eighth inductor connected in series; the first resonance structure further comprises a third port and a fourth port;
a first end of the fifth inductor is separately electrically connected to a first end of the sixth capacitor, a first end of the seventh inductor, a first end of the twelfth capacitor, and the third port, and a second end of the fifth inductor is separately electrically connected to a second end of the sixth inductor, a second end of the eighth inductor, and the fourth port; a second end of the sixth capacitor is separately electrically connected to a first end of the sixth inductor, a second end of the seventh capacitor, and a first end of the eighth capacitor; a second end of the seventh inductor is electrically connected to a first end of the seventh capacitor; a second end of the eighth capacitor is electrically connected to a first end of the eighth inductor; and a second end of the twelfth capacitor is separately electrically connected to a first end of the eleventh inductor and a first end of the twelfth inductor, and a second end of the eleventh inductor is electrically connected to a second end of the twelfth inductor and is connected to a ground.

32. A radio frequency system, comprising at least one of a filter, a combiner, a notch filter, a duplexer, and a multiplexer, wherein the filter, the combiner, the notch filter, the duplexer, or the multiplexer comprises the resonance structure according to any one of claims 1 to 31.

33. The radio frequency system according to claim 32, wherein the radio frequency system comprises a combiner, the combiner comprises at least two resonance structures, and the at least two resonance structures are configured to combine at least two signals.

34. The radio frequency system according to claim 33, wherein the combiner comprises a twentieth-level resonance network and a first resonance structure connected in parallel;
the twentieth-level resonance network comprises a twenty-first inductor, an eighteenth capacitor, a twenty-second inductor, and a twelfth port, and the eighteenth capacitor is connected in series to the twenty-second inductor and is connected in parallel to the twenty-first inductor;
the first resonance structure comprises a first-level resonance network, a second-level resonance network, a third-level resonance network, and a fourth-level resonance network, the first-level resonance network comprises a first inductor and a first capacitor connected in parallel, the second-level resonance network comprises a second inductor and a second capacitor connected in series, the third-level resonance network comprises a third inductor and a third capacitor connected in series, and the fourth-level resonance network comprises a fourth inductor and a fourth capacitor connected in series; the first resonance structure further comprises a first port and a second port;
a first end of the first capacitor is separately electrically connected to a first end of the first inductor, a first end of the twenty-first inductor, a first end of the eighteenth capacitor, and the first port, and a second end of the first capacitor is separately electrically connected to a first end of the second inductor, a first end of the third inductor, and a first end of the fourth inductor; a second end of the second inductor is electrically connected to a first end of the second capacitor; a second end of the third inductor is electrically connected to a first end of the third capacitor; a second end of the fourth inductor is electrically connected to a first end of the fourth capacitor; a second end of the first inductor is separately electrically connected to a second end of the second capacitor, a second end of the third capacitor, a second end of the fourth capacitor, and the second port; and a second end of the eighteenth capacitor is electrically connected to a first end of the twenty-second inductor, and a second end of the twenty-first inductor is separately electrically connected to a second end of the twenty-second inductor and the twelfth port.

35. The radio frequency system according to claim 33, wherein the combiner comprises a thirty-third port, a fifty-first inductor, a thirty-sixth capacitor, a fifty-second inductor, a fifty-third inductor, a thirty-seventh capacitor, a thirty-fourth port, a thirty-eighth capacitor, a fifty-fourth inductor, a thirty-ninth capacitor, a fifty-fifth inductor, a fifty-sixth inductor, a fortieth capacitor, a forty-first capacitor, and a thirty-fifth port;
a first end of the fifty-first inductor is separately electrically connected to a first end of the thirty-sixth capacitor, a first end of the thirty-eighth capacitor, a first end of the fifty-fourth inductor, and the thirty-fifth port, a second end of the thirty-sixth capacitor is separately electrically connected to a first end of the fifty-second inductor and a first end of the fifty-third inductor, a second end of the fifty-first inductor is separately electrically connected to a second end of the fifty-second inductor and the thirty-third port, a second end of the fifty-third inductor is separately electrically connected to a first end of the thirty-seventh capacitor, and a second end of the thirty-seventh capacitor is connected to a ground; a second end of the fifty-fourth inductor is separately electrically connected to a first end of the thirty-ninth capacitor and a first end of the fifty-fifth inductor, and a second end of the thirty-eighth capacitor is separately electrically connected to a second end of the thirty-ninth capacitor and a first end of the fortieth capacitor; a second end of the fifty-fifth inductor is electrically connected to a first end of the fifty-sixth inductor, and a second end of the fifty-sixth inductor is connected to a ground; a second end of the fortieth capacitor is separately electrically connected to a first end of the forty-first capacitor and the thirty-fourth port; and a second end of the forty-first capacitor is connected to a ground.

36. The radio frequency system according to claim 33, wherein the combiner comprises a thirty-eighth port, a fifty-seventh inductor, a forty-second capacitor, a fifty-eighth inductor, a fifty-ninth inductor, a forty-third capacitor, a thirty-sixth port, a forty-fourth capacitor, a sixtieth inductor, a sixty-first inductor, a forty-fifth capacitor, a sixty-second inductor, and a thirty-seventh port;
a first end of the forty-fourth capacitor is separately electrically connected to a first end of the sixtieth inductor, a first end of the fifty-seventh inductor, a first end of the forty-second capacitor, and the thirty-eighth port, a second end of the forty-second capacitor is separately electrically connected to a first end of the fifty-eighth inductor and a first end of the fifty-ninth inductor, and a second end of the fifty-seventh inductor is separately electrically connected to a second end of the fifty-eighth inductor and the thirty-sixth port; a second end of the fifty-ninth inductor is electrically connected to a first end of the forty-third capacitor, and a second end of the forty-third capacitor is connected to a ground; and a second end of the sixtieth inductor is separately electrically connected to a first end of the forty-fifth capacitor and a first end of the sixty-first inductor, a second end of the forty-fourth capacitor is separately electrically connected to a second end of the sixty-first inductor and the thirty-seventh port, a second end of the forty-fifth capacitor is electrically connected to a first end of the sixty-second inductor, and a second end of the sixty-second inductor is connected to a ground.

37. The radio frequency system according to claim 33, wherein the combiner comprises a forty-first port, a sixty-third inductor, a forty-sixth capacitor, a sixty-fourth inductor, a sixty-fifth inductor, a sixty-sixth inductor, a thirty-ninth port, a forty-seventh capacitor, a forty-eighth capacitor, a forty-ninth capacitor, a sixty-seventh inductor, a sixty-eighth inductor, and a fortieth port;
a first end of the sixty-third inductor is separately electrically connected to a first end of the forty-seventh capacitor, a first end of the forty-ninth capacitor, a first end of the forty-sixth capacitor, and the forty-first port, a second end of the forty-sixth capacitor is separately electrically connected to a first end of the sixty-fourth inductor and a first end of the sixty-fifth inductor, and a second end of the sixty-third inductor is separately electrically connected to a second end of the sixty-fourth inductor, a second end of the sixty-fifth inductor, a first end of the sixty-sixth inductor, and the thirty-ninth port; a second end of the sixty-sixth inductor is connected to a ground; a second end of the forty-ninth capacitor is separately electrically connected to a first end of the sixty-seventh inductor and a first end of the sixty-eighth inductor, a second end of the forty-seventh capacitor is separately electrically connected to a second end of the sixty-seventh inductor and a first end of the forty-eighth capacitor, and a second end of the forty-eighth capacitor is electrically connected to the fortieth port; and a second end of the sixty-eighth inductor is connected to a ground.

38. The radio frequency system according to claim 33, wherein the combiner comprises a forty-fourth port, a sixty-ninth inductor, a fiftieth capacitor, a fifty-first capacitor, a forty-second port, a fifty-second capacitor, a seventieth inductor, a fifty-third capacitor, a seventy-first inductor, a seventy-second inductor, a seventy-third inductor, and a forty-third port;
a first end of the fifty-second capacitor is separately electrically connected to a first end of the sixty-ninth inductor, a first end of the fifty-first capacitor, a first end of the seventieth inductor, and the forty-fourth port, and a second end of the fifty-second capacitor is separately electrically connected to a first end of the seventy-second inductor and a first end of the fifty-third capacitor; a second end of the seventy-second inductor is electrically connected to a first end of the seventy-third inductor; a second end of the fifty-third capacitor is electrically connected to a first end of the seventy-first inductor; a second end of the seventy-first inductor is separately electrically connected to a second end of the seventy-third inductor, a second end of the seventieth inductor, and the forty-third port; and a second end of the sixty-ninth inductor is electrically connected to a first end of the fiftieth capacitor, and a second end of the fiftieth capacitor is separately electrically connected to a second end of the fifty-first capacitor and the forty-second port.

39. An electronic device, comprising the radio frequency system according to any one of claims 32 to 38.
